(19) Europäisches Patentamt
European Patent Office
Office européen des brevets

(11) **EP 2 499 739 B1**

(12) **EUROPÄISCHE PATENTSCHRIFT**

(45) Veröffentlichungstag und Bekanntmachung des Hinweises auf die Patenterteilung:
**23.10.2013 Patentblatt 2013/43**

(21) Anmeldenummer: **11722301.6**

(22) Anmeldetag: **24.04.2011**

(51) Int Cl.:
*H03H 7/38* *(2006.01)*       *H03F 1/02* *(2006.01)*
*H03F 1/56* *(2006.01)*       *G06F 17/50* *(2006.01)*

(86) Internationale Anmeldenummer:
**PCT/EP2011/002074**

(87) Internationale Veröffentlichungsnummer:
**WO 2011/134635 (03.11.2011 Gazette 2011/44)**

(54) **VERFAHREN ZUR BESTIMMUNG EINES ANPASSNETZWERKS BASIEREND AUF POINCARÉ-KREISEN VON REFLEXIONSFAKTOREN**

METHOD FOR DETERMINING A MATCHING NETWORK BASED ON POINCARÉ DISCS OF REFLECTION FACTORS

PROCÉDÉ DE DÉTERMINATION D'UN RÉSEAU D'ADAPTATION BASÉ SUR DES DISQUES DE POINCARÉ DE FACTEURS DE RÉFLEXION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.04.2010 DE 102010018274**

(43) Veröffentlichungstag der Anmeldung:
**19.09.2012 Patentblatt 2012/38**

(73) Patentinhaber: **Bromberger, Christoph**
**89134 Blaustein (DE)**

(72) Erfinder: **Bromberger, Christoph**
**89134 Blaustein (DE)**

(74) Vertreter: **Koch Müller**
**Patentanwaltsgesellschaft mbH**
**Maaßstraße 32/1**
**69123 Heidelberg (DE)**

(56) Entgegenhaltungen:
- **MADHU S GUPTA: "Escher's art, Smith chart, and hyperbolic geometry", IEEE MICROWAVE MAGAZINE, Bd. 7, Nr. 5, 1. Oktober 2006 (2006-10-01) , Seiten 66-76, XP011143265,**
- **FOLKE BOLINDER E: "Geometric-Analytic Theory of Transition in Electrical Engineering", PROCEEDINGS OF THE IRE, Bd. 46, Nr. 6, 1. Juni 1959 (1959-06-01), Seiten 1124-1129, XP011156616,**
- **MITTRA R ET AL: "An Impedance Transformation Method for Finding the Load Impedance of a Two-Port Network", IRE TRANSACTIONS ON MICROWAVE THEORY AND TECHNIQUES, IEEE, USA, Bd. 6, Nr. 1, 1. Januar 1962 (1962-01-01), Seiten 13-19, XP011219898, ISSN: 0097-2002**
- **DETTMANN I ET AL: "Comparison of a Single-Ended Class AB, a Balance and a Doherty Power Amplifier", MICROWAVE CONFERENCE PROCEEDINGS, 2005. APMC, Bd. 2, 4. Dezember 2005 (2005-12-04), Seiten 1-4, XP010901983,**

**Beschreibung**

Die vorliegende Erfindung betrifft ein Verfahren zur Auslegung einer elektronischen Schaltung mit einem Anpassnetzwerk.

Aus "Über eine Eigenschaft der konformen Abbildung kreisförmiger Bereiche", Georg Pick, Mathematische Annalen, Bd.77, 1916, Seite 1-6 sind Grundlagen zur konformen Abbildung kreisförmiger Bereiche bekannt. Das Poincaré-Modell ist beispielsweise aus "Hyperbolische Geometrie", T. Peters, www.mathe-seiten.de, Seiten 6 und 7, 3. Sept. 2003 bekannt. Der Poincaré-Abstand ist aus "Invariant Distances and Metrics in complex Analysis - revisited", M. Jamicki, P. Pflug, Seite 7, Februar 2004 bekannt. Weiterhin bekannt ist die Möbiustransformation aus dem Vorlesungsskript "Komplexe Analysis", Prof. Dr. Dirk Ferus, 2008, Seiten 18 bis 26. Die Möbiustransformation wird beispielsweise bei einem Smith-Diagramm der Hochfrequenztechnik angewandt. Mit Hilfe des Smith-Diagramms kann die Wirkungsweise von Anpassnetzwerken in Schaltungen der Hochfrequenztechnik graphisch dargestellt werden.

Aus MADHU S. GUPTA: "Escher's art, Smith chart and hyperbolic geometry", IEEE MICROWAVE MAGAZINE, Bd. 7, Nr. 5, Oktober 2006, Seiten 66-76, XP011143265 sind das Smith Chart, die Möbius Transformation und Poincaré's Modell des hyperbolischen Raums bekannt. Aus E. FOLKE BOLINDER: "Geometric-analytic Theory of Transition in electrical Engineering", PROCEEDINGS OF THE IRE, Bd. 46, Nr. 6, 1. Juni 1959, Seiten 1124-1129, XP011156616 ist die Verwendung einer komplexen Ebene in einer einfachen geometrischen analytischen Theorie bekannt. Aus MITTRA R ET AL: "An Impedance Transformation Method for Finding the Load Impedance of a Two-Port Network", IRE TRANSACTIONS ON MICROWAVE THEORY AND TECHNIQUES, Bd. 6, Nr. 1, 1. Januar 1962, Seiten 13-19, XP011219898 ist ein Verfahren zum Auffinden einer Lastimpedanz basierend auf einer grafischen Methode bekannt.

Anpassnetzwerke können beispielsweise bei einem Doherty-Leistungsverstärker verwendet werden. Ein Doherty-Leistungsverstärker ist beispielsweise aus "The Doherty Power Amplifier", Bumman K. et al, IEEE microwave magazine, Seiten 42-50, Oktober 2006 oder "Practical Magic", R. Sweeney, IEEE microwave magazine, Seiten 73-82, April 2008 oder "Power Amplifiers and Transmitters for RF and Microwave", F. H. Raab et al, IEEE Transactions on Microwave Theory and Techniques, Vol. 50, No. 3, Seiten 814-826, März 2002 oder "A New High Efficiency Power Amplifier for Modulated Waves", W.H. Doherty, Proceedings of the Institute of Radio Engineers, Vol. 24, No. 9, Seiten 1163-1182, September 1936 bekannt.

Der Erfindung liegt die Aufgabe zu Grunde, ein Verfahren zur Auslegung einer elektronischen Schaltung möglichst zu verbessern.

Diese Aufgabe wird durch ein Verfahren mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist ein Verfahren zur Auslegung einer elektronischen Schaltung zur Optimierung einer ersten Kenngröße der Schaltung vorgesehen. Die erste Kenngröße der Schaltung ist beispielsweise ein S-Parameter oder eine Kleinsignal-Rauschzahl oder ein effektiver Eingangsreflexionsfaktor oder ein effektiver Ausgangsreflexionsfaktor oder ein effektiver Ausgangswiderstand oder ein Rollet'scher Stabilitätsfaktor oder eine Leistungsverstärkung oder ein Intermodulationsprodukt der Ordnung n oder eine harmonische Verzerrung n-ter Ordnung oder ein Klirrfaktor oder eine Effizienz der Leistungsverstärkung oder eine Rauschzahl oder ein Kompressionspunkt oder eine Kompressionsleistung oder eine Kompression der  Leistungsverstärkung oder ein Durchschnitt einer Kleinsignal-Kenngröße oder ein Integral einer Kleinsignal-Kenngröße oder eine Fehlanpassung zwischen einem transformierten ersten Quellreflexionsfaktor und einem ersten Lastreflexionsfaktor.

Die Schaltung weist ein erstes Anpassnetzwerk mit einem ersten Anschluss und einem zweiten Anschluss auf. Die Schaltung weist eine mit dem ersten Anschluss verbundene Last auf. Am ersten Anschluss des ersten Anpassnetzwerks wird ein von der Last abhängiger ersten Lastreflexionsfaktor bewirkt. Mit dem zweiten Anschluss des ersten Anpassnetzwerks ist ein erstes Quellenelement verbunden, wobei das erste Quellenelement einen ersten Quellreflexionsfaktor aufweist. Das erste Quellenelement ist beispielsweise ein Verstärker oder eine Signalleitung. Die Last ist beispielsweise ein Verstärkereingang oder eine Antenne. Der erste Lastreflexionsfaktor und der erste Quellreflexionsfaktor werden durch Messung oder ausgehend von einer Messung vorzugsweise automatisiert ermittelt.

Bei der Schaltungsauslegung ergibt sich die Notwendigkeit, die Impedanzpegel von im Signalpfad aufeinanderfolgenden Unterbaugruppen oder Bauelementen aufeinander abzustimmen.

Dies ist die Funktion gesonderter, zwischengeschalteter Funktionsblöcke, der sogenannten Anpassnetzwerke. Das Anpassnetzwerk kann als Anpassstruktur beispielsweise eine L-Struktur und/oder eine T-Struktur und/oder ein Pi-Struktur aufweisen.

Durch das erste Anpassnetzwerk wird in den zweiten Anschluss des ersten Anpassnetzwerks hinein ein transformierter erster Lastreflexionsfaktor und in den ersten Anschluss des ersten Anpassnetzwerks hinein ein transformierter erster Quellreflexionsfaktor bewirkt. Bevorzugt ist das erste Anpassnetzwerk reziprok und verlustlos.

Das Verfahren zur Auslegung der elektronischen Schaltung kann vollautomatisch - insbesondere rechnergesteuert - erfolgen. Hierzu werden Messdaten von Elementen der Schaltung, wie Transistoren, Impedanzen oder dergleichen, durch Messungen ermittelt. Die Messdaten werden in einen Programmablauf zur Berechnung der Elemente des Anpassnetzwerks der elektronischen Schaltung eingegeben. Hierdurch ist eine Berechnung der beispielsweise kapazitiven oder induktiven Elemente des Anpassnetzwerks möglich. Ein menschlicher Eingriff in das Verfahren ist hingegen nicht erforderlich.

Das Verfahren zur Auslegung der Schaltung weist mehrere Schritte auf. In einem ersten Schritt erfolgt ein Bestimmen eines ersten Wertes des transformierten ersten Quellreflexionsfaktors und eines zweiten Wertes des transformierten ersten Lastreflexionsfaktors. Für das Bestimmen des ersten Wertes und des zweiten Wertes sind mehrere Teilschritte vorgesehen. Es wird eine Anzahl von ersten Abständen bestimmt. Die ersten Abstände sind dabei keine euklidischen Abstände, sondern so genannte Poincaré-Abstände.

Für jeden ersten Abstand der Anzahl von ersten Abständen wird ein erster Kreis als Menge aller Punkte im ersten Abstand von dem komplex Konjugierten des ersten Lastreflexionsfaktors bestimmt. Der erste Kreis ist definiert durch

$$P(y, a_{on}*) = \operatorname{arctanh}\left(\frac{|y - a_{on}*|}{|1 - y * a_{on}*|}\right) \equiv P_R \qquad (1)$$

Dabei ist $P(y, a_{on}*)$ der Poincaré-Abstand, y ist ein Punkt auf dem ersten Kreis. y* ist das komplex Konjugierte eines Punktes auf dem ersten Kreis. a* ist das komplex Konjugierte des ersten Lastreflexionsfaktors und $P_R$ ist der erste Abstand.

Für jeden ersten Abstand der Anzahl von ersten Abständen wird ein zweiter Kreis als Menge aller Punkte im ersten Abstand von dem komplex Konjugierten des ersten Quellreflexionsfaktors bestimmt. Der zweite Kreis ist definiert durch

$$P(x, b_{on}*) = \operatorname{arctanh}\left(\frac{|x - b_{on}*|}{|1 - x * b_{on}*|}\right) \equiv P_R \qquad (2)$$

Dabei ist $P(y, b_{on}*)$ der Poincaré-Abstand, x ist ein Punkt auf dem zweiten Kreis. x* ist das komplex Konjugierte eines Punktes auf dem zweiten Kreis. b* ist das komplex Konjugierte des ersten Quellreflexionsfaktors und $P_R$ ist der erste Abstand.

In dem Verfahren wird eine beliebige oder vorgebbare Anzahl von ersten Punktepaaren bestimmt. Ein erster Paarpunkt jedes Punktepaares ist auf dem ersten Kreis. Ein zweiter Paarpunkt jedes Punktepaares ist auf dem zweiten Kreis.

Ein Wert der ersten Kenngröße wird bestimmt für jedes erste Punktepaar. Der erste Paarpunkt ist gleich einem Wert des transformierten ersten Quellreflexionsfaktors. Ein zweiter Paarpunkt ist gleich einem Wert des transformierten ersten Lastflexionsfaktors.

Ein Optimum der ersten Kenngröße wird bestimmt aus allen Werten der ersten Kenngröße, die den ersten Punktepaaren zugeordnet sind. Ein erstes Wertepaar wird bestimmt aus den ersten Punktepaaren, wobei dem ersten Wertepaar das Optimum der Kenngröße zugeordnet ist. Das Optimum ist ein lokales oder globales Minimum oder Maximum der Kenngröße. In einem Zwischenschritt ist es vorteilhaft für jeden Kreis ein Suboptimum zu bestimmen. Das Optimum für alle Kreise kann nachfolgend aus den Suboptima bestimmt werden.

Ein erster Wert des transformierten ersten Quellreflexionsfaktors wird gleich einem ersten Wertepunkt des ersten Wertepaares bestimmt. Ein zweiter Wert des transformierten ersten Lastreflexionsfaktors wird gleich einem zweiten Wertepunkt des ersten Wertepaares bestimmt. Die Bestimmung kann beispielsweise durch Berechnung anhand von Modellen und/oder Messung der Kenngröße der Schaltung erfolgen.

In einem nachfolgenden Schritt des Verfahrens erfolgt ein Bestimmen des ersten Anpassnetzwerks anhand des ersten Wertes des transformierten ersten Quellreflexionsfaktors, des zweiten Wertes des transformierten ersten Lastreflexionsfaktors, des ersten Quellreflexionsfaktors und des ersten Lastreflexionsfaktors. Der Schritt des Bestimmens des ersten Anpassnetzwerkes kann ebenfalls automatisiert erfolgen. Beispielsweise wird eine Topologie, also die Anordnung der Kapazitäten und Induktivitäten des ersten Anpassnetzwerks, ausgewählt. Nachfolgend werden die Kapazitätswerte und die Induktivitätswerte des ersten Anpassnetzwerks aus dem ersten Wert des transformierten ersten Quellreflexionsfaktors, aus dem zweiten Wert des transformierten ersten Lastreflexionsfaktors, aus dem ersten Quellreflexionsfaktor und aus dem ersten Lastreflexionsfaktor berechnet.

Die im Folgenden beschriebenen Weiterbildungen beziehen sich sowohl auf das zuvor erläuterte Verfahren.

Gemäß einer besonders vorteilhaften Weiterbildung weist das Verfahren weitere Schritte auf. Dabei wird eine erste Funktion bestimmt, die die Transformationswirkung des ersten Anpassnetzwerks in Vorwärtsrichtung beschreibt. Die Vorwärtsrichtung ist dabei ausgehend von dem Quellenelement in Richtung der Last definiert. Die erste Funktion ist definiert durch

$$f_{a_{on}, a_{on}', \varphi}(z_1) = e^{i\varphi} \frac{z_1 - z_0}{1 - z_0^* z_1} \tag{3}$$

mit

$$z_0 = \frac{1 - |a_{on}|^2}{|a_{on}|^2 |a_{on}'|^2 - 1} a_{on}' e^{-i\varphi} - \frac{1 - |a_{on}'|^2}{|a_{on}|^2 |a_{on}'|^2 - 1} a_{on} \tag{4}$$

In der ersten Funktion ist $a_{on}$ der erste Lastreflexionsfaktor. $a_{on}'$ ist der transformierte erste Lastreflexionsfaktor.

$\varphi \in [0...2\pi[$ ist ein Parameter. Die imaginäre Zahl i ist definiert durch $i = \sqrt[2]{-1}$ und $z_1$ ist ein erstes Argument der ersten Funktion.

Zudem wird eine zweite Funktion bestimmt, die die Transformationswirkung des ersten Anpassnetzwerks in Rückwärtsrichtung beschreibt. Die Rückwärtsrichtung ist dabei ausgehend von der Last in Richtung des Quellenelements definiert. Die zweite Funktion ist definiert durch

$$f^R_{a_{on}, a_{on}', \varphi}(z_2) = e^{i\varphi} \frac{z_2 - z_0^R}{1 - z_0^{R*} z_2} \tag{5}$$

mit

$$z_0^R = \frac{1 - |a_{on}'^*|^2}{|a_{on}'^*|^2 |a_{on}^*|^2 - 1} a_{on}^* e^{-i\varphi} - \frac{1 - |a_{on}^*|^2}{|a_{on}'^*|^2 |a_{on}^*|^2 - 1} a_{on}'^* \tag{6}$$

Dabei ist $a_{on}$ der erste Lastreflexionsfaktor. $a_{on}^*$ ist das komplexe Konjugierte des ersten Lastreflexionsfaktors. $a_{on}'$ ist der transformierte erste Lastreflexionsfaktor. $a_{on}'^*$ das komplex Konjugierte des transformierten ersten Lastreflexionsfaktors. $\varphi \in [0...2\pi[$ ist wiederum der bereits zuvor genannte Parameter. $z_2$ ist ein zweites Argument der zweiten Funktion.

Gemäß einer besonders vorteilhaften Weiterbildung des Verfahrens weist das zuvor erläuterte Verfahren weitere Schritte auf. Dabei wird ein Wert des Parameters $\varphi \in [0...2\pi[$ für das Optimum der ersten Kenngröße bestimmt. Das Optimum ist beispielsweise ein Minimum der ersten Kenngröße, wenn die erste Kenngröße beispielsweise ein Klirrfaktor ist. Das Optimum kann auch ein Maximum der ersten Kenngröße - wie beispielsweise eine Leistungsverstärkung - sein.

Zur Bestimmung des Wertes des Parameters ist die Anzahl der ersten Abstände gleich eins. Der erste Abstand wird zwischen dem transformierten ersten Lastreflexionsfaktor und dem komplex Konjugierten des ersten Quellreflexionsfaktors bestimmt. Dabei ist in dieser Weiterbildung der transformierte erste Lastreflexionsfaktor vorgegeben oder fest.

Der erste Abstand ist dabei als Poincaré-Abstand definiert durch

$$P_{a_{on}',b_{on}*} = \text{arctanh}\left(\frac{|a_{on}'-b_{on}*|}{|1 - b_{on}a_{on}'|}\right) \equiv P_R \qquad (7)$$

Dabei ist $b_{on}$ der erste Quellreflexionsfaktor. $b_{on}*$ ist das komplexe Konjugierte des ersten Quellreflexionsfaktors. $a_{on}'$ ist der transformierte erste Lastreflexionsfaktor. $P_R$ ist der erste Abstand.

Der Wert des Parameters wird bestimmt, wobei für den Wert des Parameters die zweite Funktion mit dem ersten Quellreflexionsfaktor als zweites Argument den ersten Wert des transformierten ersten Quellreflexionsfaktors als Funktionswert annimmt.

Der erste Wert des transformierten ersten Quellreflexionsfaktors wird als ein Punkt auf dem ersten Kreis bestimmt, wobei in dem Punkt die erste Kenngröße ein Optimum annimmt. Hierzu wird beispielsweise für eine Anzahl von Punkten auf dem ersten Kreis jeweils die Kenngröße bestimmt. Beispielsweise der zur maximalen Kenngröße zugehörige Punkt wird als transformierter erster Quellreflexionsfaktor bestimmt.

Danach wird der Wert des Parameters bestimmt. Für den Wert des Parameters nimmt die zweite Funktion mit dem ersten Quellreflexionsfaktor als zweites Argument den bestimmten ersten Wert des transformierten ersten Quellreflexionsfaktors als Funktionswert an. In diesem Fall gilt:

$$f^R{}_{a_{on},a_{on}',\varphi_{opt}(b_{on})} = b_{on}'{}_{opt} \qquad (8)$$

Nachfolgend wird das erste Anpassnetzwerk anhand der ersten Funktion für den Wert des Parameters bestimmt. Dabei wird diejenige Transformationswirkung aufgesucht, welche eindeutig das Anpassnetzwerk beschreibt, welches den ersten Lastreflexionsfaktor auf den transformierten ersten Lastreflexionsfaktor und welches den ersten Quellreflexionsfaktor auf den transformierten ersten Quellreflexionsfaktor abbildet. Der transformierte erste Lastreflexionsfaktor und der transformierte erste Quellreflexionsfaktor können dabei mit dem bestimmten ersten Wert beziehungsweise dem bestimmten zweiten Wert identisch sein.

In einer vorteilhaften Ausgestaltungsvariante ist die erste Kenngröße die Fehlanpassung zwischen dem ersten transformierten Quellreflexionsfaktor und dem ersten Lastreflexionsfaktor.

Gemäß einer anderen vorteilhaften Ausgestaltung ist als Randbedingung eine vorgegebene Fehlanpassung zwischen dem ersten transformierten Quellreflexionsfaktor und dem ersten Lastreflexionsfaktor ein Teil der ersten Kenngröße oder eine Fehlanpassung zwischen einem transformierten ersten Quellreflexionsfaktor und einem ersten Lastreflexionsfaktor.

Die Aufgabe wird weiterhin durch das Verfahren mit den Merkmalen des unabhängigen Anspruchs 5 gelöst. Vorteilhafte Weiterbildungen sind in der Beschreibung enthalten.

Demzufolge ist ein Verfahren zur Auslegung einer elektronischen Schaltung zur Optimierung einer zweiten Kenngröße der Schaltung vorgesehen. Die zweite Kenngröße kann mit der ersten Kenngröße übereinstimmen oder von dieser verschieden sein. Die zweite Kenngröße ist beispielsweise ein S-Parameter oder eine Kleinsignal-Rauschzahl oder ein effektiver Eingangsreflexionsfaktor oder ein effektiver Ausgangsreflexionsfaktor oder ein effektiver Ausgangswiderstand oder ein Rollet'scher Stabilitätsfaktor oder eine Leistungsverstärkung oder ein Intermodulationsprodukt der Ordnung n oder eine harmonische Verzerrung n-ter Ordnung oder ein Klirrfaktor oder eine Effizienz der Leistungsverstärkung oder eine Rauschzahl oder ein Kompressionspunkt oder eine Kompressionsleistung oder eine Kompression der Leistungsverstärkung oder ein Durchschnitt einer Kleinsignal-Kenngröße oder ein Integral einer Kleinsignal-Kenngröße oder eine Fehlanpassung zwischen einem transformierten ersten Quellreflexionsfaktor und einem ersten Lastreflexionsfaktor.

Die im Folgenden verwendeten Bezeichnungen zweiter/zweites, dritter/drittes usw. dienen ausschließlich der besseren Verständlichkeit und setzen keinen ersten/erstes Anschluss, Element etc. voraus.

Die Schaltung weist ein zweites Anpassnetzwerk mit einem dritten Anschluss und einem vierten Anschluss auf.

Die Schaltung weist eine mit dem dritten Anschluss verbundene variable Last mit einem ersten Betriebszustand und einem zweiten Betriebszustand auf. Die variable Last weist in dem ersten Betriebszustand einen dritten Lastreflexionsfaktor und in dem zweiten Betriebszustand einen zweiten Lastreflexionsfaktor auf.

Die Schaltung weist vorzugsweise ein mit dem vierten Anschluss verbundenes zweites Quellenelement mit einem zweiten Quellreflexionsfaktor auf.

Durch das zweite Anpassnetzwerk wird in den vierten Anschluss hinein im ersten Betriebszustand ein transformierter dritter Lastreflexionsfaktor und im zweiten Betriebszustand ein transformierter zweiter Lastreflexionsfaktor bewirkt. Vorzugsweise wird durch das zweite Anpassnetzwerk in den dritten Anschluss hinein ein transformierter zweiter Quellreflexionsfaktor bewirkt.

Beispielsweise werden der transformierte zweite Lastreflexionsfaktor und der transformierte dritte Lastreflexionsfaktor und der zweite Lastreflexionsfaktor beispielsweise durch Anforderungen aus der Schaltung - beispielsweise passend zu dem zweiten Quellreflexionsfaktor - vorgegeben.

Das Verfahren weist mehrere Schritte auf. In dem Verfahren werden ein dritter Wert des dritten Lastreflexionsfaktors und ein vierter Wert des zweiten Lastreflexionsfaktors bestimmt. Hierzu wird zunächst ein dritter Abstand zwischen dem transformierten zweiten Lastreflexionsfaktor und dem transformierten dritten Lastreflexionsfaktor bestimmt. Der dritte Abstand ist definiert durch

$$P_3 = \operatorname{arctanh}\left(\frac{|c_{off}' - c_{on}'|}{|1 - c_{off}' * c_{on}'|}\right) \qquad (9)$$

Dabei ist $c_{on}'$ der transformierte zweite Lastreflexionsfaktor. $c_{off}'$ ist der transformierte dritte Lastreflexionsfaktor. $c_{on}'^*$ ist das komplex Konjugierte des transformierten zweiten Lastreflexionsfaktors und $P_3$ ist der dritte Abstand.

Danach wird ein dritter Kreis als Menge aller Punkte im dritten Abstand von dem zweiten Lastreflexionsfaktor bestimmt. Der dritte Kreis ist definiert durch

$$P(z, c_{on}) = \operatorname{arctanh}\left(\frac{|z - c_{on}|}{|1 - z * c_{on}|}\right) \equiv P_3 \qquad (10)$$

Dabei ist $P(z, c_{on})$ der Poincaré-Abstand, z ist ein Punkt auf dem dritten Kreis. z* ist das komplex Konjugierte des Punktes auf dem dritten Kreis. $c_{on}$ ist der zweite Lastreflexionsfaktor. $c_{on}*$ ist das komplex Konjugierte des zweiten Lastreflexionsfaktors und $P_3$ ist der dritte Abstand.

Im Verfahren wird eine Anzahl von zweiten Punktepaaren bestimmt. Ein zweiter Paarpunkt jedes Punktepaares ist ein Punkt auf dem dritten Kreis.

Ein Wert der zweiten Kenngröße wird für jedes zweite Punktepaar bestimmt. Ein Wert des dritten Lastreflexionsfaktors ist gleich dem zweiten Paarpunkt. Ein Wert des zweiten Lastreflexionsfaktors ist gleich dem ersten Paarpunkt. Zur Bestimmung wird der Wert der zweiten Kenngröße beispielsweise berechnet.

Im Verfahren wird ein Optimum der zweiten Kenngröße aus allen Werten der zweiten Kenngröße bestimmt. Dabei sind die Werte der zweiten Kenngröße den Punktepaaren zugeordnet. Das Optimum ist ein lokales oder globales Minimum oder Maximum der Kenngröße.

Danach wird ein dem Optimum zugehöriges zweites Punktepaar bestimmt. Der dritte Wert des dritten Lastreflexionsfaktors wird gleich einem dem Optimum zugehörigen zweiten Paarpunkt des dem Optimum zugehörigen zweiten Punktepaares bestimmt. Der vierte Wert des zweiten Lastreflexionsfaktors wird gleich einem dem Optimum zugehörigen ersten Paarpunkt des dem Optimum zugehörigen zweiten Punktepaares bestimmt.

In einem nachfolgenden Schritt des Verfahrens erfolgt ein Bestimmen des zweiten Anpassnetzwerks anhand des dritten Wertes des dritten Lastreflexionsfaktors, des vierten Wertes des zweiten Lastreflexionsfaktors, des transformierten zweiten Lastreflexionsfaktors und des transformierten dritten Lastreflexionsfaktors. Der Schritt des Bestimmens des zweiten Anpassnetzwerkes kann ebenfalls automatisiert erfolgen. Beispielsweise wird eine Topologie, also die Anordnung der Kapazitäten und Induktivitäten des zweiten Anpassnetzwerks, ausgewählt. Nachfolgend werden die Kapazitätswerte und die Induktivitätswerte des zweiten Anpassnetzwerks aus dem dritten Wert des dritten Lastreflexionsfaktors, dem vierten Wert des zweiten Lastreflexionsfaktors, dem transformierten zweiten Lastreflexionsfaktor und dem transformierten dritten Lastreflexionsfaktor berechnet.

Die Aufgabe wird weiterhin durch das Verfahren mit den Merkmalen des unabhängigen Anspruchs 6 gelöst. Vorteilhafte Weiterbildungen sind in der Beschreibung enthalten.

Demzufolge ist ein Verfahren zur Auslegung einer elektronischen Schaltung vorgesehen. Die Schaltung weist einen ersten Betriebszustand und einen zweiten Betriebszustand auf. Die Schaltung weist ein erstes Quellenelement mit einem ersten Quellenausgang und ein zweites Quellenelement mit einem zweiten Quellenausgang auf. Vorzugsweise sind das erste Quellenelement ein erster Verstärker und das zweite Quellenelement ein zweiter Verstärker. Vorzugsweise sind der erste Verstärker und der zweite Verstärker Bestandteile eines Doherty-Verstärkers. Der erste Verstärker und/ oder der zweite Verstärker weist vorzugsweise einen LDMOS-Transistor zur Verstärkung auf.

Das erste Quellenelement weist in den ersten Quellenausgang hinein im ersten Betriebszustand einen ersten Quellreflexionsfaktor auf.

Die Schaltung weist eine Last mit einem Lasteingang auf. Die Last weist in den Lasteingang hinein einen Last-Eingangsreflexionsfaktor auf. Entsprechend weist die Last eine Lastimpedanz auf.

Die Schaltung weist ein T-Stück mit einem ersten Eingang, einem zweiten Eingang und einen Ausgang auf. Der Lasteingang der Last ist mit dem Ausgang des T-Stücks verbunden. Das T-Stück ist vorzugsweise ein T-förmiger Leiter, der vorzugsweise aus Metall ist. Beispielsweise ist das T-Stück auf einem Halbleiterchip integriert.

Das T-Stück weist in den ersten Eingang hinein im zweiten Betriebszustand einen ersten Lastreflexionsfaktor auf. Das T-Stück weist in den zweiten Eingang hinein im ersten Betriebszustand einen zweiten Lastreflexionsfaktor auf. Das T-Stück weist in den zweiten Eingang hinein im zweiten Betriebszustand einen dritten Lastreflexionsfaktor auf.

Die Schaltung weist ein erstes Anpassnetzwerk mit einem ersten Anschluss und einem zweiten Anschluss auf. Der der erste Anschluss ist mit dem ersten Eingang des T-Stücks verbundenen. Der zweite Anschluss ist mit dem ersten Quellenausgang des ersten Quellenelements verbunden.

Das erste Anpassnetzwerk weist in den ersten Anschluss hinein im ersten Betriebszustand einen transformierten ersten Quellreflexionsfaktor auf. Das erste Anpassnetzwerk weist in den zweiten Anschluss hinein im zweiten Betriebszustand einen transformierten ersten Lastreflexionsfaktor auf.

Die Schaltung weist ein zweites Anpassnetzwerk mit einem dritten Anschluss und einem vierten Anschluss auf. Der dritte Anschluss ist mit dem zweiten Eingang des T-Stücks verbunden.

Der vierte Anschluss des zweiten Anpassnetzwerks ist mit dem zweiten Quellenausgang verbunden.

Das zweite Anpassnetzwerk weist in den vierten Anschluss hinein im ersten Betriebszustand einen transformierten zweiten Lastreflexionsfaktor auf. Das zweite Anpassnetzwerk weist in den vierten Anschluss hinein im zweiten Betriebszustand einen transformierten dritten Lastreflexionsfaktor auf.

Ein erster Wert des transformierten ersten Lastreflexionsfaktors wird zur Optimierung einer Kenngröße der Schaltung bestimmt, indem im zweiten Betriebszustand eine Messung durchgeführt wird. Ein zweiter Wert des transformierten zweiten Lastreflexionsfaktors wird zur Optimierung der Kenngröße der Schaltung bestimmt, indem im ersten Betriebszustand eine Messung durchgeführt wird. Ein dritter Wert des transformierten dritten Lastreflexionsfaktors wird zur Optimierung der Kenngröße der Schaltung bestimmt, indem im zweiten Betriebszustand eine Messung durchgeführt wird.

In dem Verfahren wird der erste Lastreflexionsfaktors auf einen ersten Anfangswert festgelegt. Der erste Anfangswert kann beispielsweise beliebig oder anhand des Last-Eingangsreflexionsfaktors festgelegt werden. Ebenfalls wird der zweite Lastreflexionsfaktors auf zweiten Anfangswert festgelegt. Der zweite Anfangswert kann beispielsweise beliebig oder anhand des Last-Eingangsreflexionsfaktors festgelegt werden.

Das Verfahren weist mehrere Schritte auf. In einem Verfahrensschritt wird ein erster Abstand zwischen dem ersten Wert und dem komplex Konjugierten des ersten Quellreflexionsfaktors bestimmt durch

$$P_1 = \operatorname{arctanh}\left( \frac{\left| a_{on}\text{'}_{opt} - b_{off}{}^* \right|}{\left| 1 - b_{off}{}^* a_{on}\text{'}_{opt}{}^* \right|} \right) \tag{11}$$

Dabei ist $b_{off}$ der erste Quellreflexionsfaktor, $b_{off}{}^*$ das komplexe Konjugierte des ersten Quellreflexionsfaktors, $a_{on}\text{'}_{opt}$ der erste Wert des transformierten ersten Lastreflexionsfaktors und $P_1$ der erste Abstand.

In einem anderen Verfahrensschritt wird ein erster Kreis als Menge aller Punkte im berechneten ersten Abstand von dem komplex Konjugierten des ersten Lastreflexionsfaktors bestimmt durch

$$P(y, a_{on}{}^*) = \operatorname{arctanh}\left( \frac{\left| y - a_{on}{}^* \right|}{\left| 1 - y * a_{on}{}^* \right|} \right) \equiv P_1 \tag{12}$$

Dabei ist y ein Punkt auf dem ersten Kreis. $y^*$ ist das komplex Konjugierte des Punktes auf dem ersten Kreis. $a_{on}{}^*$ das komplex Konjugierte des ersten Lastreflexionsfaktors und $P_1$ ist der erste Abstand.

In einem anderen Verfahrensschritt wird ein dritter Abstand zwischen dem zweiten Wert und dem dritten Wert bestimmt durch

$$P_3 = \operatorname{arctanh}\left( \frac{\left| c_{on}\text{'}_{opt} - c_{off}\text{'}_{opt} \right|}{\left| 1 - c_{on}\text{'}_{opt} * c_{off}\text{'}_{opt} \right|} \right) \tag{13}$$

Dabei ist $c_{off'opt}$ der zweite Wert des transformierten zweiten Lastreflexionsfaktors, $c_{on'opt}$ ist der dritte Wert des transformierten dritten Lastreflexionsfaktors. $c_{on'opt}^*$ ist das konjugiert Komplexe des dritten Wertes des transformierten dritten Lastreflexionsfaktors.

In einem anderen Verfahrensschritt wird ein dritter Kreis als Menge aller Punkte im dritten Abstand von dem dritten Lastreflexionsfaktor bestimmt durch

$$P(z, c_{on}) = \text{arctanh}\left(\frac{|z - c_{on}|}{|1 - z * c_{on}|}\right) \equiv P_3 \qquad (14)$$

Dabei ist z ein Punkt auf dem dritten Kreis. $z^*$ ist das komplex Konjugierte des Punktes auf dem dritten Kreis. $c_{on}$ ist der dritte Lastreflexionsfaktor. $c_{on}^*$ ist das komplex Konjugierte des dritten Lastreflexionsfaktors und $P_3$ ist der dritte Abstand.

In dem Verfahren wird ein veränderter erster Kreis bestimmt. Dieser veränderte erste Kreis kann auch als Bildkreis bezeichnet werden. Dabei wird der veränderte erste Kreis bestimmt als Menge aller veränderten Reflexionsfaktoren, wobei jeder der veränderten Reflexionsfaktoren einer Gesamtimpedanz zugehörig ist. Jede Gesamtimpedanz wird bestimmt aus einer ersten Parallelschaltung einer Lastimpedanz der Last und einer zu einem Reflexionsfaktor auf dem ersten Kreis zugehörigen Impedanz. Dabei ist die Lastimpedanz dem Last-Eingangsreflexionsfaktor der Last zugehörig.

In dem Verfahren wird zumindest ein vierter Wert des zweiten Lastreflexionsfaktors bestimmt, wobei für den zumindest einen vierten Wert eine Quadratsumme von Abständen zwischen dem vierten Wert und dem dritten Kreis sowie zwischen dem vierten Wert und dem veränderten ersten Kreis minimiert wird.

In dem Verfahren wird ein fünfter Wert des transformierten ersten Quellreflexionsfaktors zu jedem vierten Wert des zweiten Lastreflexionsfaktors bestimmt. Dabei wird eine vierte Impedanz ermittelt, wobei die vierte Impedanz zum vierten Wert des zweiten Lastreflexionsfaktors zugehörig ist. Es wird eine fünfte Impedanz ermittelt, so dass eine zweite Parallelschaltung der fünften Impedanz mit der Lastimpedanz gleich der vierten Impedanz ist, wobei der fünfte Wert des transformierten ersten Quellreflexionsfaktors der fünften Impedanz zugehörig ist.

In dem Verfahren wird das erste Anpassnetzwerk anhand des ersten Lastreflexionsfaktors, des ersten Wertes des transformierten ersten Lastreflexionsfaktors, des ersten Quellreflexionsfaktors und des fünften Wertes des transformierten ersten Quellreflexionsfaktors bestimmt.

In dem Verfahren wird das zweite Anpassnetzwerk anhand des zweiten Wertes des transformierten zweiten Lastreflexionsfaktors, des dritten Wertes des transformierten dritten Lastreflexionsfaktors, des dritten Lastreflexionsfaktors sowie des vierten Wertes des zweiten Lastreflexionsfaktors bestimmt.

Die Aufgabe wird weiterhin durch das Verfahren mit den Merkmalen des unabhängigen Anspruchs 7 gelöst. Vorteilhafte Weiterbildungen sind in der Beschreibung enthalten.

Demzufolge ist ein Verfahren zur Auslegung einer elektronischen Schaltung vorgesehen. Die Schaltung weist ein erstes Quellenelement mit einem ersten Quellenausgang und mit einem ersten Quellreflexionsfaktor auf.

Die Schaltung weist ein zweites Quellenelement mit einem zweiten Quellenausgang und mit einem zweiten Quellreflexionsfaktor auf. Die Schaltung weist zudem eine Last auf. Die Last kann aus einem oder mehreren Elementen gebildet sein. Die Schaltung weist ein T-Stück mit einem ersten Eingang und einem zweiten Eingang und einem Ausgang auf.

Das T-Stück weist in den ersten Eingang hinein einen ersten Lastreflexionsfaktor auf. Das T-Stück weist in den zweiten Eingang hinein einen zweiten Lastreflexionsfaktor auf. Der Ausgang des T-Stücks ist mit der Last verbunden.

Die Schaltung weist ein erstes Anpassnetzwerk mit einem ersten Anschluss und einen zweiten Anschluss auf. Der zweite Anschluss des ersten Anpassnetzwerkes ist mit dem ersten

Quellenausgang des ersten Quellenelements verbunden. Der erste Anschluss des ersten Anpassnetzwerkes ist mit dem ersten Eingang des T-Stücks verbunden.

Durch das erste Anpassnetzwerk wird in den zweiten Anschluss hinein ein transformierter erster Lastreflexionsfaktor und in den ersten Anschluss hinein ein transformierter erster Quellreflexionsfaktor bewirkt.

Die Schaltung weist ein zweites Anpassnetzwerk mit einem dritten Anschluss und einem vierten Anschluss auf. Der vierte Anschluss des zweiten Anpassnetzwerkes ist mit dem zweiten Quellenausgang des zweiten Quellenelementes verbunden. Der dritte Anschluss des zweiten Anpassnetzwerkes ist mit dem zweiten Eingang des T-Stücks verbunden.

Durch das zweite Anpassnetzwerk wird in den vierten Anschluss hinein ein transformierter zweiter Lastreflexionsfaktor und in den dritten Anschluss hinein ein transformierter zweiter Quellreflexionsfaktor bewirkt.

Ein erster Wert des transformierten ersten Lastreflexionsfaktors wird ermittelt. Das erste Quellenelement weist für den am ersten Quellenausgang wirkenden ersten Wert des transformierten ersten Lastreflexionsfaktors ein erstes Optimum einer ersten Kenngröße auf. Wird der erste Quellenausgang also genau mit dem ersten transformierten Lastreflexionsfaktor abgeschlossen ist die erste Kenngröße beispielsweise minimal oder maximal. Gemäß einer Randbedingung weicht der erste Wert des transformierten ersten Lastreflexionsfaktors vom komplex Konjugierten des ersten Quellreflexionsfaktors ab.

Ein zweiter Wert des transformierten zweiten Lastreflexionsfaktors wird ermittelt. Das zweite Quellenelement weist für den am zweiten Quellenausgang wirkenden zweiten Wert des transformierten zweiten Lastreflexionsfaktors ein zweites Optimum einer zweiten Kenngröße auf. Dabei weicht der zweite Wert des transformierten zweiten Lastreflexionsfaktors vom komplex Konjugierten des zweiten Quellreflexionsfaktors ab. Vorzugsweise sind die erste Kenngröße und die zweite Kenngröße gleich.

Unter den genannten Randbedingungen sind die Verfahrensschritte ein signifikanter Teil der Erfindung. Das Verfahren zur Auslegung der elektronischen Schaltung erfolgt vollautomatisch-insbesondere rechnergesteuert. Hierzu werden Messdaten von Elementen der Schaltung, wie Transistoren, Impedanzen oder dergleichen, durch Messungen ermittelt. Die Messdaten werden in einen Programmablauf zur Bestimmung der Elemente der Anpassnetzwerke der elektronischen Schaltung eingegeben. Hierdurch ist eine Bestimmung der beispielsweise kapazitiven oder induktiven Elemente des Anpassnetzwerks möglich. Ein menschlicher Eingriff in das Verfahren ist hingegen nicht erforderlich. Die Anpassnetzwerke werden nachfolgend beispielsweise auf einem Chip zusammen mit anderen Schaltungskomponenten integriert.

Das Verfahren zur Auslegung der elektronischen Schaltung weist mehrere Schritte auf.

In einem Verfahrensschritt werden ein Abstandswert und ein dritter Wert des transformierten ersten Lastreflexionsfaktors und ein vierter Wert des transformierten zweiten Lastreflexionsfaktors bestimmt. Hierzu wird ein erster Abstand zwischen dem ersten Wert und dem transformierten ersten Lastreflexionsfaktor definiert durch

$$P_1 = \operatorname{arctanh}\left(\frac{|a'_{opt} - a'|}{|1 - a'^* a'_{opt}|}\right) \tag{15}$$

Dabei ist $P_1$ der erste Abstand. a' ist der transformierte erste Lastreflexionsfaktor. a'* ist das komplex Konjugierte des transformierten ersten Lastreflexionsfaktors. $a'_{opt}$ ist der erste Wert.

Es wird hierzu ein zweiter Abstand zwischen dem zweiten Wert und dem transformierten zweiten Lastreflexionsfaktor definiert durch

$$P_2 = \operatorname{arctanh}\left(\frac{|c'_{opt} - c'|}{|1 - c'^* c'_{opt}|}\right) \tag{16}$$

Dabei ist $P_2$ der zweite Abstand. c' ist der transformierte zweite Lastreflexionsfaktor. c'* ist das komplex Konjugierte des transformierten zweiten Lastreflexionsfaktor. $c'_{opt}$ ist der zweite Wert.

Es wird hierzu ein dritter Abstand zwischen dem transformierten ersten Lastreflexionsfaktor und dem komplex Konjugierten des ersten Quellreflexionsfaktors definiert durch

$$P_3 = \operatorname{arctanh}\left(\frac{|a' - b^*|}{|1 - ba'|}\right) \tag{17}$$

Dabei ist $P_3$ der dritte Abstand. b ist der erste Quellreflexionsfaktor. b* ist das komplex Konjugierte des ersten Quellreflexionsfaktors. a' ist der transformierte erste Lastreflexionsfaktor.

Es wird hierzu ein vierter Abstand zwischen dem transformierten zweiten Lastreflexionsfaktor und dem komplex Konjugierten des zweiten Quellreflexionsfaktors definiert durch

$$P_4 = \operatorname{arctanh}\left(\frac{|c' - d^*|}{|1 - dc'|}\right) \tag{18}$$

Dabei ist $P_4$ der vierte Abstand. d ist der zweite Quellreflexionsfaktor. d* ist das komplex Konjugierte des zweiten Quellreflexionsfaktors. c' ist der transformierte zweite Lastreflexionsfaktor. Der erste Abstand, der zweite Abstand, der dritte Abstand und der vierte Abstand können auch als Poincaré-Abstände bezeichnet werden.

In einem weiteren Verfahrensschritt werden der Abstandswert und der dritte Wert und der vierte Wert definiert, indem ein Minimum des geometrischen Mittels aus dem ersten Abstand und dem zweiten Abstand bestimmt wird unter der Randbedingung, dass der dritte Abstand gleich dem vierten Abstand und von Null verschieden ist. Zur Bestimmung des Minimums werden der transformierte erste Lastreflexionsfaktor und der transformierte zweite Lastreflexionsfaktor variiert werden. Das komplex Konjugierte des ersten Quellreflexionsfaktors und das komplex Konjugierte des zweiten Quellreflexionsfaktors und der erste Wert und der zweite Wert weisen hierzu hingegen einen festen Wert auf.

Dabei gilt für die Bedingung des Minimums beispielsweise:

$$\sqrt{P_1^2 + P_2^2} = \min \tag{19}$$

Zudem werden der dem Minimum zugehörige Wert des dritten Abstands als Abstandswert und der dem Minimum zugehörige Wert des transformierten ersten Lastreflexionsfaktors als dritter Wert und der dem Minimum zugehörige Wert des transformierten zweiten Lastreflexionsfaktors als vierter Wert festgelegt.

In einem anderen Verfahrensschritt werden ein fünfter Wert des transformierten ersten Quellreflexionsfaktors und ein sechster Wert des transformierten zweiten Quellreflexionsfaktors bestimmt. Hierzu wird ein erster Kreis mit reellem Mittelpunkt bestimmt, der einen reellen Reflexionsfaktorwert von einem Drittel und einen reellen Reflexionsfaktorwert von minus eins schneidet.

Es wird zudem ein zweiter Kreis als Menge aller Punkte mit einem Abstand von dem reellen Reflexionsfaktorwert von einem Drittel gleich dem Abstandswert bestimmt durch

$$P\left(y, \frac{1}{3}\right) = \operatorname{arctanh}\left(\frac{\left|y - \frac{1}{3}\right|}{\left|1 - y\frac{1}{3}\right|}\right) \equiv P_{aus} \tag{20}$$

Dabei ist y ein Punkt auf dem zweiten Kreis. $P_{aus}$ ist der Abstandswert des dritten Abstandes.

Zudem werden der fünfte Wert gleich einem ersten Schnittpunkt zwischen dem ersten Kreis und dem zweiten Kreis und der sechste Wert gleich einem von dem ersten Schnittpunkt verschiedenen zweiten Schnittpunkt zwischen dem ersten Kreis und dem zweiten Kreis bestimmt. In einem anderen Verfahrensschritt wird das erste Anpassnetzwerk anhand des ersten Quellreflexionsfaktors und des transformierten ersten Quellreflexionsfaktors und des dritten Wertes des transformierten ersten Lastreflexionsfaktors bestimmt.

In einem anderen Verfahrensschritt wird das zweite Anpassnetzwerk anhand des zweiten Quellreflexionsfaktors und des transformierten zweiten Quellreflexionsfaktors und des vierten Wertes des transformierten zweiten Lastreflexionsfaktors bestimmt.

In einem Verfahrensschritt wird das erste Anpassnetzwerk anhand des ersten Quellreflexionsfaktors und des fünften Wertes (des transformierten ersten Quellreflexionsfaktors und des ersten Lastreflexionsfaktors und des dritten Wertes des transformierten ersten Lastreflexionsfaktors bestimmt.

In einem Verfahrensschritt wird das zweite Anpassnetzwerk anhand des zweiten Quellreflexionsfaktors und des sechsten Wertes des transformierten zweiten Quellreflexionsfaktors und des zweiten Lastreflexionsfaktors und des vierten Wertes des transformierten zweiten Lastreflexionsfaktors bestimmt.

Der Erfindung liegt weiterhin die Aufgabe zu Grunde, eine möglichst verbesserte Schaltung anzugeben.

Diese Aufgabe wird durch die elektronische Schaltung mit den Merkmalen des Anspruchs 8 gelöst. Vorteilhafte Weiterbildungen sind Gegenstand von abhängigen Ansprüchen und in der Beschreibung enthalten.

Demzufolge ist eine elektronische Schaltung mit zumindest einer Quelle, mit zumindest einer Last und mit zumindest einem Anpassnetzwerk vorgesehen. Das Anpassnetzwerk ist gemäß einem der zuvor erläuterten Verfahren ausgelegt.

In einer besonders vorteilhaften Weiterbildung weist die Schaltung ein erstes Anpassnetzwerk und ein zweites Anpassnetzwerk auf. Die Schaltung weist einen ersten Betriebszustand und einen zweiten Betriebszustand auf. Die Schaltung weist ein erstes Quellenelement mit einem ersten Quellenausgang und ein zweites Quellenelement mit einem zweiten Quellenausgang auf. Vorzugsweise sind das erste Quellenelement ein erster Verstärker und das zweite Quellenelement ein zweiter Verstärker. Vorzugsweise sind der erste Verstärker und der zweite Verstärker Bestandteile eines Doherty-Verstärkers. Der erste Verstärker und/oder der zweite Verstärker weist vorzugsweise einen LDMOS-Transistor zur Verstärkung auf.

Das erste Quellenelement weist in den ersten Quellenausgang hinein im ersten Betriebszustand einen ersten Quellreflexionsfaktor auf.

Die Schaltung weist eine Last mit einem Lasteingang auf. Die Last weist in den Lasteingang hinein einen Last-Eingangsreflexionsfaktor auf. Entsprechend weist die Last eine Lastimpedanz auf.

Die Schaltung weist ein T-Stück mit einem ersten Eingang, einem zweiten Eingang und einen Ausgang auf. Der Lasteingang der Last ist mit dem Ausgang des T-Stücks verbunden. Das T-Stück ist vorzugsweise ein T-förmiger Leiter, der vorzugsweise aus Metall ist. Beispielsweise ist das T-Stück auf einem Halbleiterchip integriert.

Das T-Stück weist in den ersten Eingang hinein im zweiten Betriebszustand einen ersten Lastreflexionsfaktor auf. Das T-Stück weist in den zweiten Eingang hinein im ersten Betriebszustand einen zweiten Lastreflexionsfaktor auf. Das T-Stück weist in den zweiten Eingang hinein im zweiten Betriebszustand einen dritten Lastreflexionsfaktor auf.

Die Schaltung weist das erste Anpassnetzwerk mit einem ersten Anschluss und einem zweiten Anschluss auf. Der der erste Anschluss ist mit dem ersten Eingang des T-Stücks verbundenen. Der zweite Anschluss ist mit dem ersten Quellenausgang des ersten Quellenelements verbunden.

Das erste Anpassnetzwerk weist in den ersten Anschluss hinein im ersten Betriebszustand einen transformierten ersten Quellreflexionsfaktor auf. Das erste Anpassnetzwerk weist in den zweiten Anschluss hinein im zweiten Betriebszustand einen transformierten ersten Lastreflexionsfaktor auf.

Die Schaltung weist das zweite Anpassnetzwerk mit einem dritten Anschluss und einem vierten Anschluss auf. Der dritte Anschluss ist mit dem zweiten Eingang des T-Stücks verbunden.

Der vierte Anschluss des zweiten Anpassnetzwerks ist mit dem zweiten Quellenausgang verbunden.

Das zweite Anpassnetzwerk weist in den vierten Anschluss hinein im ersten Betriebszustand einen transformierten zweiten Lastreflexionsfaktor auf. Das zweite Anpassnetzwerk weist in den vierten Anschluss hinein im zweiten Betriebszustand einen transformierten dritten Lastreflexionsfaktor auf.

Ein erster Wert des transformierten ersten Lastreflexionsfaktors wird zur Optimierung einer Kenngröße der Schaltung bestimmt, indem im zweiten Betriebszustand eine Messung durchgeführt wird. Ein zweiter Wert des transformierten zweiten Lastreflexionsfaktors wird zur Optimierung der Kenngröße der Schaltung bestimmt, indem im ersten Betriebszustand eine Messung durchgeführt wird. Ein dritter Wert des transformierten dritten Lastreflexionsfaktors wird zur Optimierung der Kenngröße der Schaltung bestimmt, indem im zweiten Betriebszustand eine Messung durchgeführt wird.

Die Anpassnetzwerke sind dabei ausgelegt, indem der erste Lastreflexionsfaktors auf einen ersten Anfangswert festgelegt wird. Der erste Anfangswert kann beispielsweise beliebig oder anhand des Last-Eingangsreflexionsfaktors festgelegt werden. Ebenfalls wird der zweite Lastreflexionsfaktors auf zweiten Anfangswert festgelegt. Der zweite Anfangswert kann beispielsweise beliebig oder anhand des Last-Eingangsreflexionsfaktors festgelegt werden.

Es wird ein erster Abstand zwischen dem ersten Wert und dem komplex Konjugierten des ersten Quellreflexionsfaktors bestimmt durch

$$P_1 = \operatorname{arctanh}\left(\frac{\left|a_{on}{'}_{opt} - b_{off}{}^*\right|}{\left|1 - b_{off}{}^* * a_{on}{'}_{opt}{}^*\right|}\right) \tag{21}$$

Dabei ist $b_{off}$ der erste Quellreflexionsfaktor, $b_{off}{}^*$ das komplexe Konjugierte des ersten Quellreflexionsfaktors, $a_{on}{'}_{opt}$ der erste Wert des transformierten ersten Lastreflexionsfaktors und $P_1$ der erste Abstand.

Es wird ein erster Kreis als Menge aller Punkte im berechneten ersten Abstand von dem komplex Konjugierten des ersten Lastreflexionsfaktors bestimmt durch

$$P(y, a_{on}{}^*) = \operatorname{arctanh}\left(\frac{\left|y - a_{on}{}^*\right|}{\left|1 - y * a_{on}{}^*\right|}\right) \equiv P_1 \tag{22}$$

Dabei ist $y$ ein Punkt auf dem ersten Kreis. $y^*$ ist das komplex Konjugierte des Punktes auf dem ersten Kreis. $a_{on}{}^*$ das komplex Konjugierte des ersten Lastreflexionsfaktors und $P_1$ ist der erste Abstand.

Es wird ein dritter Abstand zwischen dem zweiten Wert und dem dritten Wert bestimmt durch

$$P_3 = \operatorname{arctanh}\left(\frac{\left|c_{on}{}'_{opt} - c_{off}{}'_{opt}\right|}{\left|1 - c_{on}{}'_{opt} * c_{off}{}'_{opt}\right|}\right) \qquad (23)$$

Dabei ist $c_{off}{}'_{opt}$ der zweite Wert des transformierten zweiten Lastreflexionsfaktors, $c_{on}{}'_{opt}$ ist der dritte Wert des transformierten dritten Lastreflexionsfaktors. $c_{on}{}'_{opt}*$ ist das konjugiert Komplexe des dritten Wertes des transformierten dritten Lastreflexionsfaktors.

Es wird ein dritter Kreis als Menge aller Punkte im dritten Abstand von dem dritten Lastreflexionsfaktor bestimmt durch

$$P(z, c_{on}) = \operatorname{arctanh}\left(\frac{\left|z - c_{on}\right|}{\left|1 - z * c_{on}\right|}\right) \equiv P_3 \qquad (24)$$

Dabei ist z ein Punkt auf dem dritten Kreis. z* ist das komplex Konjugierte des Punktes auf dem dritten Kreis. $c_{on}$ ist der dritte Lastreflexionsfaktor. $c_{on}*$ ist das komplex Konjugierte des dritten Lastreflexionsfaktors und $P_3$ ist der dritte Abstand.

Es wird ein veränderter erster Kreis bestimmt. Dieser veränderte erste Kreis kann auch als Bildkreis bezeichnet werden. Dabei wird der veränderte erste Kreis bestimmt als Menge aller veränderten Reflexionsfaktoren, wobei jeder der veränderten Reflexionsfaktoren einer Gesamtimpedanz zugehörig ist. Jede Gesamtimpedanz wird bestimmt aus einer ersten Parallelschaltung einer Lastimpedanz der Last und einer zu einem Reflexionsfaktor auf dem ersten Kreis zugehörigen Impedanz. Dabei ist die Lastimpedanz dem Last-Eingangsreflexionsfaktor der Last zugehörig.

Es wird zumindest ein vierter Wert des zweiten Lastreflexionsfaktors bestimmt, wobei für den zumindest einen vierten Wert eine Quadratsumme von Abständen zwischen dem vierten Wert und dem dritten Kreis sowie zwischen dem vierten Wert und dem veränderten ersten Kreis minimiert wird.

Es wird ein fünfter Wert des transformierten ersten Quellreflexionsfaktors zu jedem vierten Wert des zweiten Lastreflexionsfaktors bestimmt. Dabei wird eine vierte Impedanz ermittelt, wobei die vierte Impedanz zum vierten Wert des zweiten Lastreflexionsfaktors zugehörig ist. Es wird eine fünfte Impedanz ermittelt, so dass eine zweite Parallelschaltung der fünften Impedanz mit der Lastimpedanz gleich der vierten Impedanz ist, wobei der fünfte Wert des transformierten ersten Quellreflexionsfaktors der fünften Impedanz zugehörig ist.

Das erste Anpassnetzwerk ist anhand des ersten Lastreflexionsfaktors, des ersten Wertes des transformierten ersten Lastreflexionsfaktors, des ersten Quellreflexionsfaktors und des fünften Wertes des transformierten ersten Quellreflexionsfaktors ausgelegt.

Das zweite Anpassnetzwerk ist anhand des zweiten Wertes des transformierten zweiten Lastreflexionsfaktors, des dritten Wertes des transformierten dritten Lastreflexionsfaktors, des dritten Lastreflexionsfaktors sowie des vierten Wertes des zweiten Lastreflexionsfaktors ausgelegt.

Das zweite Quellenelement ist zur Ausgabe eines Signals mit einer Mittenfrequenz ausgebildet. Die Last weist eine Lastimpedanz auf. Das zweite Anpassnetzwerk weist leitungsartige Serienelemente auf, die das Signal führen. Die leitungsartigen Serienelemente weisen ausschließlich Leitungsimpedanzen kleiner als die Lastimpedanz auf.

Eine Summe der elektrischen Längen derjenigen leitungsartigen Serienelemente, die jeweils eine Leitungsimpedanz größer als die Lastimpedanz aufweisen, ist kleiner als ein Viertel einer dem Signal zugehörigen leitungsgebundenen Wellenlänge.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Die elektronische Schaltung und das erfindungsgemäße Verfahren zur Auslegung einer elektronischen Schaltung mit einem Anpassnetzwerk werden nachfolgend anhand mehrer Figuren näher erläutert.

Dabei zeigt

Fig. 1    eine serielle Schaltungsanordnung, wie sie für Hochfrequenzanwendungen geeignet ist,
Fig. 2    ein schematisches Diagramm mit einer ersten Kenngröße,
Fig. 3    einen schematisch dargestellten Poincaré- Kreis,
Fig. 4    einen weiteren schematisch dargestellten Poincaré- Kreis,
Fig. 5    eine schematische Darstellung von Lastreflexionsfaktoren bezüglich eines Anpassnetzwerkes,
Fig. 6    ein Smith- Diagramm mit Poincaré- Kreisen,

| Fig. 7 | ein Smith- Diagramm mit Poincaré- Kreisen, |
|---|---|
| Fig. 8 | ein Smith- Diagramm mit zwei konzentrischen Scharen von Poincaré- Kreisen, |
| Fig. 9 | einen Schaltplan mit einer variablen Last, |
| Fig. 10 | ein schematisches Diagramm mit einer zweiten Kenngröße, |
| Fig. 11 | einen weiteren schematisch dargestellten Poincaré- Kreis, |
| Fig. 12 | einen schematischen Schaltplan einer Doherty- Lastmodulations- verstärkeranordnung, |
| Fig. 13 | eine weitere schematische Darstellung zweier Poincaré- Kreise, |
| Fig. 14 | eine weitere schematische Darstellung zweier Poincaré- Kreise, |
| Fig. 15 | ein weiteres Smith- Diagramm mit Poincaré- Kreisen, |
| Fig. 16 | ein weiteres Smith- Diagramm mit Poincaré- Kreisen, |
| Fig. 17 bis 19 | schematische Ersatzschaltung zur Signaladdition, |
| Fig. 20 | ein schematisches Ersatzschaltbild mit einem T- Stück, |
| Fig. 21 | ein schematisches Ersatzschaltbild mit Zirkulatoren, |
| Fig. 22 | einen schematischen Schaltplan einer Verstärkeranordnung, |
| Fig. 23 | eine weitere schematische Darstellung zweier Poincaré- Kreise, |
| Fig. 24 | ein schematisches Diagramm mit einer ersten Kenngröße, |
| Fig. 25 | ein schematisches Diagramm mit einer zweiten Kenngröße, |
| Fig. 26 | eine schematische Darstellung zweier Poincaré- Kreise, |
| Fig. 27 | eine schematisch Darstellung einer Verstärkeranordnung, |
| Fig. 28 bis 31 | Struktur eines Anpassnetzwerks, und |
| Fig. 32 | Diagramme zu realisierten Strukturen von Anpassnetzwerken. |

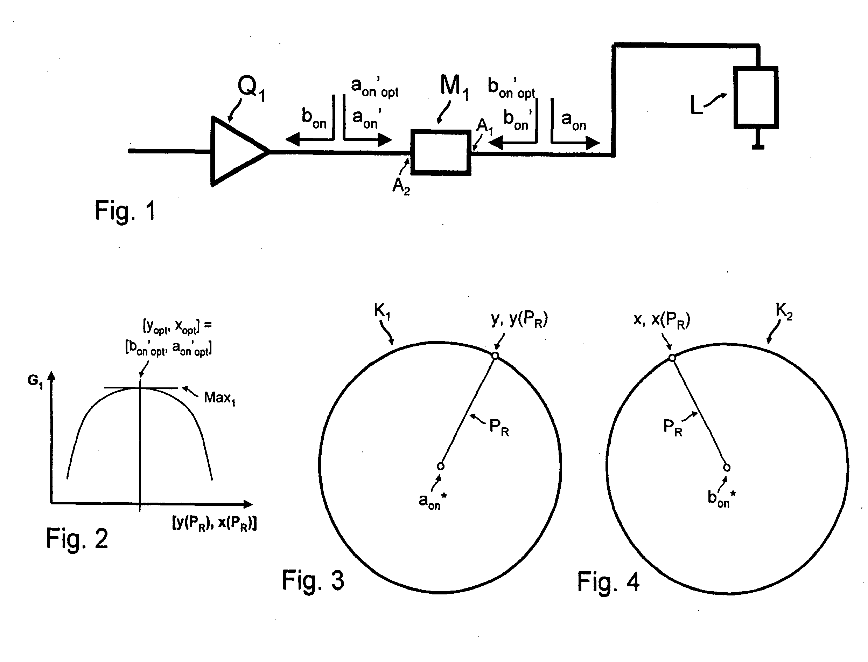

In Fig. 1 ist eine Schaltung als Blockschaltplan schematisch dargestellt. Die Schaltung weist ein erstes Anpassnetzwerk $M_1$ mit einem ersten Anschluss $A_1$ und einem zweiten Anschluss $A_2$ auf. Die Schaltung eine mit dem ersten Anschluss $A_1$ verbundene Last L auf.

Am ersten Anschluss $A_1$ des ersten Anpassnetzwerks $M_1$ wird ein von der Last L abhängiger erster Lastreflexionsfaktor $a_{on}$ bewirkt.

Die Schaltung weist ein mit dem zweiten Anschluss $A_2$ des ersten Anpassnetzwerks $M_1$ verbundenes erstes Quellenelement $Q_1$ mit einem ersten Quellreflexionsfaktor $b_{on}$ auf. Im Ausführungsbeispiel der Fig. 1 ist ein Quellenausgang $QA_1$ des ersten Quellenelement $Q_1$ an den zweiten Anschluss $A_2$ des ersten Anpassnetzwerks $M_1$ angeschlossen.

Durch das erste Anpassnetzwerk $M_1$ wird in den zweiten Anschluss $A_2$ hinein ein transformierter erster Lastreflexionsfaktor $a_{on}'$ und in den ersten Anschluss $A_1$ hinein ein transformierter erster Quellreflexionsfaktor $b_{on}'$ bewirkt.

In Fig. 2 ein Diagramm mit einer ersten Kenngröße G1 der Schaltung aus Fig. 1 gezeigt. In dem nachfolgend erläuterten Verfahren wird die elektronische Schaltung zur Optimierung der ersten Kenngröße G1 ausgelegt. Die erste Kenngröße G1 ist im Ausführungsbeispiel der Fig. 2 abhängig von dem Punktepaar $[y\,(P_R),\,y\,(P_R)\,]$ und weist für die Werte $[y_{opt},\,x_{opt}]$ bzw. $[b_{on}{}'_{opt},\,a_{on}{}'_{opt}]$ als Optimum ein Maximum $Max_1$ auf. Zunächst wird ein erster Wert $b_{on}{}'_{opt}$ des transformierten ersten Quellreflexionsfaktors $b_{on}'$ und ein zweiter Wert $a_{on}{}'_{opt}$ des transformierten ersten Lastreflexionsfaktors $a_{on}'$ bestimmt.

In Fig. 3 ist ein erster Kreis $K_1$ als Menge aller Punkte im ersten Abstand $P_R$ von dem komplex Konjugierten $a_{on}{}^*$ des ersten Lastreflexionsfaktors $a_{on}$ schematisch dargestellt. Der erste Kreis wird bestimmt durch

$$P(y, a_{on}{}^*) = \operatorname{arctanh}\left(\frac{|y - a_{on}{}^*|}{|1 - y^* a_{on}{}^*|}\right) \equiv P_R \qquad (25)$$

Dabei ist y ein Punkt auf dem ersten Kreis $K_1$. $y^*$ ist das komplex Konjugierte des Punktes y auf dem ersten Kreis $K_1$. $a_{on}{}^*$ ist das komplex Konjugierte $a_{on}{}^*$ des ersten Lastreflexionsfaktors $a_{on}$, und $P_R$ ist der erste Abstand $P_R$. Der erste Kreis $K_1$ wird dabei für jeden ersten Abstand $P_R$ einer Anzahl von ersten Abständen $P_R$ bestimmt.

In Fig. 4 ist ein zweiter Kreis $K_2$ als Menge aller Punkte im ersten Abstand $P_R$ von dem komplex Konjugierten $b_{on}{}^*$ des ersten Quellreflexionsfaktors $b_{on}$ schematisch dargestellt. Der zweite Kreis $K_2$ wird bestimmt durch

$$P(x, b_{on}{}^*) = \operatorname{arctanh}\left(\frac{|x - b_{on}{}^*|}{|1 - x^* b_{on}{}^*|}\right) \equiv P_R \qquad (26)$$

Dabei ist x ein Punkt auf dem zweiten Kreis $K_2$. $x^*$ ist das komplex Konjugierte des Punktes x auf dem zweiten Kreis $K_2$. $b_{on}^*$ ist das komplex Konjugierte $b_{on}^*$ des ersten Quellreflexionsfaktors $b_{on}$. $P_R$ ist der erste Abstand $P_R$. Der zweite Kreis $K_2$ wird dabei für jeden ersten Abstand $P_R$ einer Anzahl von ersten Abständen $P_R$ bestimmt.

In dem Verfahren wird eine Anzahl von ersten Punktepaaren $[y(P_R), x(P_R)]$ bestimmt. Dabei ist, wie in Fig. 3 dargestellt ein erster Paarpunkt $y(P_R)$ jedes Punktepaares $[y(P_R), x(P_R)]$ auf dem ersten Kreis $K_1$. Ein zweiter Paarpunkt $x(P_R)$ jedes Punktepaares $[y(P_R), x(P_R)]$ ist, wie in Fig. 4 dargestellt, auf dem zweiten Kreis $K_2$.

In dem Verfahren wird ein Wert der ersten Kenngröße G1 für jedes erste Punktepaar $[y(P_R), x(P_R)]$ bestimmt, mit dem ersten Paarpunkt $y(P_R)$ gleich einem Wert des transformierten ersten Quellreflexionsfaktors $b_{on}'$ und mit dem zweiten Paarpunkt $x(P_R)$ gleich einem Wert des transformierten ersten Lastreflexionsfaktors $a_{on}'$.

Das Optimum $Max_1$ der ersten Kenngröße $G_1$ wird aus allen Werten der ersten Kenngröße $G_1$, die den ersten Punktepaaren $[y(P_R), x(P_R)]$ zugeordnet sind, bestimmt. Dabei wird ein erstes Wertepaar $[y_{opt}, y_{opt}]$ aus den ersten Punktepaaren $[y(P_R), x(P_R)]$ bestimmt, wobei dem ersten Wertepaar $[y_{opt}, x_{opt}]$ das Optimum $Max_1$ zugeordnet ist.

Der erste Wertes $b_{on}'_{opt}$ des transformierten ersten Quellreflexionsfaktors $b_{on}'$ ist gleich einem ersten Wertepunkt $y_{opt}$ des ersten Wertepaares $[y_{opt}, x_{opt}]$. Der zweite Wert $a_{on}'_{opt}$ des transformierten ersten Lastreflexionsfaktors $a_{on}'$ ist gleich einem zweiten Wertepunkt $x_{opt}$ des ersten Wertepaares $[y_{opt}, x_{opt}]$.

Das erste Anpassnetzwerks $M_1$ in Fig. 1 wird anhand des ersten Wertes $b_{on}'_{opt}$ des transformierten ersten Quellreflexionsfaktors $b_{on}'$ und des zweiten Wertes $a_{on}'_{opt}$ des transformierten ersten Lastreflexionsfaktors $a_{on}'$ und des ersten Quellreflexionsfaktors $b_{on}$ und des ersten Lastreflexionsfaktors $a_{on}$ bestimmt.

Fig. 1 zeigt die elektronische Schaltung 1 beispielsweise als Verstärkerkette aus einem ersten Verstärker als das erste Quellenelement $Q_1$ mit dem Quellreflexionsfaktor b1, dem Anpassnetzwerk M1 mit dem ersten Anschluss A1 und dem zweiten Anschluss A2 und einem Lastelement L mit dem Lastreflexionsfaktor a1. Das Lastelement L ist beispielsweise ein zweiter Verstärker, der eingangsseitig mit dem ersten Anpassnetzwerk M1 verbunden ist. Der erste Anschluss A1 ist mit dem Lastelement L und der zweite Anschluss A2 ist mit dem Quellenelement Q1 verbunden.

Durchläuft ein elektrisches Signal, beispielsweise als Spannungswelle betrachtet, eine Diskontinuität in der Impedanz des signalführenden Kanals, erfordern die Kirchhoff'schen Gesetze, dass ein Teil der hinlaufenden Welle zurückreflektiert wird. Arbeitet das Quellenelement Q1 mit einer Ausgangsimpedanz in die Last L mit einer Eingangsimpedanz, so nimmt das Quellenelement Q1 weder Last L noch Eingangsimpedanz war, sondern ausschließlich den reflektierten, zum Quellenelement Q1 zurücklaufenden Signalanteil.

Die für das Hochfrequenzverhalten primär bedeutende Größe ist hiernach weniger die jeweilige Impedanz, als der jeweilige Reflexionsfaktor. In den Ausführungsbeispielen werden entsprechend Impedanzen und Reflexionsfaktoren verwendet, die mittels eineindeutiger Abbildung ineinander überführbar sind.

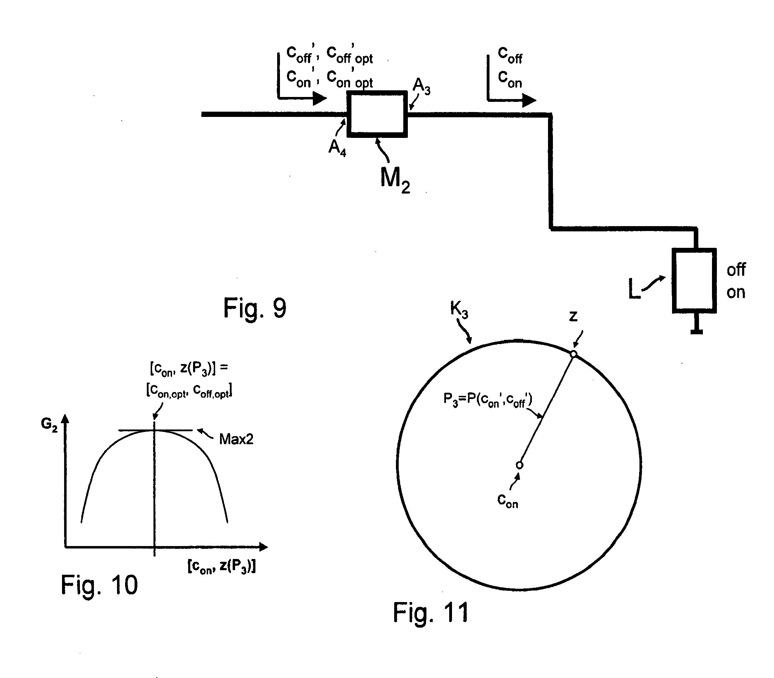

Fig. 9 zeigt eine Schaltung, die beispielsweise für Hochfrequenzsignal ausgelegt werden soll. Die Schaltung weist ein zweites Anpassnetzwerk $M_2$ mit einem dritten Anschluss $A_3$ und einem vierten Anschluss $A_4$ auf. Die Schaltung weist eine mit dem dritten Anschluss $A_3$ verbundene variable Last L mit einem ersten Betriebszustand off und einem zweiten Betriebszustand on auf. An dem dritten Anschluss $A_3$ wird im zweiten Betriebszustand on ein zweiter Lastreflexionsfaktor $c_{on}$ und in dem ersten Betriebszustand off ein dritter Lastreflexionsfaktor $c_{off}$ bewirkt. Durch das zweite Anpassnetzwerk $M_2$ wird in den vierten Anschluss $A_4$ hinein im zweiten Betriebszustand ein transformierter zweiter Lastreflexionsfaktor $c_{on}'$ und im ersten Betriebszustand ein transformierter dritter Lastreflexionsfaktor $c_{off}'$ bewirkt.

In Fig. 10 ist ein schematisches Diagramm einer zweiten Kenngröße $G_2$ der Schaltung aus Fig. 9 dargestellt. In einem Verfahren zur Auslegung der elektronischen Schaltung der Fig. 9 soll die zweite Kenngröße $G_2$ der Schaltung optimiert werden. Beispielsweise ist das Optimum, wie in der Fig. 10 dargestellt, ein Maximum $Max_2$ der zweiten Kenngröße $G_2$.

In Fig. 11 ist ein dritter Kreis K3 um einen zweiten Lastreflexionsfaktor $c_{on}$ schematisch dargestellt. In einem Verfahren zur Auslegung der elektronischen Schaltung der Fig. 9 wird ein dritter Wert $c_{off,opt}$ des dritten Lastreflexionsfaktors $c_{off}$ und ein vierter Wert $c_{on,opt}$ des zweiten Lastreflexionsfaktors $c_{on}$ bestimmt.

Hierzu wird ein dritter Abstand $P_3$ zwischen dem transformierten zweiten Lastreflexionsfaktor $c_{on}'$ und dem transformierten dritten Lastreflexionsfaktor $c_{off}'$ bestimmt wird durch

$$P_3 = \operatorname{arctanh}\left(\frac{|c_{off}' - c_{on}'|}{|1 - c_{off}'^* c_{on}'|}\right) \tag{27}$$

Dabei ist $c_{on}'$ der transformierte zweite Lastreflexionsfaktor $c_{on}'$. $c_{off}'$ ist der transformierte dritte Lastreflexionsfaktor $c_{off}'$. $c_{off}'^*$ ist das komplex Konjugierte $c_{off}'^*$ des transformierten dritten Lastreflexionsfaktors $c_{off}'$. $P_3$ ist der dritte Abstand $P_3$.

In Fig. 11 ist ein dritter Kreis $K_3$ schematisch dargestellt. Der dritte Kreis $K_3$ wird als Menge aller Punkte im dritten Abstand $P_3$ von dem zweiten Lastreflexionsfaktor $c_{on}$ bestimmt durch

$$P(z, c_{on}) = \text{arctanh}\left(\frac{|z - c_{on}|}{|1 - z * c_{on}|}\right) \equiv P_3 \qquad (28)$$

Dabei ist $z$ ein Punkt auf dem dritten Kreis $K_3$. $z^*$ ist das komplex Konjugierte $z^*$ des Punktes $z$ auf dem dritten Kreis $K_3$. $c_{on}$ ist der zweite Lastreflexionsfaktor $c_{on}$. $c_{on}^*$ ist das komplex Konjugierte $c_{on}^*$ des zweiten Lastreflexionsfaktors $c_{on}$. $P_3$ ist der dritte Abstand $P_3$.

Es wird eine Anzahl von zweiten Punktepaaren $[c_{on}, z(P_3)]$ bestimmt. Dabei ist ein zweiter Paarpunkt $z(P_3)$ jedes zweiten Punktepaares $[c_{on}, z(P_3)]$ ein Punkt auf dem dritten Kreis $K_3$, der in Fig. 11 schematisch dargestellt ist. Gemäß der Fig. 10 wird ein Wert der zweiten Kenngröße $G_2$ bestimmt für jedes zweite Punktepaar $[c_{on}, z(P_3)]$. In Fig. 10 ist der Verlauf der zweiten Kenngröße G2 in Abhängigkeit von den zweiten Punktepaaren $[c_{on}, z(P_3)]$ schematisch dargestellt. Ein Wert des dritten Lastreflexionsfaktors $c_{off}$ ist dabei gleich dem zweiten Paarpunkt $z(P_3)$. Ein Wert des zweiten Lastreflexionsfaktor $c_{on}$ ist gleich dem ersten Paarpunkt $c_{on}$.

Das in Fig. 10 dargestellte Optimum $\text{Max}_2$ der zweiten Kenngröße $G_2$ wird bestimmt aus allen Werten der zweiten Kenngröße $G_2$, die den zweiten Punktepaaren $[c_{on}, z(P_3)]$ zugeordnet sind.

Gemäß Fig. 10 wird ein zweites Punktepaar $[c_{on,opt}, c_{off,opt}]$ bestimmt, das dem Optimum $\text{Max}_2$ zugehörig ist. Der dritte Wert $c_{off,opt}$ des dritten Lastreflexionsfaktors $c_{off}$ wird gleich einem dem Optimum $\text{Max}_2$ zugehörigen zweiten Paarpunkt $c_{off,opt}$ des dem Optimum $\text{Max}_2$ zugehörigen zweiten Punktepaares $[c_{on,opt}, c_{off,opt}]$ bestimmt. Der vierte Wert $c_{on,opt}$ des zweiten Lastreflexionsfaktors $c_{on}$ wird gleich einem dem Optimum $\text{Max}_2$ zugehörigen ersten Paarpunkt $c_{on}$ des dem Optimum $\text{Max}_2$ zugehörigen zweiten Punktepaares $[c_{on,opt}, c_{off,opt}]$ bestimmt.

Das zweite Anpassnetzwerk $M_2$ im Ausführungsbeispiel der Fig. 9 wird anhand des dritten Wertes $c_{off,opt}$ des dritten Lastreflexionsfaktors $c_{off}$ und des vierten Wertes $c_{on,opt}$ des zweiten Lastreflexionsfaktors $c_{on}$ und des transformierten zweiten Lastreflexionsfaktors $c_{on}'$ und des transformierten dritten Lastreflexionsfaktors $c_{off}'$ bestimmt.

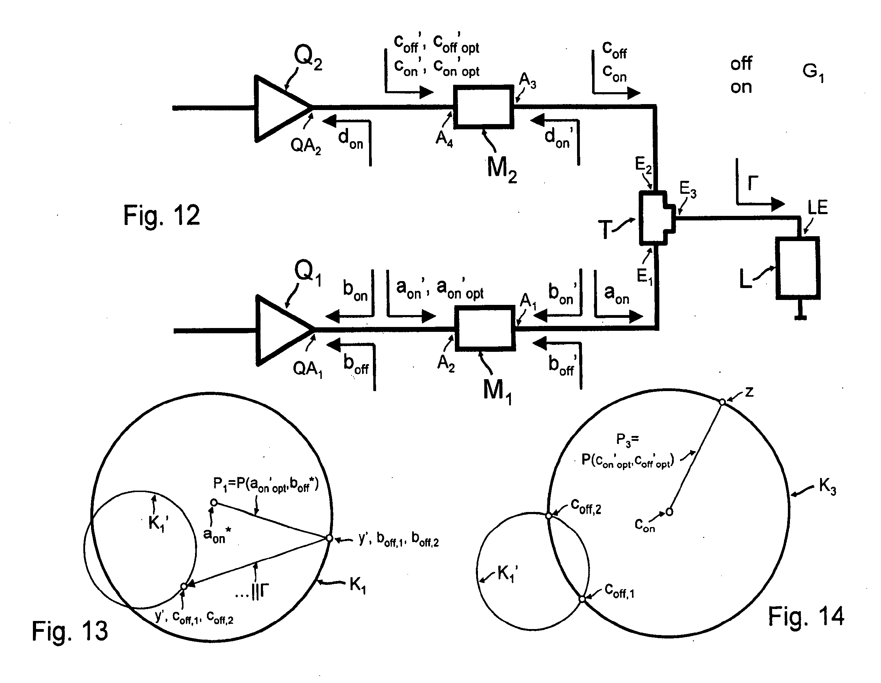

Die Fig. 12 zeigt eine elektronische Schaltung eines Ausführungsbeispiels, die ausgelegt werden soll. Die Schaltung weist einen ersten Betriebszustand off und einen zweiten Betriebszustand on auf. In Fig. 12 sind die Reflexionsfaktoren entsprechend des zugehörigen Betriebszustands bezeichnet.

Die Schaltung weist ein erstes Quellenelement $Q_1$ mit einem ersten Quellenausgang $QA_1$ und ein zweites Quellenelement $Q_2$ mit einem zweiten Quellenausgang $QA_2$ auf. Das erste Quellenelement $Q_1$ weist in den ersten Quellenausgang $QA_1$ hinein im ersten Betriebszustand off einen ersten Quellreflexionsfaktor $b_{off}$ auf.

Die Schaltung weist eine Last $L$ mit einem Lasteingang $LE$ auf. Die Last $L$ weist in den Lasteingang $LE$ hinein einen Last-Eingangsreflexionsfaktor $\Gamma$ auf.

Die Schaltung ein T-Stück $T$ mit einem ersten Eingang $E_1$ und einem zweiten Eingang $E_2$ und einen Ausgang $E_3$ auf. Der Lasteingang $LE$ der Last $L$ ist mit dem Ausgang $E_3$ des T-Stücks $T$ verbunden. Das T-Stück $T$ weist in den ersten Eingang $E_1$ hinein im zweiten Betriebszustand on einen ersten Lastreflexionsfaktor $a_{on}$ auf. Das T-Stück $T$ weist in den zweiten Eingang $E_2$ hinein im ersten Betriebszustand off einen zweiten Lastreflexionsfaktor $c_{off}$ auf. Das T-Stück $T$ weist in den zweiten Eingang $E_2$ hinein im zweiten Betriebszustand on einen dritten Lastreflexionsfaktor $c_{on}$ auf. Der erste Lastreflexionsfaktor $a_{on}$ wird auf einen ersten Anfangswert festgelegt. Der zweite Lastreflexionsfaktor $c_{on}$ wird auf einen zweiten Anfangswert festgelegt.

Die Schaltung weist ein erstes Anpassnetzwerk $M_1$ mit einem ersten Anschluss $A_1$ und einem zweiten Anschluss $A_2$ auf. Der erste Anschluss $A_1$ des ersten Anpassnetzwerkes $M_1$ ist mit dem ersten Eingang $E_1$ des T-Stücks $T$ verbundenen. Der zweite Anschluss $A_2$ des ersten Anpassnetzwerkes $M_1$ ist mit dem ersten Quellenausgang $QA_1$ verbunden. Das erste Anpassnetzwerk $M_1$ weist in den ersten Anschluss $A_1$ hinein im ersten Betriebszustand off einen transformierten ersten Quellreflexionsfaktor $b_{off}'$ auf. Das erste Anpassnetzwerk $M_1$ weist in den zweiten Anschluss $A_2$ hinein im zweiten Betriebszustand on einen transformierten ersten Lastreflexionsfaktor $a_{on}'$ auf.

Die Schaltung weist ein zweites Anpassnetzwerk $M_2$ mit einem dritten Anschluss $A_3$ und einem vierten Anschluss $A_4$ auf. Der dritte Anschluss $A_3$ des zweiten Anpassnetzwerks $M_2$ ist mit dem zweiten Eingang $E_2$ des T-Stücks $T$ verbunden. Der vierte Anschluss (A4) des zweiten Anpassnetzwerks $M_2$ ist mit dem zweiten Quellenausgang $QA_2$ verbunden. Das zweite Anpassnetzwerk $M_2$ weist in den vierten Anschluss $A_4$ hinein im ersten Betriebszustand off einen transformierten zweiten Lastreflexionsfaktor $c_{off}'$ auf. Das zweite Anpassnetzwerk $M_2$ weist in den vierten Anschluss $A_4$ hinein im zweiten Betriebszustand on einen transformierten dritten Lastreflexionsfaktor $c_{on}'$ auf.

Es wird ein erster Wert $a_{on}{}'_{opt}$ des transformierten ersten Lastreflexionsfaktors $a_{on}'$ zur Optimierung einer Kenngröße $G_1$ der Schaltung - wie beispielsweise in Fig. 2 dargestellt - im zweiten Betriebszustand on durch Messung bestimmt. Zudem wird ein zweiter Wert $c_{off}{}'_{opt}$ des transformierten zweiten Lastreflexionsfaktors $c_{off}'$ zur Optimierung der Kenngröße $G_1$ der Schaltung im ersten Betriebszustand off durch Messung bestimmt. Zudem wird ein dritter Wert $c_{on}{}'_{opt}$ des transformierten dritten Lastreflexionsfaktors $c_{on}'$ zur Optimierung der Kenngröße $G_1$ der Schaltung im zweiten Betriebszustand on durch Messung bestimmt. ,

Das Ausführungsbeispiel der Fig. 12 erlaubt selbstverständlich über die konkrete Ausführungsform hinausreichende und ausgesprochen weitgehende Anwendungen und Erkenntnisse. So erlaubt das Verfahren im Ausführungsbeispiel der Fig. 12, in Kombination mit einer Lastmodulation, eine äquivalente Ersetzung des an dem zweiten Eingang $E_1$ des T-Stückes T wirkenden Lastreflexionsfaktors (als Reflexionsfaktor einer Parallelschaltung der Lastimpedanz mit einer einem Punkt auf dem ersten Kreis entsprechenden Impedanz) durch einen sich an dem ersten Eingang $E_1$ des T-Stückes T unter Einfluss der Lastmodulation aufgrund des Signals des ersten Quellenelementes $Q_1$ ergebenen effektiven Lastreflexionsfaktor, den Anwendungsbereich des Ausführungsbeispiels der Fig. 12 noch einmal deutlich zu erweitern.

Die Fig. 13 zeigt einen ersten Abstand $P_1$. Der erste Abstand $P_1$ wird zwischen dem ersten Wert $a_{on\,opt}'$ und dem komplex Konjugierten $b_{off}*$ des ersten Quellreflexionsfaktors $b_{off}$ bestimmt durch

$$P_1 = \operatorname{arctanh}\left(\frac{\left|a_{on\,opt}'-b_{off}*\right|}{\left|1 - b_{off}*\,a_{on\,opt}'*\right|}\right) \tag{29}$$

Dabei ist $b_{off}$ der erste Quellreflexionsfaktor $b_{off}$. $b_{off}*$ ist das komplexe Konjugierte $b_{off}*$ des ersten Quellrefle-xionsfaktors $b_{off}$. $a_{on\,opt}'$ ist der erste Wert $a_{on\,opt}'$ des transformierten ersten Lastreflexionsfaktors $a_{on}$ und $P_1$ ist der erste Abstand $P_1$.

In Fig. 13 ist ein erster Kreis $K_1$ dargestellt. Der erste Kreis $K_1$ wird als Menge aller Punkte im ersten Abstand $P_1$ von dem komplex Konjugierten $a_{on}*$ des ersten Lastreflexionsfaktors $a_{on}$ bestimmt durch

$$P(y, a_{on}*) = \operatorname{arctanh}\left(\frac{\left|y - a_{on}*\right|}{\left|1 - y*a_{on}*\right|}\right) \equiv P_1 \tag{30}$$

Dabei ist y ein Punkt auf dem ersten Kreis $K_1$. $y*$ ist das komplex Konjugierte $y*$ des Punktes y auf dem ersten Kreis $K_1$. $a_{on}*$ ist das komplex Konjugierte $a_{on}*$ des ersten Lastreflexionsfaktors $a_{on}$ und $P_1$ der erste Abstand $P_1$.

Fig. 13 zeigt einen verändern ersten Kreis $K_1'$. Der veränderte erste Kreis $K_1'$ wird bestimmt als Menge aller veränderte Reflexionsfaktoren $y'$. Dabei ist jeder der veränderten Reflexionsfaktoren $y'$ einer Gesamtimpedanz zugehörig, wobei jede Gesamtimpedanz bestimmt wird aus einer ersten Parallelschaltung einer Lastimpedanz der Last (L) und einer einem Reflexionsfaktor y auf dem ersten Kreis $K_1$ zugehörigen Impedanz, wobei die Lastimpedanz dem Last-Eingangsreflexionsfaktor $\Gamma$ der Last L zugehörig ist. Dabei gilt

$$y' = y \parallel \Gamma \tag{31}$$

In Fig. 14 ist ein dritter Abstand $P_3$ gezeigt. Der dritte Abstand $P_3$ zwischen dem zweiten Wert $c_{off\,opt}'$ und dem dritten Wert $c_{on\,opt}'$ wird bestimmt durch

$$P_3 = \operatorname{arctanh}\left(\frac{\left|c_{on\,opt}'-c_{off\,opt}'\right|}{\left|1 - c_{on\,opt}'*c_{off\,opt}'\right|}\right) \tag{32}$$

Dabei ist $c_{off\,opt}'$ der zweite Wert $c_{off\,opt}'$ des transformierten zweiten Lastreflexionsfaktors $c_{off}'$. $c_{on\,opt}'$ ist der dritte Wert $c_{on\,opt}'$ des transformierten dritten Lastreflexionsfaktors $c_{on}'$. $c_{on\,opt}'*$ ist das konjugiert Komplexe $c_{on\,opt}'*$ des dritten Wertes $c_{on\,opt}'$ des transformierten dritten Lastreflexionsfaktors $c_{on}'$.

In Fig. 14 ist ein dritter Kreis $K_3$ gezeigt. Der dritte Kreis $K_3$ wird als Menge aller Punkte im dritten Abstand $P_3$ von dem dritten Lastreflexionsfaktor $c_{on}$ bestimmt durch

$$P(z, c_{on}) = \operatorname{arctanh}\left(\frac{\left|z - c_{on}\right|}{\left|1 - z*c_{on}\right|}\right) \equiv P_3 \tag{33}$$

Dabei ist z ein Punkt auf dem dritten Kreis $K_3$. $z^*$ ist das komplex Konjugierte $z^*$ des Punktes z auf dem dritten Kreis $K_3$. $c_{on}$ ist der dritte Lastreflexionsfaktor $c_{on}$. $c_{on}^*$ ist das komplex Konjugierte $c_{on}^*$ des dritten Lastreflexionsfaktors $c_{on}$ und $P_3$ ist der dritte Abstand $P_3$.

In Fig. 14 sind zwei vierte Werte $c_{off,1}$, $c_{off,2}$ als Schnittpunkte zwischen dem dritten Kreis $K_3$ und dem veränderten ersten Kreis $K_1'$ dargestellt. Zumindest ein vierter Wert $c_{off,1}$, $c_{off,2}$ des zweiten Lastreflexionsfaktors $c_{off}$ wird bestimmt. Dabei ist für den zumindest einen vierten Wert $c_{off,1}$, $c_{off,2}$ eine Quadratsumme von Abständen zwischen dem vierten Wert $c_{off,1}$, $c_{off,2}$ und dem dritten Kreis $K_3$ sowie zwischen dem vierten Wert $c_{off,1}$, $c_{off,2}$ und dem veränderten ersten Kreis $K_1'$ minimiert. Im Ausführungsbeispiel der Fig. 14 sind die Abstände in den Schnittpunkten minimal (null).

Ein fünfter Wertes $b_{off}'_1$, $b_{off}'_2$ des transformierten ersten Quellreflexionsfaktors $b_{off}'$ wird zu jedem vierten Wert $c_{off,1}$, $c_{off,2}$ des zweiten Lastreflexionsfaktors $c_{off}$ bestimmt. Dabei wird eine vierte Impedanz ermittelt, wobei die vierte Impedanz dem vierten Wert $c_{off,1}$, $c_{off,2}$ des zweiten Lastreflexionsfaktors $c_{off}$ zugehörig ist. Es wird eine fünfte Impedanz ermittelt, so dass eine zweite Parallelschaltung der fünften Impedanz mit der Lastimpedanz gleich der vierten Impedanz ist und wobei der fünfte Wert $b_{off}'_1$, $b_{off}'_2$ des transformierten ersten Quellreflexionsfaktors $b_{off}'$ der fünften Impedanz zugehörig ist.

Das erste Anpassnetzwerk $M_1$ des Ausführungsbeispiel in Fig. 12 wird nachfolgend anhand des ersten Lastreflexionsfaktors $a_{on}$ und des ersten Wertes $a_{on}'_{opt}$ des transformierten ersten Lastreflexionsfaktors $a_{on}'$ und des ersten Quellreflexionsfaktors $b_{off}$ und des fünften Wertes $b_{off}'_1$, $b_{off}'_2$ des transformierten ersten Quellreflexionsfaktors $b_{off}'$ bestimmt.

Das zweite Anpassnetzwerk $M_2$ des Ausführungsbeispiel in Fig. 12 wird nachfolgend anhand des zweiten Wertes $c_{off}'_{opt}$ des transformierten zweiten Lastreflexionsfaktors $c_{off}'$ und des dritten Wertes $c_{on}'_{opt}$ des transformierten dritten Lastreflexionsfaktors $c_{on}'$ und des dritten Lastreflexionsfaktors $c_{on}$ und des vierten Wertes $c_{off,1}$, $c_{off,2}$ des zweiten Lastreflexionsfaktors $c_{off}$ bestimmt.

Eingabegrößen des Verfahrens in dem Ausführungsbeispiel der Fig. 12 sind zunächst messbare Größen: Der erste Quellreflexionsfaktor $b_{off}$, der Last-Eingangsreflexionsfaktor Γ sowie, typischerweise in Load-Pull-Messungen ermittelt, der die Quell- bzw. Schaltungseigenschaften im zweiten Betriebszustand on optimierende erste Wert $a_{on}'_{opt}$ des transformierten ersten Lastreflexionsfaktors $a_{on}'$, der die Quell- bzw. Schaltungseigenschaften im ersten Betriebszustand off optimierende zweite Wert $c_{off}'_{opt}$ des transformierten zweiten Lastreflexionsfaktors $c_{off}'$ und der die Quell- bzw. Schaltungseigenschaften im zweiten Betriebszustand on optimierende dritte Wert $c_{on}'_{opt}$ des transformierten dritten Lastreflexionsfaktors $c_{on}'$.

Eine weitere Eingabegröße des Verfahrens in dem Ausführungsbeispiel der Fig. 12 sind die im zweiten Betriebszustand on der Schaltung unabhängig ermittelten Größen erster Lastreflexionsfaktor $a_{on}$ und dritter Lastreflexionsfaktor $c_{on}$.

Ausgehend von den genannten Eingabegrößen werden unter Anwendung des Verfahrens die - von pathologischen Fällen abgesehen, maximal zwei - Paare von mathematischen Transformationseigenschaften ermittett, welche mit den Eingabegrößen verträglich sind.

Die ermittelten mathematischen Transformationseigenschaften erlauben weitgehend verlustlose, nicht-reziproke - Anpassnetzwerke anzugeben, welche die ermittelten mathematischen Transformationseigenschaften aufweisen. Ein Beispiel für die Konstruktion eines reziproken, weitgehend verlustlosen Anpassnetzwerkes, ausgehend von bekannten Transformationseigenschaften, besteht in einem Ansatz für das Anpassnetzwerk in Form einer hinreichend flexiblen Schaltungstopologie - bspw. einer Anzahl in Serie geschalteter, in ihren jeweiligen Leiterbahnbreiten und -Längen unbestimmten Mikrostreifenleitungen - bei anschließender numerischer Optimierung der Leiterbahnbreiten und -Längen.

Die zum Ausführungsbeispiel der Fig. 12 ermittelten mathematischen Transformationseigenschaften erlauben weiter, aus den der Messung zugänglichen Quell-Reflexionsfaktoren $b_{on}$, $d_{on}$ des ersten und des zweiten Quellenelements $Q_1$, $Q_2$ in dem zweiten Betriebszustand on der Schaltung transformierte Quell-reflexionsfaktoren $b_{on}'$, $d_{on}'$ zu ermitteln. Zusammen mit dem Last-Eingangsreflexionsfaktor Γ sind somit alle Abschlussbedingungen für das T-Stück T bekannt.

Es stehen Verfahren zu Gebote - bspw. die Schaltungssimulation mit S-Parameter-Ports - aus den Abschlussbedingungen eines, als ideal angenommenen oder in Mikrostreifentechnologie ausgeführten T-Stückes T dessen Transformationseigenschaften bspw. in Form einer Streumatrix zu bestimmen.

Die Kenntnis der Streumatrix erlaubt es ferner, ein erstes, aus dem ersten Ausgang $A_1$, und ein zweites, aus dem dritten Ausgang $A_3$ austretendes hinlaufendes Zeitbereichs-Sinussignal am T-Stück T zur Überlagerung zu bringen und ein erstes, aus dem ersten Eingang $E_1$ und ein zweites, aus dem zweiten Eingang $E_2$ austretendes rücklaufendes Zeitbereichs-Sinussignal anzugeben. Dabei weist das erste und das zweite hinlaufende Zeitbereichs-Sinussignal dieselbe Frequenz bei gegebener relativer Phasenlage und einem gegebenen Amplitudenverhältnis zwischen dem ersten und dem zweiten hinlaufenden Zeitbereichs-Sinussignal auf. Hin- und rücklaufende Zeitbereichs-Sinussignale wiederum übersetzen sich in neue, sogenannte effektive Lastreflexionsfaktoren $\tilde{a}_{on}$, $\tilde{c}_{on}$, welche mit den jeweiligen eingangs unabhängig ermittelten Lastreflexionsfaktoren $a_{on}$, $c_{on}$ übereinstimmen oder von diesen abweichen können.

Es kann für jede gegebene relative Phasenlage und jedes gegebene Amplitudenverhältnis zwischen dem ersten und dem zweiten hinlaufenden Zeitbereichs-Sinussignal der Überlagerungsverlust beider Signale am T-Stück T bestimmt werden. Der Überlagerungsverlust ist die Differenz aus der an die Last abgegebenen Leistung und der Summe der Leistungen der hinlaufenden Zeitbereichs-Sinussignale. Es lässt sich hiernach für jedes gegebene Amplitudenverhältnis eine den Überlagerungsverlust minimierende ausgezeichnete relative Phasenlage zwischen dem ersten und dem zweiten hinlaufenden Zeitbereichs-Sinussignal nebst der zu dieser ausgezeichneten relativen Phasenlage gehörigen effektiven Lastreflexionsfaktoren bestimmen.

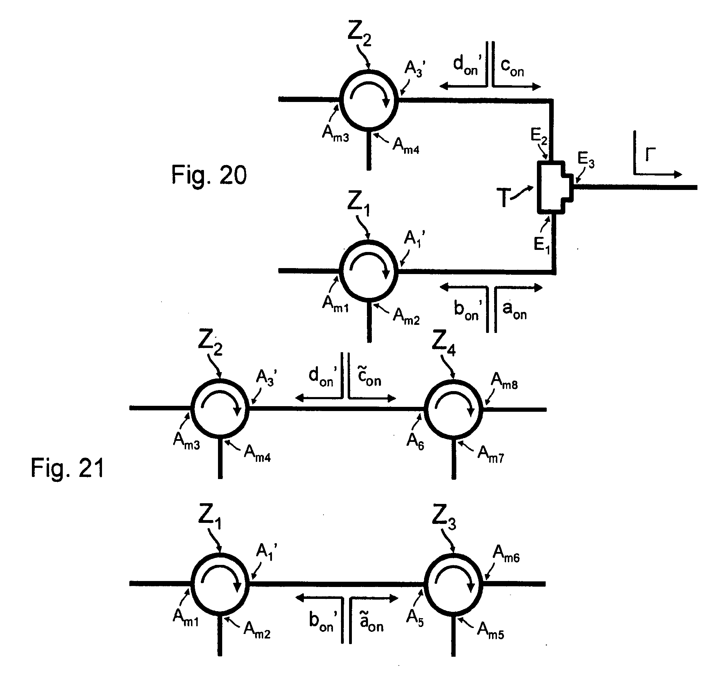

Nachfolgend wird anhand der Fig. 20 und der Fig. 21 ein Beispiel für eine Ermittlung der ausgezeichneten relativen Phasenlage und der zugehörigen effektiven Lastreflexionsfaktoren beschrieben, ausgehend von den Abschlussbedingungen des T-Stückes und den Amplituden sowie der relativen Phasenlage der hinlaufenden Zeitbereichs-Sinussignale. Das Beispiel macht Gebrauch von einem Simulationsprogramm. Mit dem Simulationsprogramm steht der Hochfrequenz-Schaltungstechnik ein verbreitetes Werkzeug zur Verfügung. Unter anderem bietet das Simulationsprogramm als vordefiniertes Bauelement einen Zirkulator, bei dem an den drei Eingängen unterschiedliche Bezugsimpedanzen gewählt werden können, nachfolgend Dreitor-Zirkulator genannt. Der Dreitor-Zirkulator des Simulationsprogramms ist damit ein ideales impedanztransformierendes Bauelement.

Fig. 20 zeigt eine erste Ersatzschaltung für das terminierte T-Stück T, welche nachfolgend Verwendung findet bei der Bestimmung der effektive Lastreflexionsfaktoren $\tilde{a}_{on}, \tilde{c}_{on}$. Die erste Ersatzschaltung enthält einen ersten Dreitor-Zirkulator $Z_1$ und einen zweiten Dreitor-Zirkulator $Z_2$.

Der erste Dreitor-Zirkulator $Z_1$ weist einen ersten Zirkulatorport $A_1$', einen zweiten Zirkulatorport $A_{m1}$ und einen dritten Zirkulatorport $A_{m2}$ auf. Der erste Dreitor-Zirkulator $Z_1$ zeigt in den ersten Zirkulatorport $A_1$' hinein den ersten transformierten Quellreflexionsfaktor $b_{on}$*

Der zweite Dreitor-Zirkulator $Z_2$ weist einen vierten Zirkulatorport $A_3$', einen fünften Zirkulatorport $A_{m3}$ und einen sechsten Zirkulatorport $A_{m4}$ auf. Der zweite Dreitor-Zirkulator $Z_2$ zeigt in den vierten Zirkulatorport $A_3$' hinein den dritten transformierten Quellreflexionsfaktor $d_{on}$'.

Die erste Ersatzschaltung enthält ein T-Stück T. Das T-Stück T weist einen ersten Eingang $E_1$, einen zweiten Eingang $E_2$ und einen dritten Eingang $E_3$ auf. Der erste Eingang $E_1$ ist mit dem ersten Zirkulatorport $A_1$' verbunden und hiernach mit dem ersten transformierten Quellreflexionsfaktor $b_{on}$' abgeschlossen. Der zweite Eingang $E_1$ ist mit dem vierten Zirkulatorport $A_3$' verbunden und hiernach mit dem dritten transformierten Quellreflexionsfaktor $d_{on}$' abgeschlossen. Der dritte Eingang $E_3$ ist mit dem Lastreflexionsfaktor r abgeschlossen. Das T-Stück T kann beispielsweise als Leitungsknoten oder als Mikrostreifen-T-Stück ausgeführt sein.

Technisch wird der Abschluss des ersten Eingangs $E_1$ mit dem ersten transformierten Quellreflexionsfaktor $b_{on}$' durch Wahl einer dem ersten transformierten Quellreflexionsfaktor $b_{on}$' zugehörigen Impedanz als Bezugsimpedanz für den ersten Dreitor-Zirkulator $Z_1$ an dem ersten Zirkulatorport $A_1$' realisiert. Für die Bezugsimpedanzen für den ersten Dreitor-Zirkulator $Z_1$ an dem zweiten Zirkulatorport $A_{m1}$ und an dem dritten Zirkulatorport $A_{m2}$ wird im Ausführungsbeispiel der Fig. 20 jeweils ein Wert von 50 $\Omega$ gewählt.

Technisch wird der Abschluss des zweiten Eingangs $E_2$ mit dem dritten transformierten Quellreflexionsfaktor $d_{on}$' durch Wahl einer dem dritten transformierten Quellreflexionsfaktor $d_{on}$' zugehörigen Impedanz als Bezugsimpedanz für den zweiten Dreitor-Zirkulator $Z_1$ an dem vierten Zirkulatorport $A_3$' realisiert. Für die Bezugsimpedanzen für den zweiten Dreitor-Zirkulator $Z_1$ an dem fünften Zirkulatorport $A_{m3}$ und an dem sechsten Zirkulatorport $A_{m4}$ wird im Ausführungsbeispiel der Fig. 20 jeweils ein Wert von 50 $\Omega$ gewählt.

Es wird an dem zweiten Zirkulatorport $A_{m1}$ ein erstes Zeitbereichs-Sinussignal einer gegebenen Frequenz, Phase und Amplitude angelegt, sowie an dem fünften Zirkulatorport $A_{m3}$ ein zweites Zeitbereichs-Sinussignal der gegebenen Frequenz, mit einer gegebenen relativen Phase bezüglich der Phase des ersten Zeitbereichs-Sinussignales und einer gegebenen relativen Amplitude bezüglich der Amplitude des ersten Zeitbereichs-Sinussignales.

Es werden in der Simulation an dem dritten Zirkulatorport $A_{m2}$ ein erster rücklaufender Strom gemessen und der dritte Zirkulatorport $A_{m2}$ reflexionsfrei abgeschlossen. Es werden in der Simulation an dem ersten Zirkulatorport $A_1$' ein erster effektiver Strom und eine erste effektive Spannung abgegriffen.

Es werden in der Simulation an dem sechsten Zirkulatorport $A_{m4}$ ein zweiter rücklaufender Strom gemessen und der sechste Zirkulatorport $A_{m4}$ reflexionsfrei abgeschlossen. Es werden in der Simulation an dem vierten Zirkulatorport $A_3$' ein zweiter effektiver Strom und eine zweite effektive Spannung abgegriffen.

Ein, von der relativen Phase und der relativen Amplitude erster effektiver Lastreflexionsfaktor $\tilde{a}_{on}$ sowie ein von der relativen Phase und der relativen Amplitude zweiter effektiver Lastreflexionsfaktor $\tilde{c}_{on}$, welcher erste effektive Lastreflexionsfaktor $\tilde{a}_{on}$ in den ersten Eingang $E_1$ und zweite effektive Lastreflexionsfaktor $\tilde{c}_{on}$ in den zweiten Eingang $E_2$ hinein wirken, werden unter Zuhilfenahme der ersten Ersatzschaltung nach Fig. 20 und einer zweiten Ersatzschaltung nach Fig. 21 bestimmt.

Fig. 21 zeigt eine zweite Ersatzschaltung für das terminierte T-Stück, welche nachfolgend Verwendung findet bei der Bestimmung der effektive Lastreflexionsfaktoren $\tilde{a}_{on}, \tilde{c}_{on}$. Die zweite Ersatzschaltung enthält einen dritten Dreitor-Zirkulator $Z_3$, einen vierten Dreitor-Zirkulator $Z_4$, einen fünften Dreitor-Zirkulator $Z_5$ und einen sechsten Dreitor-Zirkulator $Z_6$.

Der dritte Dreitor-Zirkulator $Z_3$ weist einen siebten Zirkulatorport $A_1''$, einen achten Zirkulatorport $A_{m1}'$ und einen neunten Zirkulatorport $A_{m2}'$ auf. Der dritte Dreitor-Zirkulator $Z_3$ zeigt in den siebten Zirkulatorport $A_1''$ hinein den ersten transformierten Quellreflexionsfaktor $b_{on}'$.

Der vierte Dreitor-Zirkulator $Z_4$ weist einen zehnten Zirkulatorport $A_3''$, einen elften Zirkulatorport $A_{m3}'$ und einen zwölften Zirkulatorport $A_{m4}'$ auf. Der vierte Dreitor-Zirkulator $Z_4$ zeigt in den zehnten Zirkulatorport $A_3''$ hinein den dritten transformierten Quellreflexionsfaktor $d_{on}'$.

Der fünfte Dreitor-Zirkulator $Z_5$ weist einen dreizehnten Zirkulatorport $A_5$, einen vierzehnten Zirkulatorport $A_{m5}$ und einen fünfzehnten Zirkulatorport $A_{m6}$ auf. Der fünfte Dreitor-Zirkulator $Z_5$ zeigt in den dreizehnten Zirkulatorport $A_5$ hinein einen ersten veränderlichen effektiven Lastreflexionsfaktor $\tilde{a}_{on}'$.

Der sechste Dreitor-Zirkulator $Z_6$ weist einen sechzehnten Zirkulatorport $A_6$, einen siebzehnten Zirkulatorport $A_{m7}$ und einen achtzehnten Zirkulatorport $A_{m8}$ auf. Der sechste Dreitor-Zirkulator $Z_6$ zeigt in den sechzehnten Zirkulatorport $A_6$ hinein einen zweiten veränderlichen effektiven Lastreflexionsfaktor $\tilde{c}_{on}'$.

Technisch wird die Eigenschaft des dritten Dreitor-Zirkulators $Z_3$, in den siebten Zirkulatorport $A_1''$ hinein den ersten transformierten Quellreflexionsfaktor $b_{on}'$ aufzuweisen, durch Wahl einer dem ersten transformierten Quellreflexionsfaktor $b_{on}'$ zugehörigen Impedanz als Bezugsimpedanz für den dritten Dreitor-Zirkulator $Z_3$ an dem siebten Zirkulatorport $A_1''$ realisiert. Für die Bezugsimpedanzen für den dritten Dreitor-Zirkulator $Z_3$ an dem achten Zirkulatorport $A_{m1}'$ und an dem neunten Zirkulatorport $A_{m2}'$ wird in dem Ausführungsbeispiel der Fig. 21 jeweils ein Wert von 50 $\Omega$ gewählt.

Technisch wird die Eigenschaft des vierten Dreitor-Zirkulators $Z_4$, in den zehnten Zirkulatorport $A_3''$ hinein den dritten transformierten Quellreflexionsfaktor $d_{on}'$ aufzuweisen, durch Wahl einer dem dritten transformierten Quellreflexionsfaktor $d_{on}'$ zugehörigen Impedanz als Bezugsimpedanz für den vierten Dreitor-Zirkulator $Z_4$ an dem zehnten Zirkulatorport $A_3''$ realisiert. Für die Bezugsimpedanzen für den vierten Dreitor-Zirkulator $Z_4$ an dem elften Zirkulatorport $A_{m3}'$ und an dem zwölften Zirkulatorport $A_{m4}'$ wird im Ausführungsbeispiel der Fig. 21 jeweils ein Wert von 50 $\Omega$ gewählt.

Für die Bezugsimpedanzen für den fünften Dreitor-Zirkulator $Z_5$ an dem vierzehnten Zirkulatorport $A_{m5}$ und an dem fünfzehnten Zirkulatorport $A_{m6}$ wird jeweils ein Wert von 50 $\Omega$ gewählt. Für die Bezugsimpedanzen für den sechsten Dreitor-Zirkulator $Z_6$ an dem siebzehnten Zirkulatorport $A_{m7}$ und an dem achtzehnten Zirkulatorport $A_{m8}$ wird jeweils ein Wert von 50 $\Omega$ gewählt.

Es wird an dem achten Zirkulatorport $Am_1'$ ein dem ersten Zeitbereichs-Sinussignal gleichendes, sowie an dem elften Zirkulatorport $A_{m3}'$ ein dem zweiten Zeitbereichs-Sinussignal gleichendes Signal angelegt.

Es werden in der Simulation an dem neunten Zirkulatorport $A_{m2}'$ ein dritter rücklaufender Strom gemessen und der neunten Zirkulatorport $A_{m2}'$ reflexionsfrei abgeschlossen. Es werden in der Simulation an dem siebten Zirkulatorport $A_1''$ ein dritter effektiver Strom und eine dritte effektive Spannung abgegriffen.

Es werden in der Simulation an dem zwölften Zirkulatorport $A_{m4}'$ ein vierter rücklaufender Strom gemessen und der sechste Zirkulatorport $A_{m4}$ reflexionsfrei abgeschlossen. Es werden in der Simulation an dem zehnten Zirkulatorport $A_3''$ ein vierter effektiver Strom und eine vierte effektive Spannung abgegriffen.

Es werden der vierzehnte Zirkulatorport $A_{m5}$, der fünfzehnte Zirkulatorport $A_{m6}$, der siebzehnte Zirkulatorport $A_{m7}$ und der achtzehnte Zirkulatorport $A_{m8}$ reflexionsfrei abgeschlossen.

Es werden in einer Simulation der ersten Ersatzschaltung Werte für den ersten hinlaufenden Strom, den zweiten hinlaufenden Strom, die erste effektive Spannung, die zweite effektive Spannung, den ersten effektiven Strom und den zweiten effektiven Strom gewonnen.

Es werden in Simulationen der zweiten Ersatzschaltung der erste veränderliche effektive Lastreflexionsfaktor $\tilde{a}_{on}'$ und der zweite veränderliche effektive Lastreflexionsfaktor $\tilde{c}_{on}'$ dergestalt optimiert, dass

- der dritte rücklaufende Strom in Größe und Orientierung gleich dem ersten rücklaufenden Strom,

- der vierte rücklaufende Strom in Größe und Orientierung gleich dem zweiten rücklaufenden Strom,

- der dritte effektive Strom in Größe und Orientierung gleich dem ersten effektiven Strom,

- der vierte effektiven Strom in Größe und Orientierung gleich dem zweiten effektiven Strom,

- die dritte effektive Spannung in der Größe gleich der ersten effektiven Spannung, und

- die vierte effektive Spannung in der Größe gleich der zweiten effektiven Spannung

sind.

Der mittels der Optimierung gefundene Wert für den ersten veränderlichen effektive Lastreflexionsfaktor $\tilde{a}_{on}'$ stimmt dann mit dem gesuchten Wert für den ersten effektiven Lastreflexionsfaktor $\tilde{a}_{on}$, der in der Optimierung gefundene Wert für den zweiten veränderlichen effektive Lastreflexionsfaktor $\tilde{c}_{on}'$ mit dem gesuchten Wert für den ersten effektiven

Lastreflexionsfaktor $\tilde{c}_{on}$ überein.

Aus den Abschlussbedingungen an den Eingängen $E_1$, $E_2$, $E_3$ des T-Stückes T und den Eingangssignalen an allen drei Eingängen $E_1$, $E_2$, $E_3$ des T-Stückes T - von denen im Ausführungsbeispiel der Figuren 20 und 21 das auf den dritten Eingang $E_3$ des T-Stückes T zulaufende Eingangssignal die Größe Null aufweist - werden die effektiven, in den ersten Eingang $E_1$ und den zweiten Eingang $E_2$ hinein wirkenden Reflexionsfaktoren bestimmt.

Durch den Vergleich der Summe der Leistungen des ersten Zeitbereichs-Sinussignals und des zweiten Zeitbereichs-Sinussignals mit der aus dem dritten Eingang $E_3$ des T-Stückes T heraus abgegebenen Leistung steht eine Methode zur Bestimmung des Summationsverlustes in dem T-Stück T in Abhängigkeit insbesondere von der relativen Phase zur Verfügung.

In einer möglichen Anwendung ist man bestrebt, den Summationsverlust zu minimieren. Dies gelingt durch Wiederholung des Verfahrens für unterschiedliche Werte der relativen Phase, um so zu einer ausgezeichneten relativen Phasenlage zu gelangen, durch die der Summationsverlust minimiert wird.

Ist ein Amplitudenverhältnis beispielsweise durch ein Verhältnis der Kompressionspunkte beider Quellelemente gegeben, so lehrt das Verfahren des Ausführungsbeispiels aus einem ersten Paar unabhängig ermittelter Lastreflexionsfaktoren ein neues Paar Lastreflexionsfaktoren in Form des der ausgezeichneten relativen Phasenlage zugehörigen Paares effektiver Lastreflexionsfaktoren zu bestimmen, erlaubt also eine Verbesserung eines ersten Paares von Lastreflexionsfaktoren durch ein abgeleitetes zweites Paar von Lastreflexionsfaktoren.

Neben der Methode schieren Ausprobierens ist dies bspw. die Hintereinanderausführung einer großen Anzahl von Iterationen. Für eine derartige fortgesetzte Iteration legt das große Iterationstheorem die Existenz eines Fixpunktpaares, dessen beide Paarpunkte innerhalb der abgeschlossenen Einheitskreisscheibe in der Reflexionsfaktorebene liegen, nahe. Die Iteration ist auf ein Paar von Lastreflexionsfaktoren als Anfangswert angewiesen. Nach dem großen Iterationstheorem konvergiert die Iteration mit jedem Paar von Lastreflexionsfaktoren als Startpunkt auf das Fixpunktpaar hin. Das Entwurfsverfahren für Doherty-Verstärker als Spezialfall der Lastmodulationsverstärker stellt jedoch (zumindest für reelle Last-Eingangsreflexionsfaktoren) ein naheliegendes Paar von Lastreflexionsfaktoren als Anfangswert zur Verfügung. Als Anfangswert besteht das naheliegende Paar von Lastreflexionsfaktoren in beiden Einträgen aus dem der doppelten Lastimpedanz zugehörigen Reflexionsfaktor.

Insbesondere wird daher in dem beschriebenen Verfahren eine Methode gelehrt, aus messbaren Eingabegrößen - dem ersten Quellreflexionsfaktor $b_{off}$, im ersten Betriebszustand off, den Quellreflexionsfaktoren $b_{on}$, $d_{on}$ des ersten Quellenelements $Q_1$ und des zweiten Quellenelements $Q_2$ in dem zweiten Betriebszustand on, dem Last-Eingangsreflexionsfaktor $\Gamma$ sowie dem ersten Wert $a_{on}'_{opt}$, dem zweiten Wert $c_{off}'_{opt}$ und dem dritten Wert $c_{on}'_{opt}$ - zu einer geschlossenen Lösung für die ausgezeichnete Phasenlage, die minimalen Summationsverluste, und die damit verbundenen effektiven Lastreflexionsfaktoren zu gelangen, ebenso wie zu dem zugehörigen Paar zweier mathematisch zulässiger Transformationswirkungen des ersten und des zweiten Anpassnetzwerkes $M_1$, $M_2$.

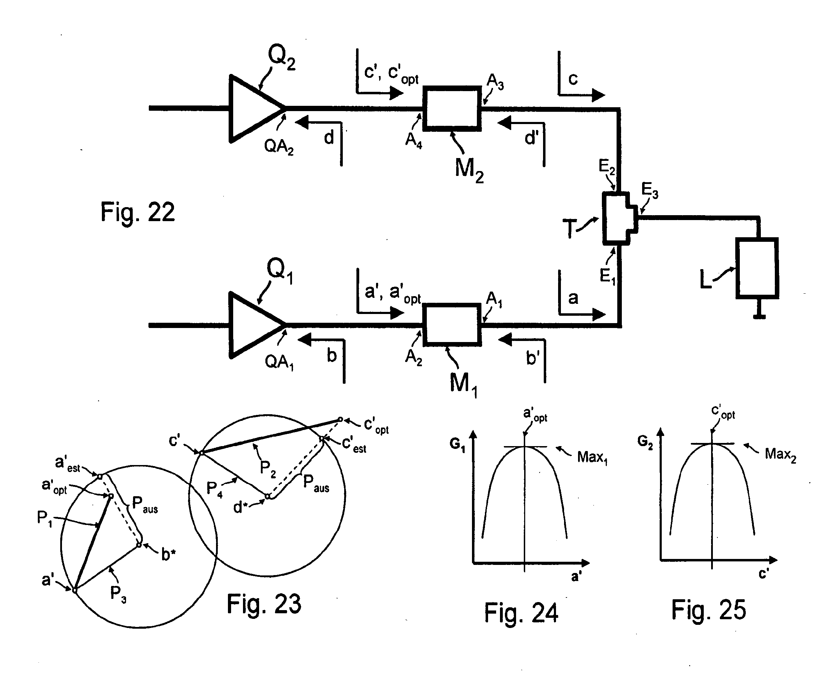

In Fig. 22 ist ein weiteres Ausführungsbeispiel einer Schaltung dargestellt, die ausgelegt wird. Die Schaltung weist ein erstes Quellenelement $Q_1$ mit einem ersten Quellenausgang $QA_1$ und mit einem ersten Quellreflexionsfaktor b auf. Die Schaltung weist ein zweites Quellenelement $Q_2$ mit einem zweiten Quellenausgang $QA_2$ und mit einem zweiten Quellreflexionsfaktor d auf. Die Schaltung weist zudem eine Last L auf.

Die Schaltung weist ein T-Stück T mit einem ersten Eingang $E_1$, einem zweiten Eingang $E_2$ und einem Ausgang $E_3$ auf. Das T-Stück T weist in den ersten Eingang $E_1$ hinein einen ersten Lastreflexionsfaktor a auf, wie in Fig. 22 durch einen Pfeil schematisch dargestellt ist. Das T-Stück T weist in den zweiten Eingang $E_2$ hinein einen zweiten Lastreflexionsfaktor c auf, wie ebenfalls in Fig. 22 durch einen Pfeil schematisch dargestellt ist. Im Ausführungsbeispiel der Fig. 22 ist der Ausgang $E_3$ des T-Stücks T mit der Last L verbunden.

Die Schaltung weist ein erstes Anpassnetzwerk $M_1$ mit einem ersten Anschluss $A_1$ und einen zweiten Anschluss $A_2$ auf. Der zweite Anschluss $A_2$ ist mit dem ersten Quellenausgang $QA_1$ verbunden. Der erste Anschluss $A_1$ ist mit dem ersten Eingang $E_1$ des T-Stücks T verbunden. Durch das erste Anpassnetzwerk $M_1$ wird in den zweiten Anschluss $A_2$ hinein ein transformierter erster Lastreflexionsfaktor a' und in den ersten Anschluss $A_1$ hinein ein transformierter erster Quellreflexionsfaktor b' bewirkt. Der transformierte erste Lastreflexionsfaktor a' und der transformierte erste Quellreflexionsfaktor b' sind in der Fig. 22 durch Pfeile schematisch dargestellt.

Die Schaltung weist ein zweites Anpassnetzwerk $M_2$ mit einem dritten Anschluss $A_3$ und einem vierten Anschluss $A_4$ auf. Der vierte Anschluss $A_4$ ist mit dem zweiten Quellenausgang $QA_2$ verbunden. Der dritte Anschluss $A_3$ ist mit dem zweiten Eingang $E_2$ des T-Stücks T verbunden. Durch das zweite Anpassnetzwerk $M_2$ wird in den vierten Anschluss $A_4$ hinein ein transformierter zweiter Lastreflexionsfaktor c' bewirkt. Weiterhin wird durch das zweite Anpassnetzwerk $M_2$ in den dritten Anschluss $A_3$ hinein ein transformierter zweiter Quellreflexionsfaktor d' bewirkt. Der transformierte zweite Lastreflexionsfaktor c' und der transformierte zweite Quellreflexionsfaktor d' sind in der Fig. 22 durch Pfeile schematisch dargestellt.

In Fig. 22 ist ein erster Wert $a'_{opt}$ des transformierten ersten Lastreflexionsfaktors a' und ein zweiter Wert $c'_{opt}$ des transformierten zweiten Lastreflexionsfaktors c' mittels Pfeile schematisch dargestellt. In einem Verfahren wird der erste Wert $a'_{opt}$ des transformierten ersten Lastreflexionsfaktors a' ermittelt. Dabei weist das erste Quellenelement $Q_1$

für den am ersten Quellenausgang $QA_1$ wirkenden ersten Wert $a'_{opt}$ des transformierten ersten Lastreflexionsfaktors $a'$ ein erstes Optimum $Max_1$ einer ersten Kenngröße $G_1$ auf, wie dies beispielhaft in Fig. 24 schematisch dargestellt ist. Der erste Wert $a'_{opt}$ des transformierten ersten Lastreflexionsfaktors $a'$ weist dabei vom komplex Konjugierten des ersten Quellreflexionsfaktors b ab.

In einem Verfahren wird der zweite Wert $c'_{opt}$ des transformierten zweiten Lastreflexionsfaktors $c'$ ermittelt. Dabei weist das zweite Quellenelement $Q_2$ für den am zweiten Quellenausgang $QA_2$ wirkenden zweiten Wert $c'_{opt}$ des transformierten zweiten Lastreflexionsfaktors $c'$ ein zweites Optimum $Max_2$ einer zweiten Kenngröße $G_2$ auf, wie dies beispielhaft in Fig. 25 schematisch dargestellt ist. Dabei weicht der zweite Wert $c'_{opt}$ des transformierten zweiten Last-reflexionsfaktors $c'$ vom komplex Konjugierten des zweiten Quellreflexionsfaktors d ab.

Fig. 23 zeigt einen Abstandswert $P_{aus}$ und einen dritten Wert $a'_{est}$ des transformierten ersten Lastreflexions-faktors $a'$ und einen vierten Wert $c'_{est}$ des transformierten zweiten Lastreflexionsfaktors $c'$. In einem im Folgenden erläuterten Verfahren werden diese Werte ermittelt. Dabei wird der Abstandswert $P_{aus}$ und der dritte Wert $a'_{est}$ des transformierten ersten Lastreflexionsfaktors $a'$ und der vierte Wert $c'_{est}$ des transformierten zweiten Lastreflexionsfaktors $c'$ bestimmt, indem ein erster Abstand $P_1$ und ein zweiter Abstand $P_2$ und ein dritter Abstand $P_3$ und ein vierte Abstand $P_4$ bestimmt werden. Die Abstände $P_1$, $P_2$, $P_3$ und $P_4$ sind in Fig. 23 schematisch dargestellt.

Ein erster Abstand $P_1$ wird zwischen dem ersten Wert $a'_{opt}$ und dem transformierten ersten Lastreflexionsfaktor $a'$ definiert durch

$$P_1 = \operatorname{arctanh}\left(\frac{|a'_{opt} - a'|}{|1 - a'^* a'_{opt}|}\right) \tag{34}$$

Dabei ist $P_1$ der erste Abstand $P_1$. $a'$ der transformierte erste Lastreflexionsfaktor $a'$. $a'^*$ ist das komplex Konjugierte $a'^*$ des transformierten ersten Lastreflexionsfaktors $a'$. $a'_{opt}$ ist der erste Wert $a'_{opt}$.

Ein zweiter Abstand $P_2$ wird zwischen dem zweiten Wert $c'_{opt}$ und dem transformierten zweiten Lastreflexionsfaktor $c'$ definiert durch

$$P_2 = \operatorname{arctanh}\left(\frac{|c'_{opt} - c'|}{|1 - c'^* c'_{opt}|}\right) \tag{35}$$

Dabei ist $P_2$ der zweite Abstand $P_2$. $c'$ ist der transformierte zweite Lastreflexionsfaktor $c'$. $c'^*$ ist das komplex Konjugierte $c'^*$ des transformierten zweiten Lastreflexionsfaktor $c'$. $c'_{opt}$ ist der zweite Wert $c'_{opt}$.

Ein dritter Abstand $P_3$ wird zwischen dem transformierten ersten Lastreflexionsfaktor $a'$ und dem komplex Konjugierten $b^*$ des ersten Quellreflexionsfaktors b definiert durch

$$P_3 = \operatorname{arctanh}\left(\frac{|a' - b^*|}{|1 - ba'|}\right) \tag{36}$$

Dabei ist $P_3$ der dritte Abstand $P_3$. b ist der erste Quellreflexionsfaktor b. $b^*$ ist das komplex Konjugierte $b^*$ des ersten Quellreflexionsfaktors b. $a'$ ist der transformierte erste Lastreflexionsfaktor $a'$.

Ein vierter Abstand $P_4$ wird zwischen dem transformierten zweiten Lastreflexionsfaktor $c'$ und dem komplex Konjugierten $d^*$ des zweiten Quellreflexionsfaktors d definiert durch

$$P_4 = \operatorname{arctanh}\left(\frac{|c' - d^*|}{|1 - dc'|}\right) \tag{37}$$

Dabei ist $P_4$ der vierte Abstand $P_4$. d ist der zweite Quellreflexionsfaktor d. $d^*$ ist das komplex Konjugierte $d^*$ des zweiten Quellreflexionsfaktors d. $c'$ ist der transformierte zweite Lastreflexionsfaktor $c'$.

Der Abstandswert $P_{aus}$ und der dritte Wert $a'_{est}$ und der vierte Wert $c'_{est}$ werden bestimmt, indem ein Minimum des geometrischen Mittels aus dem ersten Abstand $P_1$ und dem zweiten Abstand $P_2$ bestimmt wird unter der Randbedingung, dass der dritte Abstand $P_3$ gleich dem vierten Abstand $P_4$ und von Null verschieden ist. Das Minimum des geometrischen Mittels wird bestimmt, indem der transformierte erste Lastreflexionsfaktor a' und der transformierte zweite Lastreflexionsfaktor c' variiert werden und das komplex Konjugierte b* des ersten Quellreflexionsfaktors b und das komplex Konjugierte d* des zweiten Quellreflexionsfaktors d und der erste Wert $a'_{opt}$ und der zweite Wert $c'_{opt}$, wie im Ausführungsbeispiel der Fig. 23 schematisch dargestellt, einen festen Wert aufweisen.

Der dem Minimum zugehörige Wert des dritten Abstands $P_3$ wird als Abstandswert $P_{aus}$ festgelegt. Der dem Minimum zugehörige Wert des transformierten ersten Lastreflexionsfaktors a' wird als dritter Wert $a'_{est}$ festgelegt. Der dem Minimum zugehörige Wert des transformierten zweiten Lastreflexionsfaktors c' wird als vierter Wert $c'_{est}$ festgelegt,

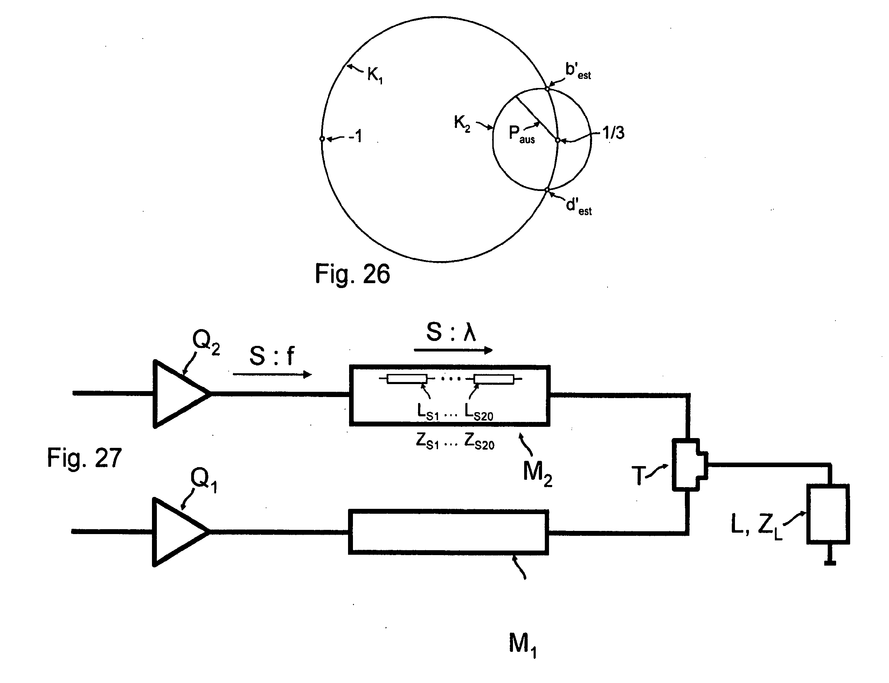

In Fig. 26 sind ein erste Kreis $K_1$ und ein zweiter Kreis $K_2$ und ein fünfter Wert $b'_{est}$ und ein sechster Wert $d'_{est}$ schematisch dargestellt. Der fünfte Wert $b'_{est}$ des transformierten ersten Quellreflexionsfaktors b' und der sechste Wert $d'_{est}$ des transformierten zweiten Quellreflexionsfaktors d' werden bestimmt, indem der erste Kreis $K_1$ mit reellem Mittelpunkt, der einen reellen Reflexionsfaktorwert von 1/3 und einen reellen Reflexionsfaktorwert von -1 schneidet bestimmt wird. Weiterhin wird der zweite Kreis $K_2$ als Menge aller Punkte y mit einem Abstand von dem reellen Reflexionsfaktorwert von 1/3 gleich dem Abstandswert $P_{aus}$ bestimmt durch

$$P(y, \frac{1}{3}) = \text{arctanh} \left( \frac{\left| y - \frac{1}{3} \right|}{\left| 1 - y \frac{1}{3} \right|} \right) \equiv P_{aus} \tag{38}$$

Dabei ist y ein Punkt y auf dem zweiten Kreis $K_2$. $P_{aus}$ ist der Abstandswert $P_{aus}$ des dritten Abstands $P_3$.

Der fünfte Wert $b'_{est}$ wird gleich dem Wert eines ersten Schnittpunkts zwischen dem ersten Kreis $K_1$ und dem zweiten Kreis $K_2$ und der sechste Wert $d'_{est}$ wird gleich dem Wert eines von dem ersten Schnittpunkt verschiedenen zweiten Schnittpunkts zwischen dem ersten Kreis $K_1$ und dem zweiten Kreis $K_2$ bestimmt.

Im Ausführungsbeispiel der Fig. 22 wird das erste Anpassnetzwerk $M_1$ anhand des ersten Quellreflexionsfaktors b und des fünften Wertes $b'_{est}$ des transformierten ersten Quellreflexionsfaktors b' und des ersten Lastreflexionsfaktors a und des dritten Wertes $a'_{est}$ des transformierten ersten Lastreflexionsfaktors a' bestimmt.

Weiterhin wird im Ausführungsbeispiel der Fig. 22 das zweite Anpassnetzwerk $M_2$ anhand des zweiten Quellreflexionsfaktors d und des sechsten Wertes $d'_{est}$ des transformierten zweiten Quellreflexionsfaktors d' und des zweiten Lastreflexionsfaktors c und des vierten Wertes $c'_{est}$ des transformierten zweiten Lastreflexionsfaktors c' bestimmt.

Im Ausführungsbeispiel der Fig. 22 treiben zwei Quellenelemente $Q_1$, $Q_2$ über je ein Anpassnetzwerk $M_1$, $M_2$ und die beiden Eingänge $E_1$, $E_2$ eines T-Stücks T eine gemeinsame Last L. Insofern ähnelt die Schaltungssituation des Ausführungsbeispiel der Fig. 22 einer zweimaligen Anwendung des Ausführungsbeispiels der Fig. 1 in einer Schaltung. Wie bereits bei dem Ausführungsbeispiel der Fig. 12, lässt sich jedoch auch im Ausführungsbeispiel der Fig. 22 die der Optimierung zugrundeliegenden Kenngröße $G_1$, $G_2$ nur als Eigenschaft der betrachteten Gesamtschaltung formulieren.

Während im Ausführungsbeispiel der Fig. 12 aus bspw. zwei festen Urbild- und einer festen Bildimpedanz ein optimaler, mit den mathematischen Randbedingungen an reziproke, verlustlose Anpassnetzwerke $M_1$, $M_2$ verträglicher Wert der zweiten Bildimpedanz bestimmt wird, wird im Ausführungsbeispiel der Fig. 22, ausgehend von gegebenen Quell- und Lastimpedanzen, sowie von einem bekannten optimalen Paar transformierter Lastimpedanzen ein Paar variierter transformierter Lastimpedanzen bestimmt, welches, unter Berücksichtigung der mathematischen Einschränkungen durch die Reziprozität und Verlustfreiheit der Anpassnetzwerke, das optimale Paar transformierter Lastimpedanzen bestmöglich annähert.

Aus Gründen verbesserter Klarheit ist der das Ausführungsbeispiel der Fig. 22 unter Zuhilfenahme einer als reell angenommenen Last L und unter, zumindest implizitem, Bezug auf zwei gleichartige, an den beiden Eingängen $E_1$, $E_2$ des T-Stückes T Signale gleicher Signalstärke und Frequenz hervorrufender Quellenelemente $Q_1$, $Q_2$ beschrieben. Selbstverständlich erstreckt sich die Anwendung der im Ausführungsbeispiel der Fig. 22 beschriebenen Ausführungsform des Verfahrens, mutandis mutatis auf einen wesentlich weiteren Bereich von Lastreflexionsfaktoren, Quellenelementen und Quellsignalen. Wiederum kann es sich bei den Lastimpedanzen um effektive, den Einfluss der Lastmodulation durch die jeweils andere Signalquelle berücksichtigende, Lastimpedanzen handeln.

Sämtlichen zu erläuterten Ausführungsbeispielen liegt ein zweistufiges Vorgehen zugrunde: Es werden zunächst wünschenswerte Paare von Bild- und Urbildimpedanzen bestimmt, und anschließend unmittelbar versucht, ein die Urbild- auf die Bildimpedanzen abbildendes Anpassnetzwerk zu synthetisieren. Das Verfahren nutzt für eine wichtige Klasse von Anpassnetzwerken (reziprok, verlustfrei) mathematische Zusammenhänge, um zunächst eine optimale, mit Abschlussbedingungen verträgliche Transformationswirkung des gesuchten Anpassnetzwerkes herzuleiten, um erst im Anschluss, bspw. aus dieser Transformationswirkung, ein geeignetes Anpassnetzwerk herzuleiten.

Die Anwendung des Verfahrens in den zuvor erläuterten Ausführungsbeispielen auf zwei wesentlich voneinander verschiedenen Schaltungstopologien (Serien- und Parallelschaltung) in jeweils zwei wesentlich voneinander verschiedenen Ausführungsformen spannt die ganze Anwendungsbreite des neuartigen und allgemeingültigen Prinzip auf:

- Für den Fall der Serienschaltung liegen beispielsweise im Ausführungsbeispiel der Fig. 9 beide Urbildimpedanzen und beide Bildimpedanzen jeweils auf der selben Seite des Anpass-Netzwerkes, während im Ausführungsbeispiel der Fig. 1 eine erste Urbildimpedanz und eine zweite Bildimpedanz auf der einen, eine zweite Urbildimpedanz und eine erste Bildimpedanz jedoch auf der gegenüberliegenden Seite des Anpass-Netzwerkes $M_1$ liegen.

- Für den Fall der Parallelschaltung zeigt das Ausführungsbeispiel der Fig. 12 das Optimieren einer Lastimpedanz (beziehungsweise, einer transformierten Lastimpedanz) unter Festhalten der anderen Lastimpedanz (transformierten Lastimpedanz), während unter Anwendung des Ausführungsbeispiels der Fig. 22 ein optimales Paar zweier variabler transformierter Lastimpedanzen bestimmt wird.

Arbeiten - beispielsweise wie in der Fig. 12 oder der Fig. 22 - zwei Quellenelemente $Q_1$, $Q_2$ parallel zueinander (beispielsweise über ein T-Stück T) in die selbe Last L, so wird ein aus dem ersten Quellenelement $Q_1$ stammendes Signal zu einem ersten Teil in das erste Quellenelement $Q_1$ hinein zurückreflektiert, zu einem zweiten Teil in die Last L, zu einem dritten Teil aber in den Ausgang des zweiten Quellenelements $Q_2$ gelangen. Das zweite Quellenelement $Q_2$ kann unter den auf es zulaufenden Signalanteilen nicht unterscheiden zwischen dem aus dem eigenen Signal zurückreflektiertem und dem aus dem ersten Quellenelement $Q_1$ herrührenden Signalanteil. Alles, was das zweite Quellenelement $Q_2$ erfährt, ist ein anderes zurücklaufendes Signal. Das erste Quellenelement $Q_1$ modifiziert daher die von dem zweiten Quellenelement $Q_2$ wahrgenommene Lastimpedanz. Der von dem zweiten Quellenelement $Q_2$ wahrgenommene Lastreflexionsfaktor - der der wahrgenommenen Lastimpedanz zugehörig ist - kann auch als effektiver Lastreflexionsfaktor bezeichnet werden.

Eine Transformation eines "physikatischen" Lastreflexionsfaktors in den "effektiven" Lastreflexionsfaktor wird als Lastmodulation (oder engl. "active Load-Pull") bezeichnet. Ist nachfolgend von einem Reflexionsfaktor die Rede, welcher in einen Eingang eines T-Stückes T hinein gemessen wird, so kann dieser Reflexionsfaktor ein physikalischer Reflexionsfaktor oder ein effektiver Reflexionsfaktor sein, sofern nicht explizit angegeben.

Ein Sonderfall ist die verlustfreie Addition der Ausgangssignale zweier identischer Quellenelemente $Q_1$, $Q_2$ am symmetrischen T-Stück T, wie sie in der Beschreibung zu den Ersatzschaltbildern der Figuren 12 ff. näher erläutert wird.

Die Ausführungsbeispiele werden für ein einfaches Verständnis für reelle effektive Lastreflexionsfaktoren erläutert. Da sich durch eine geeignete Wahl einer komplexen Bezugsimpedanz eine jede Impedanz sowohl mit einem reellen wie auch einem komplexen Reflexionsfaktor darstellen lässt, erfolgt die Vereinfachung für reelle effektive Lastreflexionsfaktoren ohne Beschränkung der Allgemeinheit: Aufgrund der Erläuterung anhand reeller Reflexionsfaktoren ist Anwendbarkeit des Verfahrens auf reelle Impedanzen entsprechend nicht beschränkt.

Die Operation des komplex Konjugierens wird in den Formeln durch das Nachstellen eines Sternes hinter eine zu konjugierende Größe bezeichnet. Z.B. ist a komplex konjugiert a*. Sofern nicht explizit hiervon abgewichen wird, zielt die nachfolgende Darstellung der Ausführungsbeispiele auf leistungserhaltende, reziproke Anpassnetzwerke $M_1$, $M_2$.

Sofern nicht explizit davon abgewichen wird, ist ein Anpassnetzwerk $M_1$, $M_2$ nachfolgend als Teilschaltung mit einem ersten Anschluss $A_1$ - beispielsweise als Ausgang - und einem zweiten Anschluss $A_2$ - beispielsweise als Eingang - vorgesehen. Eine beliebige - typischerweise vom Quellenelement zur Last definierte - Durchlaufrichtung (hier für eine Signalwelle) durch das Anpassnetzwerk $M_1$, $M_2$ - beispielsweise vom Eingang zum Ausgang - wird im Folgenden als Vorwärtsrichtung bezeichnet. Die umgekehrte Durchlaufrichtung wird als Rückwärtsrichtung bezeichnet. Ein in Rückwärtsrichtung durchlaufenes Anpassnetzwerk $M_1$, $M_2$ wird als das zu diesem Anpassnetzwerk $M_1$, $M_2$ gehörige revertierte Anpassnetzwerk bezeichnet.

Wird die Transformationswirkung eines Anpassnetzwerkes $M_1$, $M_2$ mathematisch durch eine Funktion f, welche auf der Reflexionsfaktorebene operiert, beschrieben, so heißt f die beschreibende Funktion des Anpassnetzwerks $M_1$, $M_2$. Eine beschreibende Funktion $f^R$ des revertierten Anpassnetzwerks heißt revertierte beschreibende Funktion $f^R$.

In Fällen, in welchen als Optimum ein Extremum der Kenngröße dient, ändert sich mit einem zusätzlichen Faktor von -1 in der Definition der Kenngröße die Extremaleigenschaft von "minimal" nach "maximal" und umgekehrt. Die Bezeichnung (Max) für das Maximum als Optimum in einem Ausführungsbeispiel ist entsprechend ein Minimum (Min) als Optimum in einem anderen Ausführungsbeispiel, ohne dass es einer detaillierten Erläuterung bedarf.

Durch die im Folgenden gewählte Bezeichnung einzelner Größen, wie "Lastreflexionsfaktor" und "Quellreflexionsfaktor", oder "Lastelement" und "Quellenelement", wird nicht zwingend festgelegt, wie die bezeichneten Größen in einer gewissen relativen Anordnung zueinander entlang oder entgegen einem Signalfluss in der betrachteten Schaltung angeordnet sind.

Um bei der Angabe abstandsartiger oder abstandsbestimmter geometrischer Größen explizit auf eine nicht-euklidische Natur eines betrachteten Abstandes hinweisen zu können, wird beispielsweise auf einen Radius als "Poincaré-Radius", auf einen Kreis als "Poincaré-Kreis" Bezug genommen, wenn der Kreis der Ort aller Punkte in einem festen Poincare-Abstand - gleich dem Poincare-Radius - von einem Mittelpunkt ist.

Wie sich anhand der Symmetrie der Transformationspfade im Smith-Chart zeigen lässt, ist für ein nichtresistives, reziprokes Anpassnetzwerk $M_1$, $M_2$ mit einem lastseitigen und einem quellseitigen Eingang Reflexionsfreiheit bezüglich einer reellen Last L am lastseitigen Ausgang $A_1$ des Anpassnetzwerkes $M_1$ gleichbedeutend mit komplex konjugierter Anpassung am quellseitigen Eingang $A_2$ des Anpassnetzwerks $M_1$.

Im allgemeinen ist es bei einer Serienschaltung, bestehend aus zwei durch ein Anpassnetzwerk $M_1$, $M_2$ miteinander verbundenen Schaltungselementen $Q_1$ bzw. $Q_2$ und L, nur in Sonderfällen möglich, das Anpassnetzwerk $M_1$, $M_2$ dergestalt auszulegen, dass gleichzeitig in einer ersten Richtung zum Signalfluss der Eingangsreflexionsfaktor des ersten Schaltungselementes durch das Anpassnetzwerk $M_1$, $M_2$ auf einen möglichst optimal angepassten Lastreflexionsfaktor für das zweite Schaltungselement, und in einer zweiten Richtung zum Signalfluss einen Ausgangsreflexionsfaktor des zweiten Schaltungselementes durch das in umgekehrter Richtung durchlaufene Anpassnetzwerk $M_1$, $M_2$ auf einen möglichst optimal angepassten Quellreflexionsfaktor für das erste Schaltungselement abzubilden.

Impedanzen und Reflexionsfaktoren sind im Allgemeinen komplexwertig, jeder Impedanzwert/ Reflexionsfaktorwert wird demnach über Festlegung zweier reeller Freiheitsgrade eindeutig festgelegt. Die genannten mathematischen Randbedingungen an die Transformationswirkung reziproker, verlustfreier Anpassnetzwerke $M_1$, $M_2$ sind dergestalt, dass nach Festlegung einer Urbild- und einer Bildimpedanz unter der Transformation des in einer Richtung durchlaufenen Anpassnetzwerkes $M_1$, $M_2$ für die Transformationswirkung des Anpassnetzwerkes $M_1$, $M_2$ noch ein einziger reeller Freiheitsgrad verbleibt. Dies reicht nicht, um für eine zweite Urbildimpedanz die Bildimpedanz unter dem in derselben, oder der entgegengesetzten Richtung durchlaufenen Anpassnetzwerkes $M_1$, $M_2$ frei festlegen zu können. Tatsächlich ist, wie weiter unten erläutert wird, der zweite Bildimpedanzwert auf den Rand eines Kreises beschränkt.

In einem Verfahren zur Auslegung einer elektronischen Schaltung werden zwei im Rahmen der mathematischen Randbedingungen optimale Paare von Urbild- und Bildimpedanzen unter einem reziproken, nichtresistiven Anpassnetzwerk $M_1$, $M_2$ aufgesucht, wobei die Abbildung der einen Urbildimpedanz auf die zugehörige Bildimpedanz in einer ersten Richtung, die Abbildung der zweiten Urbildimpedanz auf die zugehörige Bildimpedanz in der entgegengesetzten Richtung durch das Anpassnetzwerk $M_1$, $M_2$ erfolgt.

Ebenfalls ist eine Serienschaltung zweier durch ein Anpassnetzwerk $M_1$, $M_2$ miteinander verbundenen Schaltungselemente möglich. Es werden dabei zwei im Rahmen mathematischer Randbedingungen optimale Paare von Urbild- und Bildimpedanzen unter einem reziproken, nichtresistiven Anpassnetzwerk $M_1$, $M_2$ aufgesucht, wobei die Abbildung beider Urbildimpedanzen auf die jeweils zugehörigen Bildimpedanzen in der selben Durchlaufrichtung durch das Anpassnetzwerk $M_1$, $M_2$ erfolgt.

Das Verfahren zur Auslegung einer elektronischen Schaltung kann auf eine Schaltungstopologie angewendet werden, bei der die Signale zweier Quellenelemente $Q_1$, $Q_2$ über ein T-Stück T in eine gemeinsame Last L abgeleitet werden.

Im Folgenden wird die den erläuterten Ausführungsbeispielen gemeinsame Grundlage näher erläutert.

Das Schwarz-Pick-Theorem

Bei der Schaltungsauslegung ergibt sich häufig die Notwendigkeit, die Impedanzpegel von im Signalpfad aufeinanderfolgenden Unterbaugruppen oder Bauelementen aufeinander abzustimmen. Dies ist die Aufgabe gesonderter, zwischengeschalteter Funktionsblöcke, der sogenannten Anpassnetzwerke, z.B. $M_1$, $M_2$ in Fig. 12.

Fig. 1 zeigt eine elektronische Schaltung in Form einer Kette aus einem ersten Verstärker als Quellenelement $Q_1$ mit einem Quellreflexionsfaktor $b_{on}$, einem ersten Anpassnetzwerk $M_1$ mit einem ersten Anschluss $A_1$ und einem zweiten Anschluss $A_2$ und beispielsweise einem zweiten Verstärker als Lastelement L mit einem Lastreflexionsfaktor $a_{on}$, wobei der erste Anschluss $A_1$ mit dem Lastelement L und der zweite Anschluss $A_2$ mit dem ersten Quellenelement $Q_1$ verbunden ist. Mit Hilfe des Anpassnetzwerks $M_1$ wird am zweiten Anschluss $A_2$ ein in das Anpassnetzwerk $M_1$ hinein gemessener transformierter erster Lastreflexionsfaktor $a_{on}'$ und am ersten Anschluss A1 in das erste Anpassnetzwerk $M_1$ hinein ein transformierter erster Quellreflexionsfaktor $b_{on}'$ bewirkt.

Der Auslegung des Anpassnetzwerkes M1 aus reaktiven Elementen innerhalb der Verstärkerkette $Q_1$, L, wie sie in Form der Schaltung 1 in Fig. 1 dargestellt ist, liegt folgende Annahme zu Grunde: Bildet das Anpassnetzwerk $M_1$ den Quellreflexionsfaktor $b_{on}$ auf einen gegebenen transformierte ersten Quellreflexionsfaktor $b_{on}'$ ab - wobei beispielsweise durch einen gewünschten gegebenen transformierten ersten Quellreflexionsfaktor $b_{on}'$ bspw. eine Effizienz der Leistungsverstärkung des Lastelementes L optimiert werden kann - so liegt der transformierte erste Lastreflexionsfaktor $a_{on}'$, welchen das Quellenelement $Q_1$ erfährt, auf einem Kreis im Smith-Chart, nachfolgend als Lastkreis bezeichnet. Der Lastkreis hängt nicht von dem konkreten ersten Anpassnetzwerk $M_1$ ab, sondern (bei gegebenem ersten Quellreflexionsfaktor $b_{on}$) lediglich von dem transformierten ersten Quellreflexionsfaktor $b_{on}'$ der ersten Verstärkerstufe $Q_1$, und dem ersten Lastreflexionsfaktor $a_{on}$ (d.h., dem Eingangsreflexionsfaktor der zweiten Verstärkerstufe).

Im Rahmen der weiteren Untersuchungen des Anmelders hat sich gezeigt, dass auch das Urbild des Lastkreises unter der Menge aller reziproker, verlustloser Anpassnetzwerke, welche bei gegebenem ersten Lastreflexionsfaktor $a_{on}$ den gegebenen Quellreflexionsfaktor $b_{on}$ auf den gegebenen transformierten Quellreflexionsfaktor $b_{on}$' abbilden, einen Kreis im Smith Chart, nachfolgend Urbildkreis genannt, darstellt.

Allgemein wird die Transformationswirkung elektronischer Anpassnetzwerke $M_1$, $M_2$ mathematisch durch Möbiustransformationen beschrieben. Eine Eigenschaft der Möbiustransformationen ist die Kreistreue: Kreise werden stets auf Kreis abgebildet, insbesondere die Abbildung des Urbildkreises auf den Lastkreis:

Jeder Punkt auf dem Urbildkreis wird von allen reziproken, verlustlosen Anpassnetzwerken $M_1$, $M_2$, welche den gegebenen Quellreflexionsfaktor $b_{on}$ auf den gegebenen transformierten Quellreflexionsfaktor $b_{on}$' abbilden, auf einen Punkt auf dem Lastkreis abgebildet.

Im Laufe der weiteren Untersuchungen des Anmelders ist die Anwendung eines Satzes der Funktionentheorie im Umfeld der Elektrotechnik entwickelt worden:

Das Schwarz-Pick-Theorem. Ist $f : D| \rightarrow D|$ eine holomorphe Abbildung der Einheitskreisscheibe $D|$ auf sich selbst, so gilt allgemein für alle $z_1, z_2 \in D|$

$$\left| \frac{f(z_1) - f(z_2)}{1 - f(z_1)^* f(z_2)} \right| \leq \frac{|z_1 - z_2|}{|1 - z_1^* z_2|}, \tag{39}$$

bei Gleichheit für alle $z_1, z_2 \in D|$ genau dann, wenn f ein analytischer Automorphismus der Einheitskreisscheibe $D|$ ist, und mithin eine Möbius-Transformation, welche die Einheitskreisscheibe $D|$ isomorph auf sich selbst abbildet.

Im Poincaré'schen Modell der hyperbolischen Geometrie wird der Poincaré-Abstand zweier Punkte $z_1, z_2$ der Einheitskreisscheibe allgemein als

$$P(z_1, z_2) = \operatorname{arctanh}\left( \frac{|z_1 - z_2|}{|1 - z_1^* z_2|} \right) \tag{40}$$

gemessen. Das Schwarz-Pick-Theorem hat mithin zur Folge, dass die Anpassnetzwerke $M_1$, $M_2$, welche Automorphismen der Einheitskreisscheibe sind, den Poincare-Abstand erhalten.

Nun sind die im Rahmen der Auslegung von Leistungsverstärkern betrachteten Anpassnetzwerke $M_1$, $M_2$ nicht-resistiv, d.h., leistungserhaltend. Entsprechend transformiert ein solches Anpassnetzwerk $M_1$, $M_2$ keinen aktiven Punkt im Smith-Diagramm auf einen passiven und umgekehrt: Die Transformationswirkung eines nicht-resistiven (und reziproken) Anpassnetzwerks $M_1$, $M_2$ ist ein Automorphismus der Einheitskreisscheibe $D|$.

Wie oben gezeigt, gilt ferner: Ein Anpassnetzwerk $M_1$, das, in einer ersten Richtung durchlaufen, eine an einem Eingang $A_2$ anliegende Quellimpedanz in ein an einem Ausgang $A_1$ des Anpassnetzwerkes $M_1$ gezeigtes komplex Konjugiertes einer Lastimpedanz transformiert, bildet, in der entgegengesetzten Richtung durchlaufen, die Lastimpedanz auf das komplex Konjugierte der Quellimpedanz ab. Entsprechendes gilt aufgrund der Transformationswirkung für die Reflexionsfaktoren.

Zuletzt ist stets gemeinsam mit der Transformationswirkung eines in einer ersten Richtung durchlaufenen Anpassnetzwerks $M_1$ auch die Transformationswirkung des in umgekehrter Richtung durchlaufenen Anpassnetzwerkes $M_1$ ein Automorphismus der Einheitskreisscheibe $D|$.

Zusammenfassend gilt daher der folgende Satz: Es sei

a) M ein nicht-resistives, reziprokes Anpassnetzwerk $M_1$,

b) $f : D| \rightarrow D|$ beschreibe die Transformationswirkung des in einer ersten Richtung durchlaufenen Anpassnetzwerkes $M_1$;

c) $f^R: D| \rightarrow D|$ beschreibe die Transformationswirkung des in entgegengesetzter Richtung durchlaufenen (=revertierten) Anpassnetzwerkes $M_1$;

d) es gelte ferner f(a)=a' für zwei Punkte a, a' $\in D|$

so folgt:

i)

$$f^R(a_{on}'^*) = a_{on}^* \qquad\qquad (41)$$

ii)

$$P(a_{on}', b_{on}) = P(f(a_{on}), f(b_{on})) \qquad\qquad (42)$$

iii)

$$P(a_{on}'^*, b_{on}) = P(f^R(a_{on}'^*), f^R(b_{on})) \qquad\qquad (43)$$

wobei $P(a_{on}'^*, b_{on})$ den Poincaré-Abstand der zwei Punkte $a_{on}'^*$ und $b_{on}$ (Reflexionsfaktoren) bezeichnet.

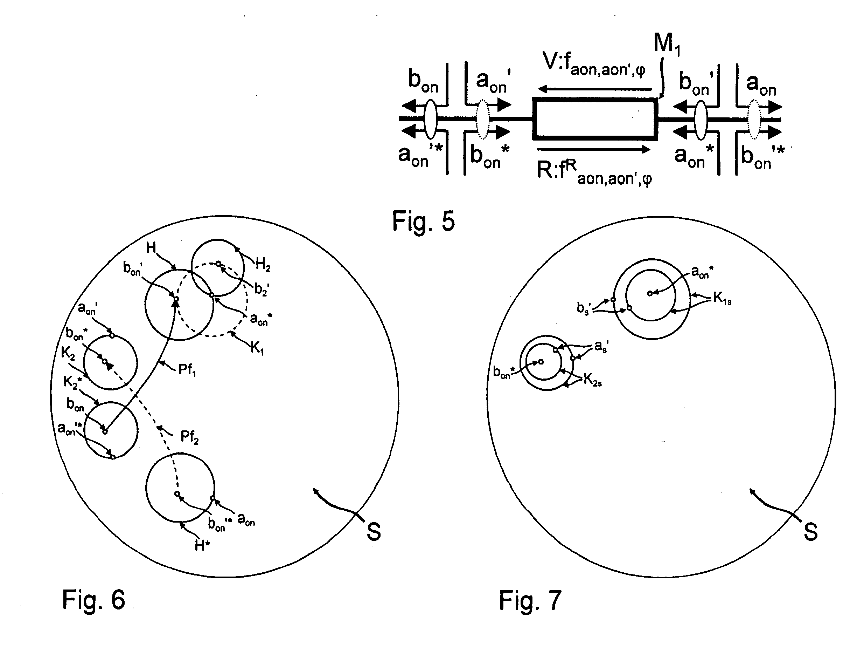

In Fig. 5 ist ein Ausführungsbeispiel für den im obigen Satz ausgedrückten Zusammenhang grafisch in Form eines Diagramms illustriert, das nachfolgend als Anpasskonstellation bezeichnet wird:

Das Anpassnetzwerk $M_1$ bildet in einer angenommenen Vorwärtsrichtung von rechts nach links den Lastreflexionsfaktor $a_{on}$ auf den transformierten Lastreflexionsfaktor $a_{on}'$ ab. Dieser Zusammenhang ist in Fig. 5 dargestellt durch die mit $a_{on}$ und $a_{on}'$ beschrifteten Winkelpfeile. Die angenommene Vorwärtsrichtung V ist durch einen mit dem Formelzeichen der beschreibenden Funktion $f_{aon,aon',\varphi}$ beschrifteten Pfeil angedeutet.

Nach Teilsatz i) des obigen Satzes bildet das revertierte Anpassnetzwerk $M_1$ das komplex Konjugierte $a_{on}'^*$ des transformierten Lastreflexionsfaktors $a_{on}'$ auf das komplex Konjugierte $a_{on}^*$ des Lastreflexionsfaktors $a_{on}$ ab, dargestellt durch die mit $a_{on}'^*$ und $a_{on}^*$ beschrifteten Winkelpfeile. Die Transformationsrichtung R des revertierten Anpassnetzwerkes $M_1$ ist durch einen mit dem Formelzeichen der revertierten beschreibenden Funktion $f^R_{aon,aon',\varphi}$ beschrifteten Pfeil angedeutet.

Das Anpassnetzwerk $M_1$ bildet weiters, in Rückwärtsrichtung R durchlaufen, den Quellreflexionsfaktor $b_{on}$ auf den transformierten Quellreflexionsfaktor $b_{on}'$ ab, dargestellt durch die mit $b_{on}$ und $b_{on}'$ beschrifteten Winkelpfeile. Die Rückwärtsrichtung R ist durch einen mit dem Formelzeichen der revertierten beschreibenden Funktion $f^R_{aon,aon',\varphi}$ beschrifteten Pfeil angedeutet.

Teilsatz i), angewendet auf die beschreibende Funktion $f^R_{aon,aon',\varphi}$ des umgekehrt durchlaufenen Anpassnetzwerkes $M_1$, besagt, dass durch das vorwärts durchlaufene Anpassnetzwerk $M_1$ das komplex Konjugierte $b_{on}'^*$ der transformierten Quellimpedanz $b_{on}'$ auf das komplex Konjugierte $b_{on}^*$ der Quellimpedanz $b_{on}$ abgebildet wird, dargestellt durch die mit $b_{on}'^*$ und $b_{on}^*$ beschrifteten Winkelpfeile.

Die Aussage der Teilsätze ii) und iii)- die Erhaltung des Poincaré- Abstandes unter der beschreibenden Funktion und unter der revertierten beschreibenden Funktion- ist in Fig. 5 jeweils durch zwei Ellipsen angedeutet: Durch eine erste durchgezogene Ellipse, welche die Winkelpfeile mit den Bezugszeichen $a_{on}'^*$ und $b_{on}$ verbindet, sowie eine zweite durchgezogene Ellipse welche die Winkelpfeile mit Bezugszeichen $b_{on}'$ und $a_{on}^*$ verbindet, wird die Erhaltung des Poincaré- Abstandes zwischen dem komplex Konjugierten $a_{on}'^*$ des transformierten Lastreflexionsfaktors $a_{on}'$ und dem Quellreflexionsfaktor $b_{on}$ unter der revertierten beschreibenden Funktion $f^R_{aon,aon',\varphi}$ (Teilsatz iii)) schematisch dargestellt.

Durch eine erste strichlinierte Ellipse, welche die Winkelpfeile mit Bezugszeichen $a_{on}$ und $b_{on}'^*$, verbindet, und durch eine zweite strichlinierte Ellipse, welche die Winkelpfeile mit Bezugszeichen $a_{on}'$ und $b_{on}^*$ verbindet, wird die Erhaltung des Poincaré- Abstandes zwischen dem komplex Konjugierten $b_{on}'^*$ des transformierten Quellreflexionsfaktors $b_{on}'$ und dem Lastreflexionsfaktor $a_{on}$ unter der beschreibenden Funktion $f_{aon,aon',\varphi}$ (Teilsatz ii)) schematisch dargestellt.

Darüber hinaus sind, aufgrund der Symmetrie der Poincaré'schen Abstandsdefinition unter der Operation komplexen Konjugierens, die Poincaré-Abstände zwischen dem komplex Konjugierten $a_{on}'^*$ des transformierten Lastreflexionsfaktors $a_{on}'$ und dem Quellreflexionsfaktor $b_{on}$, sowie zwischen dem komplex Konjugierten $b_{on}'^*$ des transformierten Quellreflexionsfaktors $b_{on}'$ und dem Lastreflexionsfaktor $a_{on}$, welche zu den jeweiligen Ellipsenpaaren in Fig. 5 gehören, gleich.

Bildet man einen Quellreflexionsfaktor $b_{on}$ auf einen bestimmten Wert des transformierten Quellreflexionsfaktors $b_{on}'$ ab, so ist, gemäß der Anpasskonstellation aus Fig. 5, der transformierte Lastreflexionsfaktor $a_{on}'$ auf einen Poincaré-Kreis um das komplex Konjugierte $b_{on}^*$ des Quellreflexionsfaktors $b_{on}$ beschränkt. Dabei ist ein Poincaré-Radius gleich dem Poincaré-Abstand zwischen dem komplex Konjugierten $a_{on}^*$ des Lastreflexionsfaktors $a_{on}$ und dem bestimmten Wert des transformierten Quellreflexionsfaktors $b_{on}'$.

Gesucht wird nun ein Wert der Werte für den transformierten Lastreflexionsfaktor $a_{on}'$ auf dem zuvor definierten Kreis für den eine gegebene Kenngröße der Schaltung - beispielsweise eine Leistungsverstärkung - einen optimalen Wert annimmt. Der optimale Wert der Kenngröße hängt von dem bestimmten Wert des transformierten Quellreflexionsfaktor $b_{on}$' ab.

Bildet man den Lastreflexionsfaktor $a_{on}$ (mit Hilfe des nun andersherum durchlaufenen Anpassnetzwerkes $M_1$) auf den optimalen Wert für den transformierten Lastreflexionsfaktor $a_{on}$' ab, so liegt, ebenfalls gemäß der Anpasskonstellation aus Fig. 5, der transformierte Quellreflexionsfaktor $b_{on}$' auf einem weiteren Poincaré-Kreis desselben Radius', jedoch um das komplex Konjugierte $a_{on}$* des Lastreflexionsfaktors $a_{on}$. Auf dem weiteren Kreis lässt sich wiederum ein Optimum der Kenngröße finden, nun für den transformierten Quellreflexionsfaktor $b_{on}$'. Das Optimum hängt von dem optimalen Wert ab, welcher seinerseits mit Bezug auf den bestimmten Wert des transformierten Quellreflexionsfaktor $b_{on}$' definiert ist.

Eine Iteration liefert ein Paar aus einem bestimmten Wert des transformierten Lastreflexionsfaktors $a_{on}$' und einem bestimmten Wert des transformierten ersten Quellreflexionsfaktors $b_{on}$', durch die die Kenngröße der Schaltung optimiert wird, unter der Randbedingung eines gegebenen Poincaré-Abstandes $P_R$ zwischen dem komplex Konjugierten $a_{on}$* des ersten Lastreflexionsfaktors $a_{on}$ und dem transformierten ersten Quellreflexionsfaktor $b_{on}$'. Dieser Poincaré-Abstand $P_R$ ist gleich dem Poincaré-Abstand zwischen dem komplex Konjugierten $b_{on}$* des Quellreflexionsfaktors $b_{on}$ und dem transformierten Lastreflexionsfaktor $a_{on}$'.

In einem vereinfachten Verfahren zum Ausführungsbeispiel der Fig. 1 werden Paare ermittelt, die Kenngröße der Schaltung optimieren: Ausgehend von einer Anzahl von Poincaré-Radien $P_R$ werden optimale Reflexionsfaktorpaare auf Kreisen selben Poincare-Radiuses innert zweier konzentrischer Scharen von Poincare-Kreisen um das komplex Konjugierte $b_{on}$* des ersten Quellreflexionsfaktors $b_{on}$ sowie das komplex Konjugierte $a_{on}$* des ersten Lastreflexionsfaktors $a_{on}$ ermittelt. Dieses Verfahren wird nachfolgend anhand der Fig. 6 und der Fig. 7 erläutert.

Fig. 6 zeigt in einem schematischen Smith-Diagramm S:

- einen ersten Lastreflexionsfaktor $a_{on}$,

- einen ersten Quellreflexionsfaktor $b_{on}$,

- das komplex Konjugierte $a_{on}$* des ersten Lastreflexionsfaktors $a_{on}$,

- das komplex Konjugierte $b_{on}$* des ersten Quellreflexionsfaktors $b_{on}$,

- einen transformierten ersten Quellreflexionsfaktor $b_{on}$',

- einen transformierten ersten Lastreflexionsfaktor $a_{on}$',

- das komplex Konjugierte $b_{on}$'* des transformierten ersten Quellreflexionsfaktors $b_{on}$',

- das komplex Konjugierte $a_{on}$'* des transformierten ersten Lastreflexionsfaktors $a_{on}$',

- einen weiteren transformierten Quellreflexionsfaktor $b_2$'.

Neben den Reflexionsfaktoren sind in Fig. 6 dargestellt

- ein erster Poincare-Kreis $K_1$ um das komplex Konjugierte $b_{on}$* des ersten Quellreflexionsfaktors $b_{on}$,

- ein zweiter Poincaré-Kreis $K_2$ um das komplex Konjugierte $a_{on}$* des ersten Lastreflexionsfaktors $a_{on}$,

- das komplex Konjugierte $K_1$* des ersten Poincaré-Kreises $K_1$,

- ein Poincaré-Hilfskreis $H_1$ um den transformierten ersten Quellreflexionsfaktor $b_{on}$',

- das komplex Konjugierte $H_1$* des Poincaré-Hilfskreises $H_1$ sowie

- ein weiterer Poincaré-Hilfskreis $H_2$ um den weiteren transformierten Quellreflexionsfaktor $b_2$'.

Bis auf den Einheitskreis als Rand des Smith-Diagrammes S haben alle in Fig. 6 dargestellten Kreise den gleichen Poincaré-Radius, welcher der Poincaré-Radius als Poincaré-Abstand zwischen dem transformierten ersten Quellreflexionsfaktor $b_{on}$' und dem komplex Konjugierten $a_{on}$* des ersten Lastreflexionsfaktors $a_{on}$ gegeben ist, so dass

- der erste Lastreflexionsfaktor $a_{on}$ auf dem komplex Konjugierten $H_1^*$ des Poincaré-Hilfskreises $H_1$,

- das komplex Konjugierte $a_{on}^*$ des ersten Lastreflexionsfaktors $a_{on}$ auf dem Poincaré-Hilfskreis $H_1$ sowie auf dem weiteren Poincaré-Hilfskreis $H_2$,

- der transformierte erste Lastreflexionsfaktor $a_{on}'$ auf dem ersten Poincaré-Kreis $K_1$, und

- das komplex Konjugierte $a_{on}'^*$ des transformierten ersten Lastreflexionsfaktors $a_{on}'$ auf dem komplex Konjugierten $K_1^*$ des ersten Poincaré-Kreises $K_1$

liegt.

Ein durchgezogener Pfeil deutet die Abbildung des ersten Quellreflexionsfaktors $b_{on}$ durch das Anpassnetzwerk $M_1$ auf den transformierten ersten Quellreflexionsfaktor $b_{on}'$, ein gestrichelter Pfeil die Abbildung des komplex Konjugierte $b_{on}'^*$ des transformierten ersten Quellreflexionsfaktors $b_{on}'$ durch das revertierte Anpassnetzwerk $M_1$ auf das komplex Konjugierte $b_{on}^*$ des ersten Quellreflexionsfaktors $b_{on}$ an.

Aufgrund der Erhaltung des Poincaré- Abstandes unter der beschreibenden Funktion $f_{aon,aon',\varphi}$ des Anpassnetzwerkes $M_1$ wird bei der Abbildung des ersten Quellreflexionsfaktors $b_{on}$ auf den transformierten ersten Quellreflexionsfaktor $b_{on}'$ der komplex Konjugierte $K_1^*$ des ersten Poincare- Kreises $K_1$ um den Quellreflexionsfaktor $b_{on}$ auf den Poincaré- Hilfskreis $H_1$ um den transformierten ersten Quellreflexionsfaktor $b_{on}'$ abgebildet. Wird dagegen durch das Anpassnetzwerk $M_1$ der erste Quellreflexionsfaktor $b_{on}$ in den weiteren transformierten Quellreflexionsfaktor $b_2'$ transformiert, so wird der komplex Konjugierte $K_1^*$ des ersten Poincaré- Kreises $K_1$ um den ersten Quellreflexionsfaktor $b_{on}$ auf den weiteren Poincaré- Hilfskreis $H_2$ um den weiteren transformierten Quellreflexionsfaktor $b_2'$ abgebildet.

Gleichzeitig wird, aufgrund der Erhaltung des Poincaré- Abstandes unter der revertierten beschreibenden Funktion $f^R_{aon,aon',\varphi}$ des umgekehrt durchlaufenen Anpassnetzwerkes $M_1$ bei der Abbildung des komplex Konjugierten $b_{on}'^*$ des transformierten ersten Quellreflexionsfaktors $b_{on}'$ auf das komplex Konjugierte $b_{on}^*$ des ersten Quellreflexionsfaktors $b_{on}$ der komplex Konjugierte $H_1^*$ des Poincaré- Hilfskreises $H_1$ um das komplex Konjugierte $b_{on}'^*$ des transformierten ersten Quellreflexionsfaktors $b_{on}'$ auf den ersten Poincaré- Kreis $K_1$ um das komplex Konjugierte $b_{on}^*$ des ersten Quellreflexionsfaktors $b_{on}$ abgebildet.

Demzufolge liegen, zu jedem Wert des transformierten ersten Quellreflexionsfaktors $b_{on}'$, alle möglichen Werte des transformierten ersten Lastreflexionsfaktors $a_{on}'$ auf dem ersten Poincare-Kreis $K_1$. Zu dem transformierten ersten Quellreflexionsfaktor $b_{on}'$ wird ein Wert des transformierten ersten Lastreflexionsfaktors $a_{on}'$ auf dem ersten Poincaré-Kreis $K_1$ bestimmt, für den die Kenngröße der Schaltung ein (lokales) Optimum annimmt.

Durch die Bestimmung des transformierten weiteren Quellreflexionsfaktor $b_2'$ auf dem zweiten Poincaré-Kreis $K_2$ und (im selben Poincaré-Abstand von dem komplex Konjugierten $a_{on}^*$ des ersten Lastreflexionsfaktors $a_{on}$) des transformierten ersten Quellreflexionsfaktors $b_{on}'$, werden zudem zulässige Werte des transformierten ersten Lastreflexionsfaktor $a_{on}'$ auf den ersten Poincaré-Kreis $K_1$ beschränkt.

Zu dem weiteren transformierten Quellreflexionsfaktor $b_2'$ wird ein weiterer Wert des transformierten ersten Lastreflexionsfaktors $a_{on}'$ auf dem ersten Poincaré-Kreis $K_1$ bestimmt, für den die Kenngröße der Schaltung ein (lokales) Optimum annimmt.

In vollständiger Analogie liegen sogar sämtliche Werte des transformierten ersten Quellreflexionsfaktors $b_{on}'$, für welche der transformierte erste Lastreflexionsfaktor $a_{on}'$ auf den ersten Poincaré-Kreis $K_1$ beschränkt ist, auf dem zweiten Poincaré-Kreis $K_2$.

Entsprechend wird die Bestimmung der die Kenngröße optimierenden Paare aus je einem transformierten ersten Quellreflexionsfaktor $b_{on}'$ und einem transformierten ersten Lastreflexionsfaktor $a_{on}'$ auf Paare beschränkt, bei welchen der Poincaré-Abstand des transformierten ersten Lastreflexionsfaktors $a_{on}'$ von dem komplex Konjugierten $b_{on}^*$ des ersten Quellreflexionsfaktors $b_{on}$ gleich ist wie der Poincaré-Abstand des transformierten ersten Quellreflexionsfaktors $b_{on}'$ von dem komplex Konjugierten $a_{on}^*$ des ersten Lastreflexionsfaktors $a_{on}$.

Dieser Sachverhalt ist in einer gesonderten Darstellung in Fig. 7, hervorgehoben. Fig. 7 zeigt in einem Smith-Diagramm S

- das komplex Konjugierte $a_{on}^*$ des ersten Lastreflexionsfaktors $a_{on}$,

- das komplex Konjugierte $b_{on}^*$ des ersten Quellreflexionsfaktors $b_{on}$,

- eine erste Punkteschar $b_s'$ von zwei transformierten Quellreflexionsfaktoren.

- eine zweite Punkteschar $a_s'$ von zwei transformierten Lastreflexionsfaktoren und

Zusätzlich zu den Reflexionsfaktoren sind in Fig. 7 dargestellt:

- eine erste Kreisschar $K_{1s}$ zweier erster Poincaré-Kreise um das komplex Konjugierte $b_{on}^*$ des ersten Quellreflexionsfaktors $b_{on}$, die erste Schar $K_{1s}$ einen Poincaré-Kreis mit einem ersten Poincaré-Radius und einen Poincaré-Kreis mit einem zweiten Poincaré-Radius enthaltend, und
- ein zweite Kreisschar $K_{2s}$ zweiter Poincaré-Kreise um das komplex Konjugierte $a_{on}^*$ des Lastreflexionsfaktors $a_{on}$, die zweite Schar $K_{2s}$ einen Poincaré-Kreis mit dem ersten Poincare-Radius und einen Poincaré-Kreis mit dem zweiten Poincaré-Radius enthaltend.

Je ein transformierter Quellreflexionsfaktor $b_s'$ aus der ersten Punkteschar $b_s'$ liegt auf je einem Poincaré-Kreis aus der ersten Kreisschar $K_{1s}$, je ein transformierter Lastreflexionsfaktor $a_s'$ aus der zweiten Punkteschar $a_s'$ liegt auf je einem Poincaré-Kreis aus der zweiten Kreisschar $K_{2s}$.

Es werden, für einen Satz gegebener Poincaré-Abstände, Paare gebildet aus je einem transformierten ersten Lastreflexionsfaktor $a_{on}'$ in einem ersten Poincaré-Abstand von dem komplex Konjugierten $b_{on}^*$ des ersten Quellreflexionsfaktors $b_{on}$ und einem transformierten ersten Quellreflexionsfaktor $b_{on}'$ in dem ersten Poincaré-Abstand von dem komplex Konjugierten $a_{on}^*$ des ersten Lastreflexionsfaktors $a_{on}$ und ein Paar unter den dergestalt bestimmten Paaren von Reflexionsfaktoren derart bestimmt, dass die Kenngröße ein Optimum annimmt.

Möbiustransformationen und die Automorphismen der Einheitskreisscheibe

Eine Möbiustransformation ist eine Abbildung f der komplexen Zahlenebene auf sich selbst, von der Form

$$f(z) = \frac{\alpha z + \beta}{\gamma z + \delta}, \tag{44}$$

wobei z ein Punkt der komplexen Zahlenebene und $\alpha$, $\beta$, $\gamma$, $\delta$ beliebige komplexe Konstanten sind.

Während die Gruppe der Möbiustransformationen somit sechs reelle Freiheitsgrade hat (der Bruch lässt sich bspw. durch ö kürzen ohne die Abbildung zu verändern, so dass die vier Konstanten und $\alpha$, $\beta$, $\gamma$, $\delta$ nur drei komplexe Freiheitsgrade darstellen), ist die Automorphismengruppe der Einheitskreisscheibe eine echte Untergruppe der Möbiustransformationen: Die Automorphismen der Einheitskreisscheibe lassen sich darstellen als:

$$f(z) = e^{i\phi} \frac{z - z_0}{1 - z_0^* z}, \quad \left| e^{i\phi} \right| = 1 \tag{45}$$

Mit einem komplexen Automorphismenparameter $z_0$ und einem zyklischen Freiheitsgrad $\phi$ verfügt die Automorphismengruppe, und mithin die Gruppe der Transformationswirkungen nicht-resistiver reziproker Anpassnetzwerke, nur über drei Freiheitsgrade (bei einer gegebenen Frequenz).

Fordert man von einem Anpassnetzwerk $M_1$, einen ersten Reflexionsfaktor $a_{on}$ in einen zweiten, vom ersten verschiedenen Reflexionsfaktor $b_{on}^*$ zu transformieren,

$$f(a_{on}) = b_{on}^*, \tag{46}$$

wobei f die Transformationswirkung des in Vorwartsrichtung V durchlaufenen Anpassnetzwerkes $M_1$ beschreibt, verbleibt für die Menge N der Transformationswirkungen aller derartigen Anpassnetzwerke $M_1$ lediglich der zyklische Freiheitsgrad $\phi$: Bild wie Urbild eines beliebigen Reflexionsfaktors unter der Menge N sind geschlossene Kurven.

Das Schwarz-Pick-Theorem fordert für die geschlossenen Kurven die Gestalt von Poincare-Kreisen. So ist das Bild $N(a_{on}')$ eines dritten Reflexionsfaktors $a_{on}'$ unter der Menge N ein Poincaré-Kreis um den zweiten Reflexionsfaktor $b_{on}^*$ mit einem Poincaré-Radius gleich dem Poincaré-Abstand $P(a_{on}, a_{on}')$ zwischen dem ersten Reflexionsfaktor $a_{on}$ und dem dritten Reflexionsfaktor $a_{on}'$.

Insbesondere folgt, dass man das Bild $f(a_{on}')$ des dritten Reflexionsfaktors $a_{on}'$ unter der Transformationswirkung f des Anpassnetzwerkes $M_1$ (für reziproke, leistungserhaltende Anpassnetzwerke) lediglich auf einem festen, durch den ersten und den zweiten Reflexionsfaktor $b_{on}^*$ festgelegten Poincaré-Kreis wählen kann. Weiter folgt, dass mit der Wahl eines derartigen Bildes $f(a_{on}')$ auf dem gegebenen Poincaré-Kreis die Transformationswirkung f des Anpassnetzwerkes $M_1$ eindeutig festgelegt ist.

Löst man zuletzt die obige Darstellung der Automorphismen für $f(a_{on}) = a_{on}'$ nach $z_0$ auf, erhält man:

$$f(z_1) = e^{i\varphi} \frac{z_1 - z_0}{1 - z_0^* z_1} \quad , \quad f(a_{on}) = a_{on}' \tag{47}$$

$$\Rightarrow \quad z_0 = \frac{1 - |a_{on}|^2}{|a_{on}|^2 |a_{on}'|^2 - 1} a_{on}' e^{-i\varphi} - \frac{1 - |a_{on}'|^2}{|a_{on}|^2 |a_{on}'|^2 - 1} a_{on} \tag{48}$$

Dies zeigt explizit, dass die Menge aller beschreibender Funktionen nicht-resistiver, reziproker Anpassnetzwerke, welche einen gegebenen Lastreflexionsfaktor $a_{on}$ auf einen gegebenen transformierten Lastreflexionsfaktor $a_{on}'$ abbilden, nur über einen einzigen reellen Freiheitsgrad verfügt.

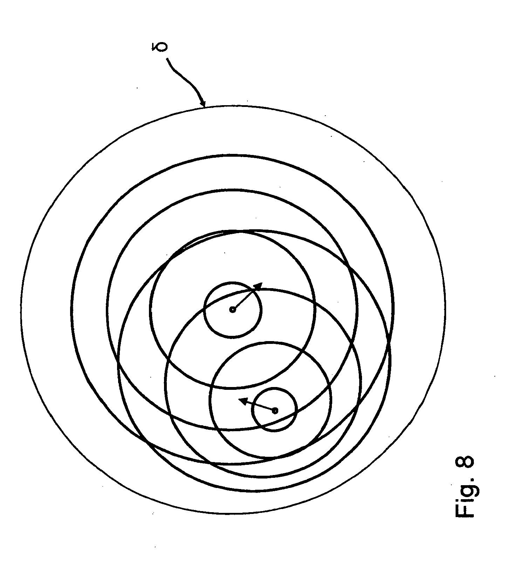

Die Auswirkungen des dargestellten Sachverhalts sind in Fig. 8 illustriert. Fig. 8 zeigt, im Inneren des Einheitskreises $\delta$, zwei Scharen einander jeweils einbeschriebener Kreise. Eine erste Schar bildet im Sinne der euklidischen Metrik der (kartesischen) Ebene eine Schar konzentrischer und äquidistanter Kreise um den Ursprung. Diese Kreise sind auch im Rahmen der hyperbolischen Geometrie der Ebene und gemessen im Poincaré-Abstand konzentrische Kreise.

Die zweite Schar von Kreisen um einen von dem Ursprung abweichenden Punkt ist im Poincaré'schen Sinne äquidistant und konzentrisch, nicht jedoch, gemessen mit der euklidischen Metrik der Ebene.

Fig. 8 zeigt ferner zwei Richtungspfeile, ein erster ausgehend vom Ursprung, ein zweiter ausgehend von dem vom Ursprung abweichenden Punkt.

Wird die Menge der beschreibenden Funktionen aller reziproken, nicht-resistiven Anpassnetzwerke auf die Teilmenge F der Funktionen eingeschränkt, welche den Ursprung auf den vom Ursprung abweichenden Punkt abbilden, so ist das Bild eines der Kreise aus der ersten Schar mit einem bestimmten Poincaré-Radius unter der Teilmenge F derjenige der Kreise aus der zweiten Schar mit dem bestimmten Poincaré-Radius.

Liegt neben dem Ursprung und dem vom Ursprung abweichenden Punkt, in welchen der Ursprung durch das Anpassnetzwerk $M_1$ transformiert wird, ein (einziges) weiteres Paar aus einem Reflexionsfaktor auf einem Poincaré-Kreis (bei gegebenen Poincaré-Radius) um den Ursprung, und seinem Bild unter dem Anpassnetzwerk $M_1$ fest (nötigenfalls auf einem Poincare-Kreis des selben Poincaré-Radiuses um den vom Ursprung abweichenden Punkt), so ist die Transformationswirkung des Anpassnetzwerkes $M_1$ im ganzen Smith-Diagramm bekannt, und somit die beschreibende Funktion eindeutig festgelegt.

Ein gleiches gilt, wenn zusätzlich zu einem Urbildpunkt und einem Bildpunkt unter der beschreibenden Funktion des Anpassnetzwerkes $M_1$ zu einer ersten Richtung ausgehend vom Urbildpunkt, eine zweite Richtung ausgehend vom Bildpunkt bekannt ist.

Die beschreibende Funktion revertierter Anpassnetzwerke

Ein revertiertes Anpassnetzwerk zu einem, einen Urbild-Reflexionsfaktor m (z.B. $m = a_{on}$) in einen Bild-Reflexionsfaktor n (z.B. $n = a_{on}'$) transformierenden Anpassnetzwerk $M_1$ werde durch eine revertierte beschreibende Funktion

$$f^R_{mn\phi} = f_{n^* m^* \phi_R} \tag{49}$$

mit Automorphismenparameter $z_0^R$ beschrieben, wobei das Gleichheitszeichen aufgrund der Symmetrie gilt. Drückt man die beschreibende Funktion des Anpassnetzwerkes $M_1$ aus als

$$f(z) = e^{i\phi} \frac{z - z_0}{1 - z_0^* z} \tag{50}$$

mit

$$z_0 = \frac{1 - |m|^2}{|m|^2 |n|^2 - 1} n\, e^{-i\phi} - \frac{1 - |n|^2}{|m|^2 |n|^2 - 1} m, \tag{51}$$

folgt

$$z_0^R = -\, e^{-i\phi_R} z_0^*, \tag{52}$$

und weiter:

$$\left\{ \begin{array}{l} f_{mn\phi}\left(z_2^*\right) = \qquad\qquad z_1^* = e^{i\phi}\, \dfrac{z_2^* - z_0(\phi)}{1 - z_0(\phi)^* z_2^*} \\[2em] f^R_{mn\phi}\left(z_1\right) = f_{n^* m^*\phi_R}\left(z_1\right) = z_2 = e^{i\phi_R}\, \dfrac{z_1 - z_0^R(\phi_R)}{1 - z_0^R(\phi_R)^* z_1} \end{array} \right\}, \tag{53}$$

$$z_0^R = -\, e^{-i\phi_R} z_0^*$$
$$\longrightarrow \qquad z_1^* = e^{i\phi}\, e^{-i\phi_R}\, z_1^*, \tag{54}$$

oder

$$\phi = \phi_R, \quad f^R_{mn\phi} = f_{n^* m^*\phi} \tag{55}$$

Die beschreibende Funktion f des in Vorwärtsrichtung durchlaufenen Anpassnetzwerkes $M_1$ bestimmt die beschreibende Funktion $f^R$ des revertierten Anpassnetzwerkes eindeutig, die Operation des Revertierens ist mathematisch wohldefiniert.

Die Kenntnis der beschreibenden Funktion f (ebenso wie der zu dieser äquivalenten revertierten beschreibenden Funktion $f^R$), deren Anwendung bei der Konstruktion von Schaltungseigenschaften optimierenden Anpassnetzwerken genutzt wird, eröffnet eine große Freiheit bei der Bestimmung konkreter Anpassnetzwerke, deren Transformationswirkung die beschreibende Funktion f bei einer gegebenen Betriebsfrequenz physikalisch realisieren:

Wie gezeigt, weist die Transformationswirkung eines nichtresisitiven, reziproken Anpassnetzwerkes bei einer Betriebsfrequenz drei reelle Freiheitsgrade auf. Liegt ein Bildreflexionsfaktor und ein (von dem Bildreflexionsfaktor verschiedener) zu diesem Bildreflexionsfaktor unter dem Anpassnetzwerk $M_1$ gehörige Urbildreflexionsfaktor fest, so verbleibt lediglich ein einziger reeller Freiheitsgrad. In Folge ist das Bild oder das Urbild jedes weiteren Reflexionsfaktors unter dem Anpassnetzwerk $M_1$ oder dem zugehörigen revertierten Anpassnetzwerk auf einen Kreis beschränkt. Liegt demnach ein zweites Paar aus einem Bild- und einem Urbildreflexionsfaktor fest - welche nicht mehr unabhängig voneinander frei gewählt werden können - sind die Transformationseigenschaften des Anpassnetzwerkes $M_1$ weitgehend bekannt.

Bei der physikalischen Auslegung eines Anpassnetzwerkes $M_1$ erlaubt die eindeutige Kenntnis der beschreibenden Funktion f frei zu wählen, welche beiden Paare von Bild- und Urbildreflexionsfaktor zur Bestimmung herangezogen werden, und in welcher Durchlaufrichtung welches der beiden Urbilder in sein Bild transformiert wird.

Während zu jedem Anpassnetzwerk $M_1$, bei einer festen Betriebsfrequenz, eine eindeutig bestimmte beschreibende Funktion f gehört, passen zu einer gegebenen beschreibenden Funktion f eine große Klasse/Menge unterschiedlichster Anpassnetzwerke und Anpassnetzwerk-Topologien: Eine beschreibende Funktion lässt sich auf vielerlei Weisen in Form des Anpassnetzwerkes $M_1$ umsetzen, dessen Transformationswirkung durch die beschreibende Funktion f gegeben ist.

Aus gegebenen Transformationseigenschaften wird ein physikalisches Anpassnetzwerk $M_1$ konstruiert. Beispielsweise wird eine hinreichend flexible Schaltungstopologie für ein Anpassnetzwerk $M_1$ vorgeben. Die Topologie wird in eine Gleichung umgesetzt mit den Bauteilwerten als Variablen. Die Gleichung wird nach der gewünschten Transformationswirkung aufgelöst.

Eine weitere Methode ist, mit einer Schaltungstopologie und variablen Bauelementwerten eine Schaltungsoptimierung mit Hilfe eines Computerprogramms zur Schaltungssimulation durchzuführen, um die gewünschte Transformationswirkung mit Hilfe der verwendeten Schaltungstopologie zu realisieren.

Darüber hinaus eröffnet die beschreibende Funktion f zusätzlich weitgehende Möglichkeiten bei der Untersuchung von Kenngrößen einer Schaltung. Insbesondere lassen sich sämtliche Transformationseigenschaften des durch die beschreibende Funktion f charakterisierten reziproken, nicht-resistiven Anpassnetzwerks $M_1$ bei einer Betriebsfrequenz ausschließlich aus der beschreibenden Funktion f herleiten - bereits vor Konstruktion oder Kenntnis des Anpassnetzwerkes $M_1$ selbst.

Ein ganz wesentlicher Vorteil und Fortschritt ist:

Das vorgestellte Verfahren ermöglicht es, sich von vornherein unter allen denkbaren Transformationswirkungen von nicht-resistiven, reziproken Anpassnetzwerken bei der Schaltungsauslegung auf die mathematisch realisierbaren zu begrenzen. Die bisherige Versuch-Irrtum-Methode ist nicht mehr erforderlich.

Darüber hinaus erlaubt das vorgestellte Verfahren, noch ohne Kenntnis einer konkreten Realisierung des durch die beschreibende Funktion f festgelegten Transformationsverhaltens, sämtliche Auswirkungen des Transformationsverhaltens auf die Kenngröße der Schaltung zu berücksichtigen.

Anstelle also für eine große Anzahl von bisherigen konkreten Anpassnetzwerken die Transformationseigenschaften bestimmen zu müssen, um so ihren Einfluss auf die Schaltungseigenschaften untersuchen zu können, ist es mit dem erläuterten Verfahren möglich, unter allen mathematisch möglichen Transformationswirkungen diejenigen auszusuchen, durch welche die Kenngröße der Schaltung optimiert wird. Die anschließende Realisierung ist auf physikalische Anpassnetzwerke mit diesen wenigen Transformationseigenschaften beschränkt. Nachfolgend soll der durch das Verfahren erzielte Fortschritt anhand eines besonders einfachen Anwendungsbeispiels erläutert werden. Hierbei wird von der Verstärkerkette ausgegangen, wie sie in Fig. 1 dargestellt ist.

Damit in einer physikalischen Realisierung der Schaltung auftretende Signalleitung die Impedanzpegel in trivialer Weise transformieren, werden das Anpassnetzwerk $M_1$ häufig dergestalt ausgelegt, dass es an seinem der Signalleitung zugewandten Ende eine Impedanz von $50\Omega$ aufweist. Zu diesem Zweck findet beispielsweise ein vektorieller Netzwerkanalysator Einsatz. Anhand von in die Schaltung eingebrachten Testanschlüssen des Netzwerkanalysators, wird die Fehlanpassung der der Signalleitung zugewandten Anschlüsse des Anpassnetzwerks $M_1$ bezüglich der $50\Omega$ minimiert.

Neben der prima facie Aufgabe dieses Optimierungsverfahrens, das erste und das zweite Anpassnetzwerk voneinander unabhängig zu machen, leistet der Stand der Technik bereits implizit ein Zweites: Bei Verwendung nicht-resistiver und reziproker Anpassnetzwerke werden die Verstärker an ihren Anschlüssen mit dem komplex Konjugierten der jeweiligen Anschlussimpedanz abgeschlossen, und mithin die Kleinsignal-Leistungsverstärkung der Schaltung maximiert.

Auch ohne die obigen Betrachtungen zum Schwarz-Pick-Theorem kann man sich unmittelbar anhand der Symmetrieeigenschaften des Transformationspfades des Anpassnetzwerkes M1 aus konzentrierten reaktiven Elementen im Smith-Diagramm hiervon überzeugen: Angewendet auf eine Ausgangsimpedanz führt das vorwärts durchlaufene Anpassnetzwerk M1 zu einer Zielimpedanz. Mit den reaktiven Elementen in umgekehrter Reihenfolge, bildet dagegen das rückwärts durchlaufene Anpassnetzwerk M1 das komplex Konjugierte der Zielimpedanz auf das komplex Konjugierte der Ausgangsimpedanz ab. Die Hintereinanderausführung der Revertierung des Anpassnetzwerks M1 und der komplexen Konjugation der Impedanzen hat eine Spiegelung des Transformationspfades an der reellen Achse, nebst Änderung des Durchlaufsinnes zur Folge.

Ist die Ausgangsimpedanz reell, beispielsweise gleich $50\Omega$, folgt damit aus der Reflexionsfreiheit am verstärkerfernen Ende des Anpassnetzwerkes M1 komplex konjugierte Anpassung am verstärkerseitigen. Häufig ist diese Anpassung auf maximale Leistungsverstärkung ausgelegt.

Soll nicht die Kleinsignal-Leistungsverstärkung, sondern beispielsweise die lineare Ausgangsleistung einer Verstärkerstufe unter der Randbedingung einer gegebenen maximalen Fehlanpassung zwischen einer $50\Omega$-Last und der in den verstärkerfernen Ausgang des Ausgangs-Anpassnetzwerks M1 hinein gesehenen Impedanz optimiert werden, ist man bisher weitgehend auf Versuch und Irrtum angewiesen: Im Anschluss an die ausgangsseitig reflexionsfreie Auslegung des Anpassnetzwerkes wird dieses bisher experimentell so lange verändert, bis die geforderten Randbedingungen erfüllt sind.

Durch das neue Verfahren wird dabei vermieden, dass von teuren und raumgreifenden nichtreziproken Schaltungselementen Gebrauch gemacht werden muss, um unabhängig auf die Transformationswirkungen des Anpassnetzwerkes sowohl in Richtung des, als auch entgegen dem Signalfluss zugreifen zu können.

Eine weitere Anwendung des Verfahren ist die Verwendung und Beurteilung von Load-Pull-Daten bei der Bestimmung der Kenngröße der Schaltung im Rahmen der Auslegung von Anpassnetzwerken: Angewandt bei einem reellen Lastreflexionsfaktor $a_{on}$ ermöglicht das Verfahren für jeden vorgegebenen transformierten Lastreflexionsfaktor $a_{on}'$ die Bestimmung der ausgangsseitigen Fehlanpassung als Funktion des transformierten Lastreflexionsfaktors $a_{on}'$.

Unter Anwendung des Verfahrens lässt sich insbesondere für den Fall eines verschwindenden Lastreflexionsfaktors $a_{on}$ eine Kreisschar angeben als Loci der transformierten Lastreflexionsfaktoren $a_{on}'$, welche unter Anwendung nicht-resistiver, reziproker Anpassnetzwerke zu einer gegebenen ausgangsseitigen Fehlanpassung führen. Hierdurch eröffnen sich erweiterte Möglichkeiten für den Einsatz von Load-Pull-Daten im Schaltungsdesign.

Wie aus der Erhaltung des Poincaré-Abstandes folgt, wird die Transformationswirkung nicht-resistiver, reziproker Anpassnetzwerke eindeutig festgelegt durch Angabe zweier Paare von je einem Bild- und einem Urbildreflexionsfaktor. Die beiden, zur Festlegung der Transformationseigenschaften genutzten Bildreflexionsfaktoren können auf der selben Seite des Anpassnetzwerkes liegen.

Wie gezeigt, ist mathematisch die Angabe der Transformationswirkung, beispielsweise anhand einer beschreibenden Funktion f, eines nicht-resistiven, reziproken Anpassnetzwerkes $M_1$ äquivalent zur Angabe der Transformationswirkung des zugehörigen revertierten Anpassnetzwerkes, beispielsweise anhand der revertierten beschreibenden Funktion $f^R$.

Dies lässt sich anwenden, um von der Festlegung der Transformationseigenschaften anhand zweier Bildreflexionsfaktoren auf der selben Seite des Anpassnetzwerkes überzugehen auf eine Festlegung der Transformationseigenschaften anhand zweier Bildreflexionsfaktoren auf unterschiedlichen Seiten des Anpassnetzwerkes und umgekehrt.

Grundsätzlich ist zu berücksichtigen, dass Bezeichner, welche Begriffe wie "Last" enthalten, keine Implikation zulassen auf die Lage der damit bezeichneten Größen relativ zu dem Anpassnetzwerk $M_1$, und gemessen mit Bezug auf die Richtung des Signalflusses innerhalb der Schaltung. Es wird daher auch die Situation umfasst, in welcher beispielsweise das als "variable Last" bezeichnete Schaltungselement, elektrotechnisch betrachtet, als eine Quelle angesehen werden kann.

In der anderen Ausführungsform erfolgt die Transformation beider Urbildimpedanzen bei Durchlaufen des Anpassnetzwerkes in derselben Richtung. Dies ist beispielsweise in der Fig. 9 anhand einer Schaltung beispielhaft dargestellt.

In einem Verfahren zur Auslegung dieser elektronischen Schaltung im Ausführungsbeispiel zur Fig. 9 soll eine zweite Kenngröße $G_2$ der Schaltung optimiert werden. Die Schaltung weist ein zweites Anpassnetzwerk $M_2$ mit einem dritten Anschluss $A_3$ und einem vierten Anschluss $A_4$ auf. Die Schaltung weist eine mit dem dritten Anschluss $A_3$ verbundene variable Last L mit einem ersten Betriebszustand off und einem zweiten Betriebszustand on aufweist. Entsprechend des zweiten und dritten Lastreflexionsfaktors $c_{off}$, $c_{on}$ ist auch die Impedanz der Last L in den beiden Betriebszuständen unterschiedlich.

Anpassung bei Parallelschaltung mehrerer Schaltungselemente

Wesentlich bei dem folgenden Ausführungsbeispiel ist zunächst für die mathematisch zulässigen, nicht-resistiven reziproken Anpassnetzwerke die Transformationswirkungen zu bestimmen, anhand dieser Transformationswirkungen den Einfluss auf Kenngrößen der Schaltungen zu ermitteln, und erst, wenn eine optimale Transformationswirkung aufgefunden ist, ein Anpassnetzwerk zu konstruieren oder ein bestehendes Anpassnetzwerk abzuwandeln, beispielsweise zur Auslegung der Anpassnetzwerke von Lastmodulationsverstärkern, insbesondere für die Parallelschaltung zweier Schaltungselemente (Verstärker).

Bei dem in der Fachwelt wohl bekanntesten Typus des Lastmodulationsverstärkers, dem Doherty-Verstärker, ist für den Pfad aus einem erstem Quellenelement $Q_1$ und einem erstem Anpassnetzwerk $M_1$ die Bezeichnung "Peak-Zweig", und für den Pfad aus einem zweitem Quellenelement $Q_2$ und zweitem Anpassnetzwerk $M_2$ die Bezeichnung "Main-Zweig" verwendbar.

Einer verbesserten Verständlichkeit geschuldet, wird das Verfahren zur Auslegung von Anpassnetzwerken $M_1$, $M_2$ im Folgenden in enger Anlehnung an den Spezialfall des Doherty-Verstärkers erläutert. Hierdurch soll in keiner Weise impliziert werden, dass das Verfahren in seiner Anwendung auf die Schaltungstopologie des Doherty-Verstärkers begrenzt ist.

Um zu betonen, dass das Verfahren weit über eine Anwendung für den Doherty-Verstärker hinausreicht, wird nachfolgendes Anwendungsbeispiel erläutert:

Anhand der Teilbilder Figuren 12 ff. wird hierbei zunächst die Nomenklatur geklärt und in die Funktionsweise eines Lastmodulationsverstärkers eingeführt.

Fig. 12 gilt für eine Schaltungstopologie eines Lastmodulationsverstärkers. Fig. 12 zeigt für die Anwendung des Lastmodulationsverstärkers im Einzelnen:

- einen Main- Verstärker $Q_2$ mit einem zweiten (Main- ) Quellreflexionsfaktor $d_{on}$,

- einen Peak- Verstärker $Q_1$ mit einem ersten (Peak- ) Quellreflexionsfaktor $b_{off}$ bei einem niedrigen Eingangs- Signalpegel und einem dritten (Peak- ) Quellreflexionsfaktor $b_{on}$ bei einem hohen Eingangs- Signalpegel,

- ein T-Stück T mit einem ersten Anschluss $E_1$ als erster Eingang, einem zweiten Anschluss $E_2$ als zweitem Eingang und einem dritten Anschluss $E_3$ als Ausgang, wobei mit dem dritten Anschluss $E_3$ des Ausgangs eine Last L mit der Lastimpedanz $Z_L$ verbunden ist,

- ein erstes Anpassnetzwerk $M_1$, das auch als Peak-Anpassnetzwerk bezeichnet werden kann, mit einem ersten Anschluss $A_1$ und einem zweiten Anschluss $A_2$, wobei der erste Anschluss $A_1$ mit dem ersten Anschluss $E_1$ des T-Stückes T und wobei der zweite Anschluss $A_2$ mit dem Peak-Verstärker $Q_1$ als erstem Quellenelement verbunden ist, und

- ein zweites Anpassnetzwerk $M_2$, das auch als Main-Anpassnetzwerk $M_2$ bezeichnet werden kann, mit einem dritten Anschluss $A_3$ und einem vierten Anschluss $A_4$, wobei der dritte Anschluss $A_3$ mit dem zweiten Anschluss $E_2$ des T-Stückes T und wobei der vierte Anschluss $A_4$ mit dem Main-Verstärker $Q_2$ verbunden ist.

In den Fig. 12 ff. sind die zuvor genannten Reflexionsfaktoren mit den entsprechenden Bezugszeichen bezeichnet.

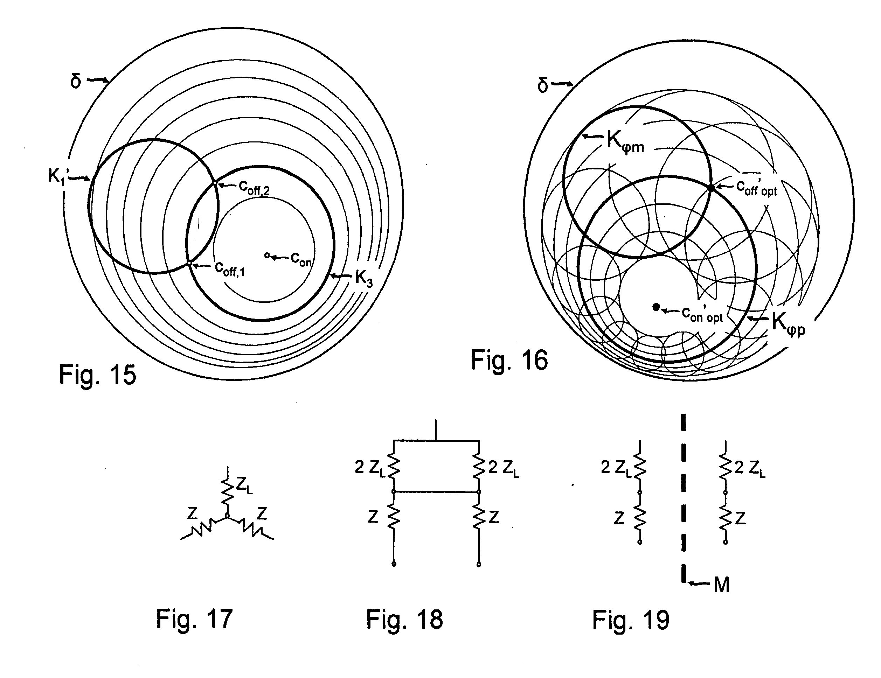

Für eine leichtere Verständlichkeit, zeigen die Figuren 17, 18, 19 in drei Teilbildern Ersatzschaltungen für ein symmetrisch getriebenes T-Stück T. In der Fig. 17 ist eine Sternschaltung aus einer Lastimpedanz $Z_L$ und zwei identischen Quellimpedanzen Z dargestellt. Die Fig. 18, zeigt eine hierzu äquivalente Schaltung, durch welche sich die Symmetrieeigenschaften leichter herausarbeiten lassen: Die Lastimpedanz $Z_L$ ist durch eine Parallelschaltung zweier identischer Impedanzen von dem doppelten Wert $2Z_L$ der Lastimpedanz $Z_L$ ersetzt worden. Bei Beaufschlagung der der Lastimpedanz $Z_L$ fernliegenden Anschlüsse der Quellimpedanzen Z mit identischen Signalen werden sämtliche Verhältnisse in der dargestellten Schaltung vollständig symmetrisch. Die Maxwell'schen Gleichungen erzwingen eine sogenannte magnetische Wand M, durch welche die Schaltung virtuell in zwei Teilschaltungen zerfällt, welche jeweils aus einer Quellimpedanz Z und einer doppelten Lastimpedanz $2Z_L$ in Serieschaltung bestehen. Diese Situation ist in Fig. 19 gezeigt.

Würde hiernach in Fig. 17 eine der beiden Quellimpedanzen Z durch einen Leerlauf ersetzt, würde das zweite Quellenelement $Q_2$ einzig die einfache Lastimpedanz $Z_L$ "sehen". Geben beide Quellenelemente $Q_1$, $Q_2$ jedoch ein gleichartiges Signal aus, so teilen sich die Quellenelemente $Q_1$, $Q_2$ den Leitwert der Lastimpedanz $Z_L$ gleichmäßig, so dass beide Quellenelemente $Q_1$, $Q_2$ mit der Quellimpedanz Z die doppelte Lastimpedanz $2Z_L$ erfahren, entsprechend Fig. 19.

Bei einem Doherty- Verstärker wird typischerweise der Peak- Zweig in Klasse C betrieben. Bei niedrigen Eingangs- Signalpegeln ist der Peak- Zweig daher abgeregelt. Bei einer hierfür geeigneten Auslegung des ersten (Peak- ) Anpassnetzwerkes $M_2$ stellt dieses am ersten Anschluss $A_1$ als ersten transformierten (Peak- ) Quellreflexionsfaktor $b_{off}'$ in einem ersten Betriebszustand off einen Leerlauf zur Verfügung, der Main- Verstärkerzweig hängt allein an dem Leitwert der Lastimpedanz $Z_L$.

Bei hohen Eingangs-Signalpegeln in einem zweiten Betriebszustand on hingegen wird der Peak-Verstärkerzweig dynamisch aufgesteuert. Er fügt ein Signal, das dem von Main-Verstärkerzweig an dem zweiten Anschluss $E_2$ des T-Stückes T erzeugten Signals ähnlich ist, an dem ersten Anschluss $E_1$ des T-Stückes T hinzu. Beide Verstärkerzweige teilen sich den Leitwert der Lastimpedanz $Z_L$: Aufgrund des dynamischen Aufsteuerns des in Klasse C betriebenen Peak-Verstärkerzweiges werden der für den Main-Verstärkerzweig wirkende (zweite/dritte) (Main-) Lastreflexionsfaktor $c_{off}$, $c_{on}$ und somit der (zweite/dritte) transformierte (Main-) Lastreflexionsfaktor $c_{off}'$, $c_{on}'$ moduliert.

Ein Zwischenergebnis sowie die sich aus den beiden Zwischenergebnissen abzuleitenden Schlüsse werden nachfolgend anhand der Fig. 15 erläutert.

In Fig. 15 ist im Einzelnen dargestellt:

- der Rand $\delta$ des Einheitskreises in der Reflexionsfaktorebene,

- der geometrischen Ort $K_1'$ aller Reflexionsfaktoren, welche durch die Parallelschaltung der Lastimpedanz $Z_L$ mit jeweils einer weiteren Impedanz bestimmt werden, wobei jede weitere Impedanz einem Reflexionsfaktor auf dem ersten Poincaré-Kreis $K_1$ gemäß Fig. 13 zugehörig ist, zur Lastimpendanz $Z_L$ und doppelten Lastimpedanz $2Z_L$, ist auf Fig. 18 verwiesen,

- der Reflexionsfaktor $c_{on}$, der der doppelten Lastimpedanz $2Z_L$ zugehörig ist,

- dünn gezeichnet und ohne Bezugszeichen, eine im Poincaré'schen Sinne konzentrische Schar von Poincaré-Kreisen um den der doppelten Lastimpedanz $2Z_L$ zugehörigen Reflexionsfaktor $c_{on}$,

- fett hervorgehoben, einen dritten Poincaré-Kreis $K_3$ aus der Schar von Poincaré-Kreisen, sowie

- zwei Schnittpunkte $c_{off,1}$, $c_{off,2}$ zwischen dem fett hervorgehobenen dritten Poincaré-Kreis $K_3$ aus der Schar von Poincaré-Kreisen und dem geometrischen Ort $K_1$', wie zuvor erläutert.

Gemäß dem ersten Zwischenergebnis liegen gemäß Fig. 13 alle zulässigen Werte y' für den ersten Lastreflexionsfaktor $a_{on}$ auf dem geometrischen Ort $K_1$' und gemäß dem zweiten Zwischenergebnis zudem auf dem dritten Poincaré-Kreis $K_3$.

Bei Kenntnis eines für den Einsatzbereich des Peak- Verstärkers $Q_1$ der Fig. 12 angestrebten transformierten ersten (Peak- ) Lastreflexionsfaktor $a_{on}$' legt dieser zusammen mit der Lastimpedanz $Z_L$ den geometrische Ort $K_1$' fest.

Bei Kenntnis von für den gewünschten Einsatzbereich des Main- Verstärkers $Q_1$ gewünschten transformierten zweiten und dritten (Main- ) Lastreflexionsfaktoren $c_{off}$', $c_{on}$' legt dieser zusammen mit dem Wert der Lastimpedanz $Z_L$ auch den dritten Poincaré- Kreis $K_3$ fest.

Es ergeben sich als zulässige Werte für den zweiten (Main- ) Lastreflexionsfaktor $c_{off}$ lediglich die zwei Schnittpunkte $c_{off,1}$, $c_{off,2}$ des festliegenden geometrischen Ortes $K_1$' und des festliegenden dritten Poincaré- Kreises $K_3$.

Beispielsweise ist die Kenngröße der Schaltung eine Quadratsumme eines ersten und eines zweiten geometrischen Abstands. Dabei ist der erste geometrische Abstand zwischen einem beliebigen Reflexionsfaktor und dem dritten Poincare- Kreises $K_3$ definiert. Der zweite geometrische Abstand ist hingegen zwischen dem beliebigen Reflexionsfaktor und dem geometrischen Ort $K_1$' definiert. Hierdurch wird der zweite (Main- ) Lastreflexionsfaktor $c_{off}$ weitgehend festgelegt. Hiermit sind auch der erste, dem Main- Verstärkerzweig zugehörige zyklische Freiheitsgrad sowie der zweite, dem Peak- Verstärkerzweig zugehörige zyklische Freiheitsgrad, und hiernach die vollständigen beschreibenden Funktionen beider Anpassnetzwerke $M_1$, $M_2$, weitgehend bestimmt.

Zusätzlich zu den sich aus dem Erläuterten ergebenden Einschränkungen an mögliche Wertepaare aus einem transformierten zweiten (Main- ) Lastreflexionsfaktor $c_{off}$' und einem transformierten dritten (Main- ) Lastreflexionsfaktor $c_{on}$' wird die weitgehende Festlegung der beschreibenden Funktionen mit Hilfe der Fig. 16 näher erläutert:

Fig. 16 zeigt dabei:

- den Rand $\delta$ des Einheitskreises in der Reflexionsfaktorebene,

- einen dritten Wert $c_{on}'_{opt}$ eines transformierten dritten (Main- ) Lastreflexionsfaktor $c_{on}$',

- dünn gezeichnet und ohne Bezugszeichen, eine erste Schar von (im Poincaré'schen Sinne) konzentrischen Poincaré-Kreisen um den dritten Wert $c_{on}'_{opt}$, ein ringförmiges Gebiet im Inneren des Einheitskreises überstreichend,

- ebenfalls dünn gezeichnet eine zweite Schar von Kreisen, deren jeder den inneren und den äußeren Rand des ringförmigen Gebietes berührt,

- einen zweiten Wert $c_{off}'_{opt}$ eines transformierten zweiten (Main- ) Lastreflexionsfaktor $c_{off}$',

- fett hervorgehoben, je einen Kreis $K_{\varphi p}$ aus der ersten Schar und einen Kreis $K_{\varphi m}$ aus der zweiten Schar, wobei sich die hervorgehobenen Kreise schneiden im zweiten Wert $c_{off}'_{opt}$.

Es beginnt die Entwicklung eines Lastmodulationsverstärkers von Doherty-Typus mit der Bestimmung des Einflusses der Werte der transformierten Lastreflexionsfaktoren auf die einzusetzenden Main- und Peak-Verstärker. Hierzu werden Load-Pull-Messungen von Größen wie dem Gang der Großsignal-Leistungsverstärkung mit der Ausgangsleistung durchgeführt. Aus den Load-Pull-Messungen lassen sich, lastreflexionsfaktorabhängig, beispielsweise ein Kompressionsverhalten oder eine Effizienz der Leistungsverstärkung bei einer gegebenen Kompression messen. Anhand dieser Messungen kann eine optimale Last unter Vollaussteuerung festgelegt werden, beispielsweise als eine Last, durch die eine Kompressionsleistung bei einer Betriebsfrequenz maximiert wird. Ebenso lässt sich der Messung eine Zielimpedanz entnehmen, welche für den Main-Verstärker unter moderaten Eingangspegeln anzustreben ist. Dies ist beispielsweise eine Last, durch die eine Effizienz der Leistungsverstärkung bei einem gegebenen Bruchteil der maximalen Kompressionsleistung bei der gegebenen Betriebsfrequenz maximiert wird. Im Verfahren zur Auslegung der Anpassnetzwerke in einem Doherty-Verstärker ist man in einem ersten Verfahrensschritt bestrebt, in beiden Verstärkerpfaden zu bewirken, dass die zweifache (reelle) Lastimpedanz in die optimale Last unter Vollaussteuerung transformiert wird. In einem weiteren Verfahrensschritt wird, durch Einfügen einer Leitung geeigneter Länge mit einer Leitungsimpedanz gleich der Lastimpedanz zwischen dem Peak-Anpassnetzwerk und dem T-Stück, die transformierte Peak-Quellimpedanz unter niedrigen Eingangs-Signalpegeln so gut also möglich auf einen Leerlauf gedreht. Hierdurch werden die Verluste minimiert, welche das Signal des Main-Verstärkerpfades am T-Stück erfährt. Dabei geht ein Teil der Signalleistung in den Ausgang des Peak-Verstärkerzweiges verloren. Beschränkt man sich auf nicht-resistive, reziproke Anpassnetzwerke im Main- wie im Peak-Verstärkerzweig, so verfügen beide über je drei Freiheitsgrade.

Anhand der Fig. 12 bis Fig. 15 ergibt sich für den vorherrschenden Fall reeller Lastimpedanzen $Z_L$ der Last L, dass der kleinstmögliche Kreis aus der Schar konzentrischer Kreise in Fig. 15 gesucht ist, wobei der kleinstmögliche Kreis ($K_3$) den geometrischen Ort $K_1'$ schneidet. Dabei ist der Poincaré-Radius der konzentrischen Kreise der Fig. 15 durch den dritten Poincaré-Abstand $P_3$ zwischen den transformierten zweiten und dritten (Main-) Lastreflexionsfaktoren $c_{off}'$, $c_{on}'$ gegeben.

Gegenüber bisherigen Verfahren zur Auslegung von Lastmodulationsverstärkern bei dem die Signalveriuste bei niedrigen Eingangspegeln minimiert werden, wird durch das Ausführungsbeispiel der Figuren 12 bis 16 der Vorteil erzielt, dass nicht zugleich der erzielbare Hub minimiert wird.

Ein festgelegter dritter Poincaré-Abstand $P_3$ zwischen dem transformierten zweiten und dritten (Main-) Lastreflexionsfaktor $c_{off}'$, $c_{on}'$ hat- wie zuvor erläutert- einen festliegenden Satz von möglichen Werten für den dem Peak-Verstärkerzweig zugehörigen zyklischen Freiheitsgrad zur Folge. Die konzentrischen Kreise in Fig. 16 entsprechen einem jeweils festen Poincaré-Abstand zwischen dem transformierten zweiten und dritten (Main-) Lastreflexionsfaktor $c_{off}'$, $c_{on}'$ und mithin einem festen Wert des dem Peak-Verstärkerzweig zugehörigen zyklischen Freiheitsgrades.

Entsprechend wird, bei festliegendem Wert des dritten transformierten (Main-) Lastreflexionsfaktors $c_{on}'$, und mithin zwei ausgeschöpften Freiheitsgraden für das zweite (Main-) Anpassnetzwerk $M_1$, die Lage der möglichen Werte für den transformierten zweiten (Main-) Lastreflexionsfaktor $c_{off}'$ auf einem festen Kreis unter den konzentrischen Kreisen der Fig. 15 und somit festgelegtem, dem Peak-Verstärkerzweig zugehörigen zyklischen Freiheitsgrad durch den einzigen im Anpass-System verbleibenden, dem Main-Verstärkerzweig zugehörigen zyklischen Freiheitsgrad bestimmt: Entlang der konzentrischen Kreise ist der dem Peak-Verstärkerzweig zugehörige zyklische Freiheitsgrad jeweils fest, der dem Main-Verstärkerzweig zugehörige zyklische Freiheitsgrad variabel.

Umgekehrtes gilt für die zweite Schar von Kreisen: Diese entsprechen jeweils einem festen Wert des dem Main-Verstärkerzweig zugehörigen zyklischen Freiheitsgrad, während ein Ort entlang eines der Kreise der zweiten Schar durch den variablen, dem Peak-Verstärkerzweig zugehörigen zyklischen Freiheitsgrad parametrisiert wird.

Gegenüber einer experimentellen Optimierung weist das vorliegende Ausführungsbeispiel den Vorteil der Nutzung aller Freiheitsgrade auf.

Zunächst werden im vorliegenden Ausführungsbeispiel anhand von Load-Pull-Messungen optimale Lastimpedanzen für beide Betriebsfälle (hoher bzw. niedriger Eingangs-Signalpegel) ermittelt. Für ein einfachere Erläuterung, jedoch ohne das erfindungsgemäße Verfahren hierauf zu beschränken, wird nachfolgend zunächst davon ausgegangen, dass bei der Auslegung von Main- und Peak-Anpassnetzwerk $M_2$, $M_1$ nach dem Verfahren des Ausführungsbeispiels ebenfalls zunächst die Werte der transformierten Lastreflexionsfaktoren bei hohen Eingangs-Signalpegeln für eine maximale Spitzenleistung bestimmt werden. Dabei verbleiben die beiden zyklischen Freiheitsgrade.

Im vorliegenden Ausführungsbeispiel der Fig. 16 werden beide zyklischen Freiheitsgrade genutzt, um den transformierten zweiten (Main-) Lastreflexionsfaktor $c_{off}'$ frei in dem von der konzentrischen Kreis-Schar der Fig. 16 überstrichenen Bereich bestimmen zu können. Beispielsweise wird der zweite (Main-) Lastreflexionsfaktor $c_{off}$ bestimmt, um eine Effizienz bei einem gewünschten Bruchteil der maximalen Ausgangsleistung zu optimieren. Hierdurch wird der Vorteil erzielt, dass die bewirkte Effizienzsteigerung unter niedrigen Eingangs-Signalpegeln gegenüber einer Effizienzminderung aufgrund zusätzlicher Verluste durch ein in Kauf genommenes weiteres Abweichen des transformierten ersten (Peak-) Quellreflexionsfaktors $b_{off}'$ von einem Leerlauf bei weitem überwiegt.

Darüber hinaus wird durch das Verfahren in dem vorliegenden Ausführungsbeispiel ein weiterer Vorteil erzielt: Mithilfe des Verfahrens lassen sich für beliebige Tripel aus

- einem transformierten zweiten (Main-) Lastreflexionsfaktor $c_{off}'$,

- einem transformierten dritten (Main-) Lastreflexionsfaktor $c_{on}'$ und

- einem transformierten ersten (Peak-) Lastreflexionsfaktor $a_{on}'$

die vollständigen Transformationseigenschaften des Main- und des Peak-Anpassnetzwerkes $M_2$, $M_1$ bereits vor der Kenntnis einer physikalischen Realisierung dieser Transformationseigenschaften in einer konkreten Schaltung bestimmen.

Unter Zuhilfenahme der Messung zugänglicher erster und dritter (Peak-) Quellreflexionsfaktoren $b_{off}$, $b_{on}$ sowie eines ebenfalls messtechnisch zu erfassenden zweiten (Main-) Quellreflexionsfaktors $d_{on}$ lassen sich, bei Kenntnis der beschreibenden Funktionen von den (Peak- und Main-) Anpassnetzwerk $M_1$, $M_2$, sofort die Impedanzpegel an dem T-Stück T unter beiden Betriebsbedingungen, und mithin die Kombinationsverluste, rechentechnisch erfassen.

Ausgehend von Load-Pull-Messungen der elektrischen Eigenschaften des Peak- und des Main-Verstärkers $Q_1$, $Q_2$, erlaubt das Verfahren des vorliegenden Ausführungsbeispiels demzufolge die Bestimmung der elektrischen Eigenschaften - beispielsweise von Gain und Effizienz in Abhängigkeit von der Ausgangsleistung - für einen aus dem Peak- und dem Main-Verstärker $Q_1$, $Q_2$ zusammengesetzten Lastmodulationsverstärker, in Abhängigkeit von dem genannten beliebigen Tripel von Reflexionsfaktoren.

Somit lassen sich, selbst ohne konkrete Realisierungen der Anpassnetzwerke $M_1$, $M_2$ anzugeben, zuerst die Eigenschaften des Lastmodulationsverstärkers anhand der beschreibenden Funktionen der Anpassnetzwerke $M_1$, $M_2$ optimieren. Erst, nachdem ein bestmögliches Paar beschreibender Funktionen aufgefunden ist, erfolgt die Konstruktion des zugehörigen idealen Paares von Anpassnetzwerken $M_1$, $M_2$. Das Verfahren ist dabei vollständig automatisiert, beispielsweise basierend auf einem automatischen Load-Pull-Messsystem.

Die Beschränkung der Darstellung anhand der erläuternden Figuren auf den symmetrischen Fall dient alleine einer vereinfachten Darstellung. Die Gültigkeit und Anwendbarkeit der Ausführungsbeispiele des Verfahrens für die Auslegung nicht-symmetrischer Lastmodulationsverstärker bleibt hiervon unberührt. Beispielsweise ist das Verfahren der Ausführungsbeispiele unmittelbar auf Lastmodulationsverstärker mit ungleichem Teilerverhältnis anwendbar. Ebenfalls ist es möglich die erläuterten Ausführungsbeispiele auf Mehrwege-Lastmodulationsverstärker anzuwenden.

Ein weiteres Ausführungsbeispiel eines Verfahrens ist zur Auslegung von Anpassnetzwerken für eine verlustarme Leistungsaddition anhand der Fig. 22 vorgesehen. In einem als Summierglied eingesetzten T-Stück T seien ein erstes Quellenelement $Q_1$ mit einem ersten Quellreflexionsfaktor b über ein erstes Anpassnetzwerk $M_1$ mit einem ersten Anschluss $E_1$ eines T-Stückes T verbunden. Ein zweites Quellenelement $Q_2$ ist mit einem zweiten Quellreflexionsfaktor d über ein zweites Anpassnetzwerk $M_2$ mit einem zweiten Anschluss $E_2$ des T-Stückes T verbunden. Eine Last L mit einer Lastimpedanz ist mit einem dritten Anschluss $E_3$ des T-Stückes T verbunden.

Im Fall identischer Quellreflexionsfaktoren b, d und phasen- und leistungsgleicher Anregung der Eingänge eines T-Stückes T sind beide Eingänge durch die Symmetrie gegeneinander isoliert. Sind die Quellimpedanzen ferner gleich der zweifachen Lastimpedanz der Last L, erfolgt die Leistungsaddition reflexions- und verlustfrei.

Die obigen Ausführungen aufgreifend, ist, bei reeller Lastimpedanz $Z_L$, eine Identität der Quellimpedanzen und der zweifachen Lastimpedanz genau dann gegeben, wenn als Quellen zwei im Punkt maximaler Kleinsignal-Leistungsverstärkung betriebene Verstärkerzweige eingesetzt werden.

Für die verlustfreie Addition beispielsweise der Ausgangssignale zweier identischer, jedoch in ihrem jeweiligen Leistungsoptimum betriebener Verstärkerzweige ist der weitestgehend unabhängige Zugriff auf die Transformationswirkung eines Anpassnetzwerkes $M_1$, $M_2$ in Richtung des (Vorwärtsrichtung V), sowie entgegen (Rückwärtsrichtung R) dem Signalfluss, wünschenswert. Dabei bedeutet der unabhängige Zugriff, dass beide Anpassnetzwerke $M_1$, $M_2$ unterschiedlich transformieren dürfen.

Einen derartigen, weitestgehend unabhängigen, Zugriff, und damit ein Entwurfsverfahren zur Auslegung der Anpassnetzwerke $M_1$, $M_2$ zweier paralleler, über ein T-Stück T zusammenzuführender Verstärkerzweige, ermöglicht ein weiteres vorteilhaftes Ausführungsbeispiel, welches nachfolgend unter Rückgriff auf Fig. 22 erläutert ist.

In einem konkreten möglichen Anwendungsfall des Verfahrens wird ausgegangen von

- einem ersten Leistungsverstärker als erstem Quellenelement $Q_1$,

- einem zweiten Leistungsverstärker als zweitem Quellenelement $Q_2$,

- einem ersten transformierten Lastreflexionsfaktor a' und

- einem zweiten transformierten Lastreflexionsfaktor c'.

Der erste Wert $a'_{opt}$ ist hierbei ein Ziel-Wert für den ersten transformierten Lastreflexionsfaktor a'. Er kann, zu Beginn der Auslegung der Schaltung, beispielsweise bestimmt werden, indem an dem ersten Quellenelement $Q_1$ Messungen an einem Load-Pull-Messplatz durchgeführt werden. Beispielsweise wird ein eine Effizienz einer Leistungsverstärkung des ersten Quellenelementes $Q_1$ bei einer Kompression der Leistungsverstärkung über der Ausgangsleistung von einem Dezibel optimierender wünschenswerter Wert für den ersten transformierten Lastreflexionsfaktor a' ermittelt, welcher als erster Wert $a'_{opt}$ bestimmt wird.

Beispielsweise wird anhand von Messungen an dem zweiten Quellenelement $Q_2$ der zweite Wert $c'_{opt}$ als Ziel-Wert des zweiten transformierten Lastreflexionsfaktors c' bestimmt.

Für den Fall, dass der erste Wert a'$_{opt}$ von dem komplex Konjugierten b* des ersten Quellreflexionsfaktors b abweicht (das erste Quellenelement Q$_1$ folglich nicht in dem Maximum seiner Kleinsignal-Leistungsverstärkung betrieben werden soll), wird für ein aus dem ersten Quellenelement Q$_1$ ausgegebenes Signal bei dem Übergang von dem ersten Anpassnetzwerk M$_1$ zu dem T-Stück T ein Reflexionsverlust verursacht.

Sind bei der Auslegung des ersten und des zweiten Anpassnetzwerkes M$_1$, M$_2$ das erste und das zweite Quellenelement Q$_1$, Q$_2$ nicht gegeneinander isoliert, so wird das aus dem ersten Quellenelement Q$_1$ ausgegebene Signal, welche zu der Last L übertragen wird, abgeschwächt, indem ein Teil der Signalleistung im zweiten Ausgang verloren geht. Bei der Auslegung der Anpassnetzwerke M$_1$, M$_2$ gemäß dem erläuterten Ausführungsbeispiel werden diese Verluste minimiert, während zudem von den die Quelleigenschaften optimierenden Werten a'$_{opt}$, c'$_{opt}$ nur geringfügig abgewichen wird.

Erst durch das vorliegende Ausführungsbeispiel, die in den Ausgang eines Anpassnetzwerkes M$_1$, M$_2$ hinein "gesehenen" Reflexionsfaktoren in einer Weise auf einem Poincaré-Kreis zu bestimmen, erlaubt es, in einer konstruktiven Weise zu Anpassnetzwerken M$_1$, M$_2$ zu gelangen. Dabei werden durch die Anpassnetzwerke M$_1$, M$_2$ gleichzeitig die Verluste minimiert und von den die Quelleigenschaften optimierenden Reflexionsfaktorenwerten a'$_{opt}$, c'$_{opt}$ nur geringfügig abgewichen.

Im Hinblick auf möglichst hohe Einfachheit der Darstellung wird die Herleitung anhand einer reellen Eingangsimpedanz der Last erläutert, ohne dass hierdurch das Verfahren auf reelle Lastimpedanzen beschränkt ist. Beispielsweise wird die (nicht nötigerweise reelle) Lastimpedanz als Referenzimpedanz der Reflektionsfaktoren bestimmt. In diesem Fall ist es zumeist vorteilhaft, den Quotienten aus der Differenz einer Impedanz und der Bezugsimpedanz als Dividend, und die Summe aus der Impedanz und dem komplex Konjugierten der Bezugsimpedanz als Divisor zu wählen. Der Reflexionsfaktor zu der (nicht notwendig, reellen) Lastimpedanz ist reell, wir können in der Darstellung der Impedanzen von Bildern mit endlichem, auf solche mit verschwindendem Imaginärteil einzelner Reflexionsfaktoren überwechseln.

Man erhält eine verlustfreie Leistungsaddition, wenn der erste Quellverstärker als erstes Quellenelement Q$_1$ und das erste Anpassnetzwerk M$_1$, sowie der zweite Quellverstärker als zweites Quellenelement Q$_2$ und das zweite Anpassnetzwerk M$_2$ bei geeigneter Signalbeaufschlagung am ersten und am zweiten Eingang des T-Stückes T phasengleiche Signale identischer Amplituden bewirken, und die transformierte erste Ausgangsimpedanz des ersten Quellenelements Q$_1$ gleich der transformierten zweiten Ausgangsimpedanz des zweiten Quellenelements Q$_2$ gleich der doppelten Lastimpedanz ist.

Zwischen der ersten Ausgangsimpedanz des ersten Anpassnetzwerkes M$_1$ und der in den ersten Eingang des T-Stückes T hinein gemessenen Eingangsimpedanz herrscht Reflexionsfreiheit genau dann, wenn der erste Quellverstärker Q$_1$ ausgangsseitig im Maximum seiner Kleinsignal-Leistungsverstärkung betrieben wird.

Genauso herrscht Reflexionsfreiheit zwischen der zweiten Ausgangsimpedanz des zweiten Anpassnetzwerkes M$_2$ und der in den zweiten Eingang des T-Stückes T hinein gemessenen Eingangsimpedanz genau dann, wenn der zweite Quellverstärker Q$_2$ ausgangsseitig im Maximum seiner Kleinsignal-Leistungsverstärkung betrieben wird.

Nach dem Vorgesagten erzwingt verlustfreie Leistungsaddition nach dem Stand der Technik einen Betrieb des ersten und des zweiten Quellverstärkers in den jeweiligen Maxima der Kleinsignal-Leistungsverstärkungen.

Untersuchungen des Anmelders haben ergeben, dass sich ein erstes Sinus-Signal eines ersten Signalpegels eines ersten Quellverstärkers Q$_1$ und ein zweites Sinus-Signal des ersten Signalpegels eines zweiten Quellverstärkers Q$_2$ sich bei einer geeigneten Wahl der relativen Phase des ersten und des zweiten Sinussignals genau dann verlustfrei an einem reziproken T-Stück T überlagern lassen, wenn zunächst die Quellkonduktanzen 1/Z1, 1/Z2 gleich der halben Lastkonduktanz 1/Z$_L$ ist,

$$\mathrm{Re}\left(\frac{1}{Z_1}\right) = \mathrm{Re}\left(\frac{1}{Z_2}\right) = \mathrm{Re}\left(\frac{1}{2Z_L}\right), \tag{56}$$

während sich gleichzeitig die Imaginärteile der Admittanzen in der Summe aufheben:

$$\mathrm{Im}\left(\frac{1}{Z_1}\right) = -\mathrm{Im}\left(\frac{1}{Z_2}\right). \tag{57}$$

In beiden Gleichungen bezeichnet Z$_1$ die eine, Z$_2$ die andere an dem T-Stück erfahrene Quellimpedanz, während Z$_L$ für die Lastimpedanz steht. Insbesondere sind Z$_1$ und Z$_2$ komplex konjugiert zueinander. Im Grenzfall verschwindenden Imaginärteiles von Quellen und Lasten spezialisieren sich die beiden Formeln auf die Lösung für die Impedanzen nach dem vormaligen Stand der Technik. Geometrisch anschaulich bedeuten die Formeln, dass die beiden Quellimpe-

danzen $Z_1$, $Z_2$ auf einem gemeinsamen Konduktanzkreis mit der doppelten Lastimpedanz liegen.

Bei den angegebenen Werten der Quellkonduktanzen $1/Z_1$, $1/Z_2$ sowie einer geeigneten Phasenlage beider Quellsignale zueinander verschiebt sich aufgrund der Lastmodulation durch das Signal des jeweils anderen Quellzweiges der Eingangsreflexionsfaktor eines jeden Eingangs des T-Stückes T zu dem Wert des transformierten Quellreflexionsfaktors: Bei verlustloser Addition der Quellsignale im T-Stück T löschen sich die vom ersten Quellenelement ausgegebenen, am ersten Eingang des T-Stückes T zurückreflektierten Signalanteils und die vom zweiten Quellenelement $Q_2$ ausgegebenen und durch den ersten Eingang des T-Stückes T in den ersten Signalpfad laufenden Signalanteile gegenseitig aus. Die gesamte abgegebene Leistung beider Quellenelemente $Q_1$, $Q_2$ wird an die Last L abgegeben. Vorzugsweise werden also zunächst beide Quellenelemente $Q_1$, $Q_2$ im Maximum ihrer Kleinsignal-Leistungsverstärkung betrieben.

Der erste transformierte Quellreflexionsfaktor b' und der zweite transformierte Quellreflexionsfaktor d' weisen jedoch wesentlich unterschiedliche Werte auf. Diese Eigenschaft bleibt erhalten, wenn man stetig abweicht von komplex konjugierter Anpassung am Ausgang der Quellenelemente $Q_1$, $Q_2$. Beispielsweise werden ausgangsseitige Abschlussbedingungen vorgegeben, die eine Quelleffizienz optimieren.

Durch den nichtverschwindenden Imaginärteil der transformierten Quellreflexionsfaktoren b', d' und der gebrochenen Symmetrie der das T-Stück T umfassenden Schaltung, weicht auch der erste Lastreflexionsfaktor a wesentlich von dem der doppelten Lastimpedanz $2Z_L$ zugeordneten Reflexionsfaktor, ebenso wie von dem zweiten Lastreflexionsfaktor c ab.

Zum Ausführungsbeispiel der Fig. 22 wird zunächst aus den Quellrelfexionsfaktoren b, d und dem bekannten Paar ermittelter transformierter Lastreflexionsfaktoren a', c' ein neues, nur leicht von dem bekannten Paar abweichendes Paar von leicht veränderten Lastreflexionsfaktoren $a'_{est}$, $c'_{est}$ bestimmt, welches mit den mathematischen Einschränkungen an die Transformationswirkung nicht-resistiver reziproker Anpassnetzwerke $M_1$, $M_2$ kompatibel ist. Das neue Paar von variierten Lastreflexionsfaktoren $a'_{est}$, $c'_{est}$ erlaubt bei geeigneter Wahl der relativen Phasenlagen der überlagerten Signale aus beiden Quellenelementen $Q_1$, $Q_2$, eine weitgehend verlustfreie Leistungsaddition am T-Stück T.

Bildet beispielsweise das erste Anpassnetzwerk $M_1$ den ersten Lastreflexionsfaktor a auf den (die Eigenschaften des ersten Quellenelements $Q_1$ optimierenden) ersten Wert $a'_{est}$ ab, so liegt der transformierte erste Lastreflexionsfaktor a' auf einem Poincaré-Kreis um das komplex Konjugierte b* des ersten Quellreflexionsfaktors b. Entsprechendes gilt für den transformierten zweiten Lastreflexionsfaktor c'.

Das Ziel ist eine möglichst verlustfreie Leistungsaddition. Voraussetzung hierfür ist, dass der transformierte erste und der zweite Quellreflexionsfaktor b', d' zueinander komplex konjugiert sind. Eine weitere Voraussetzung ist, dass beide den selben Poincaré-Abstand von dem Reflexionsfaktor aufweisen, der dem komplex Konjugierten $2Z_L{}^*$ der doppelten Lastimpedanz $2Z_L$ entspricht, wobei der erste und der zweite Reflexionsfaktor gleich sind.

Aufgrund der in Fig. 5 dargestellten allgemeinen Eigenschaften nicht-resistiver, reziproker Anpassnetzwerke erfordert dies zwingend den dritten Abstand $P_3$ - also den Poincaré-Abstand des transformierten ersten Lastreflexionsfaktors a' von dem komplex Konjugierten b* des ersten Quellreflexionsfaktors b1 - und den gleichen vierten Abstand $P_4$ - also den Poincaré-Abstand des transformierten zweiten Lastreflexionsfaktors c' von dem komplex Konjugierten b* des zweiten Quellreflexionsfaktors b.

Um eine geringstmöglich Abweichung der transformierten Lastreflexionsfaktoren a', c' von den die Quelleigenschaften optimierenden Reflexionsfaktoren zu erzielen, und zugleich weitgehend verlustlose Leistungsaddition am T-Stück T zu erhalten, ist man auf einen technischen Kompromiss angewiesen:

In Fig. 23 ist für die Darstellung der Fall des dritten Abstandes $P_3$ gleich dem vierten Abstand $P_4$ gewählt. Für diesen Wert des dritten und des vierten Abstandes $P_3$, $P_4$ ergibt sich ein minimaler Abstand zwischen beispielsweise dem ersten Wert $a'_{opt}$ und dem dritten Wert $a'_{est}$, wenn der transformierte erste Lastreflexionsfaktor a' auf einer den ersten Wert $a'_{opt}$ und das komplex Konjugierte b* des ersten Quellreflexionsfaktors b in einem ersten Abstand $P_1$ von dem ersten Wert $a'_{opt}$ bestimmt werden. Dasselbe gilt für die Bestimmung des transformierten zweiten Lastreflexionsfaktors c' und des zweiten Wertes $c'_{opt}$.

Durch Variation des dritten und des ihm gleichen vierten Abstandes $P_3$, $P_4$ werden der Abstandwert $P_{aus}$ sowie der erste Wert $a'_{opt}$ des transformierten ersten Lastreflexionsfaktors a' und der zweite Wert $c'_{opt}$ des transformierten zweiten Lastreflexionsfaktors c' bestimmt. Die Bestimmung des ersten Wertes und des zweiten Wertes erfolgt, indem das geometrische Mittel aus dem ersten und dem zweiten Abstand $P_1$, $P_2$ minimiert wird.

Durch die weiteren Verfahrensschritte werden, wie zuvor erläutert, die Verluste minimiert, während zudem geringstmöglich von dem ersten Wert $a'_{opt}$ und zweiten Wert $c'_{opt}$ abgewichen wird.

Für die Ausführungsbeispiele zum Verfahren zur Auslegung von Anpassnetzwerken, lassen sich die wesentlichen Schritte wie folgt zusammenfassen:

- Tätigung eines Ansatzes für eine die Transformationswirkung des Anpassnetzwerkes $M_1$, $M_2$ beschreibende Funktion als Isomorphismus der Einheitskreisscheibe in der Reflexionsfaktorebene,

- Ausnutzung der Invarianz des Poincaré-Abstandes zweier Reflektionsfaktoren unter den von diesem Ansatz umfassten Anpassnetzwerken $M_1$, $M_2$ zur Festlegung einer die Schaltungseigenschaften optimierenden Transformationswirkung,

- Bestimmung eines Anpassnetzwerkes $M_1$, $M_2$, das eine die Schaltungseigenschaften optimierende Transformationswirkung aufweist.

Elektrotechnisch entspricht der erste Punkt einer Beschränkung auf nicht-resistive, reziproke Anpassnetzwerke $M_1$, $M_2$:

Die Transformationswirkung nicht-reziproker Anpassnetzwerke $M_1$, $M_2$ kann einen endlichen Defekt aufweisen, das heißt, einen nicht-trivialen Unterraum der Reflexionsfaktorebene auf Null abbilden. In diesem Falle ist sie höchstens ein Isomorphismus eines Unterraumes der Reflexionsfaktorebene, nicht jedoch des Einheitskreises. Als Beispiel hierfür diene die die Transformationswirkung eines zweipoligen Isolators beschreibende Abbildungsmatrix, eine 2x2-Matrix mit einer Eins auf dem ersten Hauptdiagonalelement und Nullen an den anderen drei Stellen.

Resistive Anpassnetzwerke hingegen bilden einzelne Reflexionsfaktoren mit einem Betrage größer Eins ("aktive Punkte") in die Einheitskreisscheibe ("passive Punkte") ab. Daher kann die Transformationswirkung resistiver Anpassnetzwerke zwar weiterhin bijektiv sein, aber im Allgemeinen kein Isomorphismus der Einheitskreisscheibe.

Für alle Automorphismen der komplexen Einheitskreischeibe jedoch gilt aufgrund des Schwarz- Pick- Theorems, dass sie den Poincaré- Abstand erhalten. Wie anhand mehrere Beispiele gezeigt, lässt sich diese Invarianz vorteilhaft einsetzen, um Transformationseigenschaften von Anpassnetzwerken $M_1$, $M_2$ zu bestimmen, durch die Schaltungseigenschaften optimiert werden, sofern die Schaltungseigenschaften von der Transformation mehr als eines Reflexionsfaktors durch das Anpassnetzwerk $M_1$, $M_2$ abhängen.

Schließlich werden durch Anwendung des Verfahrens der Ausführungsbeispiele automatisch lediglich derartige, die Schaltungseigenschaften optimierende Transformationswirkungen bestimmt, welche die Poincaré-Abstände zweier Punkte invariant lassen, so dass sich die Optimierung ausschließlich auf durch nicht-resistive, reziproke Anpassnetzwerke $M_1$, $M_2$ realisierbare Transformationswirkungen erstreckt. Im dritten Punkt des Verfahrens wird ein derartiges Anpassnetzwerk $M_1$, $M_2$ angeben, welches sich durch die gewünschten Transformationseigenschaften auszeichnet.

Die erhaltenen Anpassnetzwerke lassen sich hiernach dadurch charakterisieren, dass unter Ausnutzung der Invarianz des Poincaré-Abstandes zweier Reflexionsfaktoren Schaltungseigenschaften optimiert werden, welche von der Transformation mehr als eines der Reflexionsfaktoren durch das Anpassnetzwerk $M_1$, $M_2$ abhängen.

Gegenüber herkömmlichen Lastmodulationsverstärkern des Doherty-Typus sind die Layouts der erzielten Anpassnetzwerke weit weniger groß. Dies ist insbesondere dann vorteilhaft, wenn beispielsweise eine Frequenzfamilie von Leistungsverstärkern für Basisstationen des Mobilfunks in jeweils gleich großen Gehäusen untergebracht werden muss. Mit dem erfindungsgemäßen Verfahren zur Auslegung von Anpassnetzwerken steht nach 74 Jahren zum ersten Mal eine gangbare Alternative zur Verfügung. Insbesondere macht das hier erläuterte Verfahren die bisherige Impedanzinversion unnötig.

Fig. 27 zeigt eine elektronische Schaltung insbesondere für ein Hochfrequenzsignal. Die Schaltung weist ein erstes Quellenelement $Q_1$ und ein zweites Quellenelement $Q_2$ und ein erstes Anpassnetzwerk $M_1$ und ein zweites Anpassnetzwerk $M_2$ auf.

Das erste Anpassnetzwerk $M_1$ und das zweite Anpassnetzwerk $M_2$ sind entsprechend dem Ausführungsbeispiel der Fig. 12 ausgelegt.

Das zweite Quellenelement $Q_2$ ist zur Ausgabe eines Signals S mit einer Mittenfrequenz f ausgebildet. Die Last L weist eine Lastimpedanz $Z_L$ auf. Das zweite Anpassnetzwerk $M_2$ weist leitungsartige Serienelemente $L_{S1}...L_{S20}$ auf, die das Signal S führen,

Dabei weisen entweder die leitungsartigen Serienelemente $L_{S1}...L_{S20}$ ausschließlich Leitungsimpedanzen $Z_{S1}...Z_{S20}$ kleiner als die Lastimpedanz $Z_L$ auf,

oder

eine Summe der elektrischen Längen derjenigen leitungsartigen Serienelemente $L_{S1}...L_{S20}$, die jeweils eine Leitungsimpedanz $Z_{S1}...Z_{S20}$ größer als die Lastimpedanz $Z_L$ aufweisen, ist kleiner als ein Viertel einer dem Signal S zugehörigen Wellenlänge $\lambda$. Die Wellenlänge eines Signals gegebener Frequenz auf einem der leitungsartigen Serienelemente $L_{S1}...L_{S20}$ hängt dabei von der physikalischen Realisierung des jeweiligen leitungsartigen Serienelementes $L_{S1}...L_{S20}$ab.

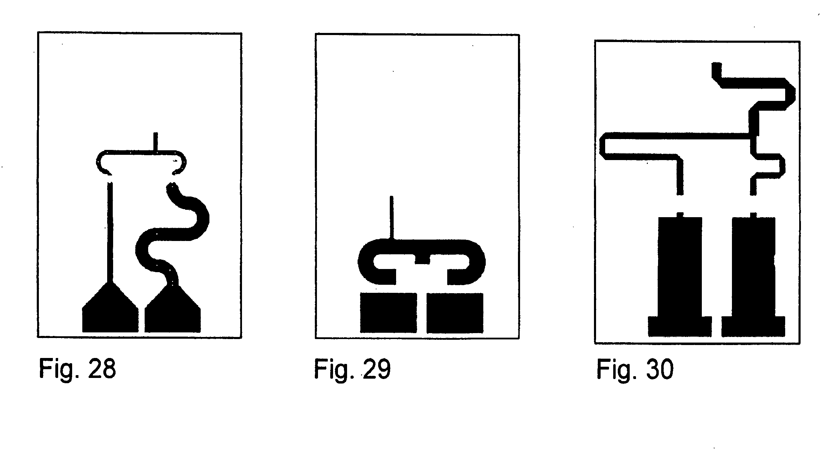

Ein konkrete Ausführungsbeispiele von Anpassnetzwerken werden in den Figuren 28ff. dargestellt. Die Figuren 28 und 29 zeigen jeweils die drainseitigen erzeugten Anpass-Strukturen, welche im Wesentlichen das erste Anpassnetzwerk $M_1$ und das zweite Anpassnetzwerk $M_2$ darstellen. Dabei zeigt Fig. 28 ein Layout für eine Lastmodulations-Verstärkeranordnung für eine Betriebsfrequenz von 1500MHz und (in selbem Maßstab) Fig. 29 ein Doherty-Design für dieselbe Betriebsfrequenz.

Wie beispielsweise aus Fig. 12 ersichtlich, erlaubt das Verfahren zumeist zwei Lösungen für Paare aus einem dem Peak-Verstärkerzweig zugehörigen zyklischen Freiheitsgrad und einem dem Main-Verstärkerzweig zugehörigen zyklischen Freiheitsgrad. Entsprechend umfasst die Lastmodulations-Verstärkeranordnung zwei disjunkte Lösungen für die Transformationswirkung der Anpassnetzwerke $M_1$, $M_2$. Zwei diesen beiden Transformationswirkungen zugehörige AnpassNetzwerke werden maßstäblich dargestellt in den Figuren 28 und 29. Besonders vorteilhaft ist die im Vergleich zum Stand der Technik deutlich geringere erforderliche elektrische Länge der Strukturen der Anpassnetzwerke $M_1$, $M_2$. Tatsächlich sind für ein und dieselbe gewünschte Transformationswirkung, selbst mit einem identischen Ansatz, Scharen von Anpass-Netzwerken zu bestimmen, welche jeweils die gewünschte Transformationswirkung realisieren. Die Strukturen unterscheiden sich jedoch von Schar zu Schar in ihren elektrischen Längen um Vielfache einer halben Wellenlänge.

In der Figur 30 sind als Ausführungsbeispiele maßstäblich Strukturen des Anpassnetzwerks $M_1$ dargestellt. Die Strukturen sind gemäß der zuvor erläuterten Ausführungsbeispiele bestimmt und bewirken eine Abbildung in Vorwärtsrichtung bei 1500MHz der ersten Urbild-Impedanz von (10.1 - j*11.0) $\Omega$ auf eine erste Bildimpedanz von 4 $\Omega$. Zudem bewirken die Sturkturen eine Abbildung in Vorwärtsrichtung einer zweiten Urbild-Impedanz von 50 $\Omega$ auf eine zweite Bildimpedanz von (1.44 - j*3.5) $\Omega$.

Die Strukturen in den Beispielen nach Fig. 30 bestehen aus vier seriellen homogenen Mikrostreifenleitungen auf einem Dielektrikum mit einer Dicke von 20 mit und einer Dielektrizitätskonstante von 3.5. In der Fig. 30 ist jeweils das der Urbildimpedanz zugewandte Ende der Struktur dargestellt, während die Struktur am unteren Ende die gewünschte Bild-Impedanz aufweist.

Nummeriert man in der Figur 30 die vier homogenen Mikrostreifenleitungen bei dem urbildseitigen Anschluss beginnend von 1 bis 4 durch, weisen die drei Anpass-Strukturen die geometrischen Längen L und Weiten W auf von:

| W1 [mm] / L1 [mm] | 6.467 / 26.173 | 1.098 / 14.913 | 16 / 5 |
| W2 [mm] / L2 [mm] | 9,973 / 48.424 | 2.850 / 39.098 | 1 / 2.927 |
| W3 [mm] / L3 [mm] | 6.424 / 52.078 | 12.383 / 14.547 | 16 / 1.126 |
| W4 [mm] / L4 [mm] | 14.5 / 3.5 | 14.5 / 3.5 | 14.5 / 3.5 |

Aufgrund der, gegenüber dem Stand der Technik um typischerweise eine halbe Wellenlänge geringeren elektrischen Längen der neuen Strukturen der Anpassnetzwerke $M_1$, $M_2$ in Lastmodulationsverstärkern, erhöht sich die erzielbare relative Bandbreite der Anpass-Strukturen von typischerweise 5% bei Lastmodulationsverstärkern vom Doherty-Typ auf typischerweise 13% für Lastmodulationsverstärkeranordnungen gemäß den zuvor erläuterten Ausführungsbeispielen.

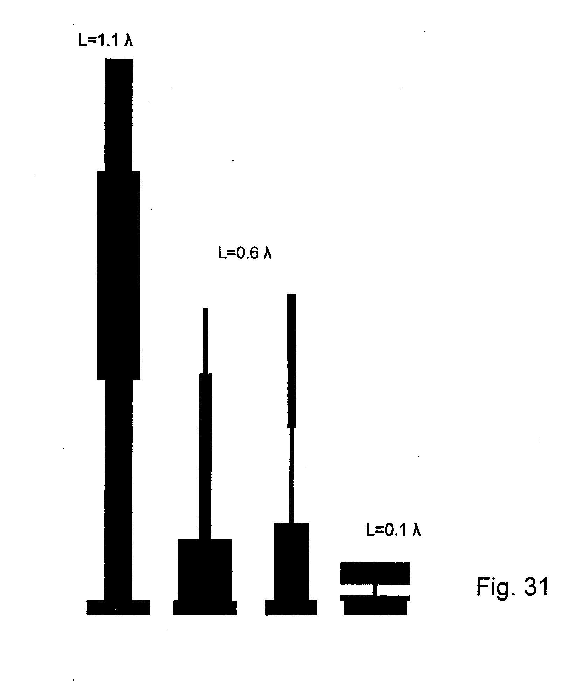

Die Diagramme der Fig. 31 stellen die Transformationswege für drei Strukturen der Anpassnetzwerke $M_1$, $M_2$ der Fig. 30 im Smith-Chart dar. In der oberen Reihe für die erste, in der unteren Reihe für die zweite Urbild- und Bildimpedanz.

**Patentansprüche**

**1.** Verfahren zur Auslegung einer elektronischen Schaltung,

- wobei die Schaltung ein erstes Anpassnetzwerk ($M_1$) mit einem ersten Anschluss ($A_1$) und einem zweiten Anschluss ($A_2$) aufweist,
- wobei die Schaltung eine mit dem ersten Anschluss ($A_1$) verbundene Last (L) aufweist,
- wobei am ersten Anschluss ($A_1$) ein von der Last (L) abhängiger erster Lastreflexionsfaktor ($a_{on}$) bewirkt wird,
- wobei die Schaltung ein mit dem zweiten Anschluss ($A_2$) verbundenes Quellenelement ($Q_1$) mit einem ersten Quellreflexionsfaktor ($b_{on}$) aufweist,
- wobei durch das erste Anpassnetzwerk ($M_1$) in den zweiten Anschluss ($A_2$) hinein ein transformierter erster Lastreflexionsfaktor ($a_{on}$') und in den ersten Anschluss ($A_1$) hinein ein transformierter erster Quellreflexionsfaktor ($b_{on}$') bewirkt wird,

mit den Schritten:

a) Bestimmen eines ersten Wertes ($b_{on}{}'_{opt}$) des transformierten ersten Quellreflexionsfaktors ($b_{on}$') und eines zweiten Wertes ($a_{on}{}'_{opt}$) des transformierten ersten Lastreflexionsfaktors ($a_{on}$'), indem für jeden ersten Poincaré-Abstand ($P_R$) einer Anzahl von ersten Poincaré- Abständen ($P_R$),

- ein erster Poincaré- Kreis ($K_1$) als Menge aller Punkte im ersten Poincaré- Abstand ($P_R$) von dem komplex Konjugierten ($a_{on}$*) des ersten Lastreflexionsfaktors ($a_{on}$) bestimmt wird durch

$$P(y, a_{on}*) = \mathrm{arctanh}\left(\frac{|y - a_{on}*|}{|1 - y * a_{on}*|}\right) \equiv P_R \,,$$

wobei

y ein Punkt (y) auf dem ersten Poincaré- Kreis ($K_1$),
y* das komplex Konjugierte (y*) des Punktes (y) auf dem ersten Poincaré-Kreis ($K_1$),
$a_{on}$* das komplex Konjugierte ($a_{on}$*) des ersten Lastreflexionsfaktors ($a_{on}$) und
$P_R$ der erste Poincaré-Abstand ($P_R$) ist,

- ein zweiter Poincaré-Kreis ($K_2$) als Menge aller Punkte im ersten Poincaré-Abstand ($P_R$) von dem komplex Konjugierten ($b_{on}$*) des ersten Quellreflexionsfaktors ($b_{on}$) bestimmt wird durch

$$P(x, b_{on}*) = \mathrm{arctanh}\left(\frac{|x - b_{on}*|}{|1 - x * b_{on}*|}\right) \equiv P_R \,,$$

wobei

x ein Punkt (x) auf dem zweiten Poincaré-Kreis ($K_2$),
x* das komplex Konjugierte (x*) des Punktes (x) auf dem zweiten Poincaré-Kreis ($K_2$),
$b_{on}$* das komplex Konjugierte ($b_{on}$*) des ersten Quellreflexionsfaktors ($b_{on}$) und
$P_R$ der erste Poincaré-Abstand ($P_R$) ist,

- eine Anzahl von ersten Punktepaaren ($[y(P_R), x(P_R)]$) bestimmt wird, wobei ein erster Paarpunkt ($y(P_R)$) jedes Punktepaares ($[y(P_R), x(P_R)]$) auf dem ersten Poincaré-Kreis ($K_1$) ist, und wobei ein zweiter Paarpunkt ($x(P_R)$) jedes Punktepaares ($[y(P_R), x(P_R)]$) auf dem zweiten Poincaré-Kreis ($K_2$) ist, und
- ein Wert einer ersten Kenngröße ($G_1$) bestimmt wird für jedes erste Punktepaar ($[y(P_R), x(P_R)]$) mit dem ersten Paarpunkt ($y(P_R)$) gleich einem Wert des transformierten ersten Quellreflexionsfaktors ($b_{on}$') und mit dem zweiten Paarpunkt ($x(P_R)$) gleich einem Wert des transformierten ersten Lastreflexionsfaktors ($a_{on}$'),

wobei die Kenngröße ($G_1$) der Schaltung ein S-Parameter oder eine Kleinsignal-Rauschzahl oder ein effektiver Eingangsreflexionsfaktor oder ein effektiver Ausgangsreflexionsfaktor oder ein effektiver Ausgangswiderstand oder ein Rollet'scher Stabilitätsfaktor oder eine Leistungsverstärkung oder ein Intermodulationsprodukt der Ordnung n oder eine harmonische Verzerrung n-ter Ordnung oder ein Klirrfaktor oder eine Effizienz der Leistungsverstärkung oder eine Rauschzahl oder ein Kompressionspunkt oder eine Kompressionsleistung oder eine Kompression der Leistungsverstärkung oder ein Durchschnitt einer Kleinsignal-Kenngröße oder ein Integral einer Kleinsignal-Kenngröße oder eine Fehlanpassung zwischen dem transformierten ersten Quellreflexionsfaktor ($b_{on}$') und dem ersten Lastreflexionsfaktor ($a_{on}$) ist,
b) Bestimmen

- eines Optimums ($Max_1$) der ersten Kenngröße ($G_1$) aus allen Werten der ersten Kenngröße ($G_1$), die den ersten Punktepaaren ($[y(P_R), x(P_R)]$) zugeordnet sind,
- eines ersten Wertepaares ($[y_{opt}, x_{opt}]$) aus den ersten Punktepaaren ($[y(P_R), x(P_R)]$), wobei dem ersten Wertepaar ($[y_{opt}, x_{opt}]$) das Optimum ($Max1$) zugeordnet ist,
- des ersten Wertes ($b_{on}'_{opt}$) des transformierten ersten Quellreflexionsfaktors ($b_{on}$') gleich einem ersten Wertepunkt ($y_{opt}$) des ersten Wertepaares ($[y_{opt}, x_{opt}]$),
- des zweiten Wertes ($a_{on}'_{opt}$) des transformierten ersten Lastreflexionsfaktors ($a_{on}$') gleich einem zweiten Wertepunkt ($x_{opt}$) des ersten Wertepaares ($[y_{opt}, x_{opt}]$) .

wobei das Optimum ($Max_1$) ein lokales oder globales Minimum oder Maximum der Kenngröße ($G_1$) ist,

c) Bestimmen des ersten Anpassnetzwerks ($M_1$) anhand des ersten Wertes ($b_{on}'_{opt}$) des transformierten ersten Quellreflexionsfaktors ($b_{on}'$), des zweiten Wertes ($a_{on}'_{opt}$) des transformierten ersten Lastreflexionsfaktors ($a_{on}'$), des ersten Quellreflexionsfaktors ($b_{on}$) und des ersten Lastreflexionsfaktors ($a_{on}$) .

2. Verfahren nach Anspruch 1, mit den weiteren Schritten:

d) Bestimmen einer ersten Funktion ($f_{aon,aon',\varphi}$), die die Transformationswirkung des ersten Anpassnetzwerks ($M_1$) in Vorwärtsrichtung (V) beschreibt, wobei die erste Funktion ($f_{aon,aon',\varphi}$) durch

$$f_{a_{on},a_{on}',\varphi}(z_1) = e^{i\varphi}\frac{z_1 - z_0}{1 - z_0^* z_1}$$

mit

$$z_0 = \frac{1 - |a_{on}|^2}{|a_{on}|^2|a_{on}'|^2 - 1} a_{on}'e^{-i\varphi} - \frac{1 - |a_{on}'|^2}{|a_{on}|^2|a_{on}'|^2 - 1} a_{on}$$

definiert ist, wobei

$a_{on}$ der erste Lastreflexionsfaktor ($a_{on}$),
$a_{on}'$ der transformierte erste Lastreflexionsfaktor ($a_{on}'$),
$\varphi \in [0...2\pi[$ ein Parameter,

$i = \sqrt[2]{-1}$ und

$z_1$ ein erstes Argument der ersten Funktion ($f_{aon,aon',\varphi}$) ist,

e) Bestimmen einer zweiten Funktion ($f^R_{aon,aon',\varphi}$), die die Transformationswirkung des ersten Anpassnetzwerks ($M_1$) in Rückwärtsrichtung (R) beschreibt, wobei die zweite Funktion ($f^R_{aon,aon',\varphi}$) durch

$$f^R_{a_{on},a_{on}',\varphi}(z_2) = e^{i\varphi}\frac{z_2 - z_0^R}{1 - z_0^{R*} z_2}$$

mit

$$z_0^R = \frac{1 - |a_{on}'^*|^2}{|a_{on}'^*|^2|a_{on}^*|^2 - 1} a_{on}^*e^{-i\varphi} - \frac{1 - |a_{on}^*|^2}{|a_{on}'^*|^2|a_{on}^*|^2 - 1} a_{on}'^*$$

definiert ist, wobei

$a_{on}$ der erste Lastreflexionsfaktor ($a_{on}$),
$a_{on}^*$ das komplexe Konjugierte ($a_{on}^*$) des ersten Lastreflexionsfaktors ($a_{on}$),
$a_{on}'$ der transformierte erste Lastreflexionsfaktor ($a_{on}'$),
$a_{on}'^*$ das komplex Konjugierte ($a_{on}'^*$) des transformierten ersten Lastreflexionsfaktors ($a_{on}'$). $\varphi \in [0...2\pi[$ der Parameter, und
$z_2$ ein zweites Argument der zweiten Funktion ($f^R_{aon,aon',\varphi}$) ist,

f) Bestimmen eines Wertes des Parameters für das Optimum ($Max_1$) der ersten Kenngröße ($G_1$), indem

- die Anzahl der ersten Poincaré-Abstände ($P_R$) gleich Eins ist, und der erste Poincaré-Abstand ($P_R$) zwischen dem transformierten ersten Lastreflexionsfaktor ($a_{on}'$) und dem komplex Konjugierten ($b_{on}*$) des ersten Quellreflexionsfaktors ($b_{on}$) bestimmt wird durch

$$P_{a_{on}',b_{on}*} = \operatorname{arctanh}\left(\frac{|a_{on}'-b_{on}*|}{|1-b_{on}*a_{on}'*|}\right) \equiv P_R \ ,$$

wobei

$b_{on}$ der erste Quellreflexionsfaktor ($b_{on}$),
$b_{on}*$ das komplexe Konjugierte ($b_{on}*$) des ersten Quellreflexionsfaktors ($b_{on}$),
$a_{on}'$ der transformierte erste Lastreflexionsfaktor ($a_{on}'$)
und $P_R$ der erste Poincaré-Abstand ($P_R$) ist,

- der Wert des Parameters bestimmt wird, wobei für den Wert des Parameters die zweite Funktion ($f^R_{aon,aon',\varphi}$) mit dem ersten Quellreflexionsfaktor ($b_{on}$) als zweites Argument den ersten Wert ($b_{on}'_{opt}$) des transformierten ersten Quellreflexionsfaktors ($b_{on}'$) als Funktionswert annimmt,

g) Bestimmen des ersten Anpassnetzwerks ($M_1$) anhand der ersten Funktion ($f_{aon,aon',\varphi opt}$) für den Wert des Parameters.

3. Verfahren nach einem der vorhergehenden Ansprüche,

- bei dem die erste Kenngröße ($G_1$) eine Fehlanpassung zwischen dem transformierten ersten Quellreflexionsfaktor ($b_{on}'$) und dem ersten Lastreflexionsfaktor ($a_{on}$) ist.

4. Verfahren nach einem der vorhergehenden Ansprüche,

- bei dem als Randbedingung eine vorgegebene Fehlanpassung zwischen dem transformierten ersten Quellreflexionsfaktor ($b_{on}'$) und dem ersten Lastreflexionsfaktor ($a_{on}$) ein Teil der ersten Kenngröße ($G_1$) ist.

5. Verfahren zur Auslegung einer elektronischen Schaltung,

- wobei die Schaltung ein zweites Anpassnetzwerk ($M_2$) mit einem dritten Anschluss ($A_3$) und einem vierten Anschluss ($A_4$) aufweist,
- wobei die Schaltung eine mit dem dritten Anschluss ($A_3$) verbundene variable Last (L) mit einem ersten Betriebszustand (off) und einem zweiten Betriebszustand (on) aufweist, und wobei an dem dritten Anschluss ($A_3$) im zweiten Betriebszustand (on) ein zweiter Lastreflexionsfaktor ($c_{on}$) und in dem ersten Betriebszustand (off) ein dritter Lastreflexionsfaktor ($c_{off}$) bewirkt wird,
- wobei durch das zweite Anpassnetzwerk ($M_2$) in den vierten Anschluss ($A_4$) hinein im zweiten Betriebszustand ein transformierter zweiter Lastreflexionsfaktor ($c_{on}'$) und im ersten Betriebszustand ein transformierter dritter Lastreflexionsfaktor ($c_{off}'$) bewirkt wird, mit den Schritten:

a) Bestimmen eines dritten Wertes ($c_{off,opt}$) des dritten Lastreflexionsfaktors ($c_{off}$) und eines vierten Wertes ($c_{on,opt}$) des zweiten Lastreflexionsfaktors ($c_{on}$), indem

- ein dritter Poincaré-Abstand ($P_3$) zwischen dem transformierten zweiten Lastreflexionsfaktor ($c_{on}'$) und dem transformierten dritten Lastreflexionsfaktor ($c_{off}'$) bestimmt wird durch

$$P_3 = \operatorname{arctanh}\left(\frac{|c_{off}'-c_{on}'|}{|1-c_{off}'*c_{on}'|}\right) \ ,$$

wobei

$c_{on}$' der transformierte zweite Lastreflexionsfaktor ($c_{on}$'),
$c_{off}$' der transformierte dritte Lastreflexionsfaktor ($c_{off}$'),
$c_{off}$'* das komplex Konjugierte ($c_{off}$'*) des transformierten dritten Lastreflexionsfaktors ($c_{off}$') und
$P_3$ der dritte Poincaré-Abstand ($P_3$) ist,

- ein dritter Poincaré-Kreis ($K_3$) als Menge aller Punkte im dritten Poincaré-Abstand ($P_3$) von dem zweiten Lastreflexionsfaktor ($c_{on}$) bestimmt wird durch

$$P(z, c_{on}) = \mathrm{arctanh}\left(\frac{|z - c_{on}|}{|1 - z * c_{on}|}\right) \equiv P_3 \, ,$$

wobei

$z$ ein Punkt auf dem dritten Poincaré-Kreis ($K_3$),
$z^*$ das komplex Konjugierte ($z^*$) des Punktes ($z$) auf dem dritten Poincaré-Kreis ($K_3$), $c_{on}$ der zweite Lastreflexionsfaktor ($c_{on}$),
$c_{on}^*$ das komplex Konjugierte ($c_{on}^*$) des zweiten Lastreflexionsfaktors ($c_{on}$) und
$P_3$ der dritte Poincaré-Abstand ($P_3$) ist,

- eine Anzahl von zweiten Punktepaaren ([$c_{on}$, $z(P_3)$]) bestimmt wird, wobei ein zweiter Paarpunkt ($z(P_3)$) jedes zweiten Punktepaares ([$c_{on}$, $z(P_3)$]) ein Punkt auf dem dritten Poincaré-Kreis ($K_3$) ist,
- ein Wert einer zweiten Kenngröße ($G_2$) bestimmt wird für jedes zweite Punktepaar ([$c_{on}$, $z(P_3)$]), wobei ein Wert des dritten Lastreflexionsfaktors ($c_{off}$) gleich dem zweiten Paarpunkt ($z(P_3)$) ist, und wobei ein Wert des zweiten Lastreflexionsfaktor ($c_{on}$) gleich dem ersten Paarpunkt ($c_{on}$) ist,
- ein Optimum ($Max_2$) der zweiten Kenngröße ($G_2$) bestimmt wird aus allen Werten der zweiten Kenngröße ($G_2$), die den zweiten Punktepaaren ([$c_{on}$, $z(P_3)$]) zugeordnet sind,
- ein dem Optimum ($Max_2$) zugehöriges zweites Punktepaar ([$c_{on,opt}$, $c_{off,opt}$]) bestimmt wird,
- der dritte Wert ($c_{off,opt}$) des dritten Lastreflexionsfaktors ($c_{off}$) bestimmt wird gleich einem dem Optimum ($Max_2$) zugehörigen zweiten Paarpunkt ($c_{off,opt}$) des dem Optimum ($Max_2$) zugehörigen zweiten Punktepaares ([$c_{on,opt}$, $c_{off,opt}$]), und
- der vierte Wert ($c_{on,opt}$) des zweiten Lastreflexionsfaktors ($c_{on}$) bestimmt wird gleich einem dem Optimum ($Max_2$) zugehörigen ersten Paarpunkt ($c_{on}$) des dem Optimum ($Max_2$) zugehörigen zweiten Punktepaares ([$c_{on,opt}$, $c_{off,opt}$]),

wobei die Kenngröße ($G_2$) der Schaltung ein S-Parameter oder eine Kleinsignal-Rauschzahl oder ein effektiver Eingangsreflexionsfaktor oder ein effektiver Ausgangsreflexionsfaktor oder ein effektiver Ausgangswiderstand oder ein Rollet'scher Stabilitätsfaktor oder eine Leistungsverstärkung oder ein Intermodulationsprodukt der Ordnung n oder eine harmonische Verzerrung n-ter Ordnung oder ein Klinfaktor oder eine Effizienz der Leistungsverstärkung oder eine Rauschzahl oder ein Kompressionspunkt oder eine Kompressionsleistung oder eine Kompression der Leistungsverstärkung oder ein Durchschnitt einer Kleinsignal-Kenngröße oder ein Integral einer Kleinsignal-Kenngröße oder eine Fehlanpassung zwischen dem transformierten ersten Quellreflexionsfaktor ($b_{on}$') und dem ersten Lastreflexionsfaktor ($a_{on}$) ist,
wobei das Optimum ($Max_2$) ein lokales oder globales Minimum oder Maximum der Kenngröße ($G_2$) ist,
b) Bestimmen des zweiten Anpassnetzwerks ($M_2$) anhand des dritten Wertes ($c_{off,opt}$) des dritten Lastreflexionsfaktors ($c_{off}$), des vierten Wertes ($c_{on,opt}$) des zweiten Lastreflexionsfaktors ($c_{on}$), des transformierten zweiten Lastreflexionsfaktors ($c_{on}$') und des transformierten dritten Lastreflexionsfaktors ($c_{off}$').

6. Verfahren zur Auslegung einer elektronischen Schaltung,

- bei dem die Schaltung einen ersten Betriebszustand (off) und einen zweiten Betriebszustand (on) aufweist,
- bei dem die Schaltung ein erstes Quellenelement ($Q_1$) mit einem ersten Quellenausgang ($QA_1$) und ein zweites Quellenelement ($Q_2$) mit einem zweiten Quellenausgang ($QA_2$) aufweist,
- bei dem das erste Quellenelement ($Q_1$) in den ersten Quellenausgang ($QA_1$) hinein im ersten Betriebszustand (off) einen ersten Quellreflexionsfaktor ($b_{off}$) aufweist,

- bei dem die Schaltung eine Last (L) mit einem Lasteingang (LE) aufweist,
- bei dem die Last (L) in den Lasteingang (LE) hinein einen Last-Eingangsreflexionsfaktor ($\Gamma$) aufweist,
- bei dem die Schaltung ein T-Stück (T) mit einem ersten Eingang ($E_1$), einem zweiten Eingang ($E_2$) und einen Ausgang ($E_3$) aufweist,
- bei dem der Lasteingang (LE) mit dem Ausgang ($E_3$) des T-Stücks (T) verbunden ist,
- bei dem das T-Stück (T) in den ersten Eingang ($E_1$) hinein im zweiten Betriebszustand (on) einen ersten Lastreflexionsfaktor ($a_{on}$) aufweist,
- bei dem das T-Stück (T) in den zweiten Eingang ($E_2$) hinein im ersten Betriebszustand (off) einen zweiten Lastreflexionsfaktor ($c_{off}$) aufweist,
- bei dem das T-Stück (T) in den zweiten Eingang ($E_2$) hinein im zweiten Betriebszustand (on) einen dritten Lastreflexionsfaktor ($C_{on}$) aufweist,
- bei dem die Schaltung ein erstes Anpassnetzwerk ($M_1$) mit einem ersten Anschluss ($A_1$) und einem zweiten Anschluss ($A_2$) aufweist,
- bei dem der erste Anschluss ($A_1$) mit dem ersten Eingang ($E_1$) des T-Stücks (T) verbundenen ist,
- bei dem der zweite Anschluss ($A_2$) mit dem ersten Quellenausgang ($QA_1$) verbunden ist,
- bei dem das erste Anpassnetzwerk ($M_1$) in den ersten Anschluss ($A_1$) hinein im ersten Betriebszustand (off) einen transformierten ersten Quellreflexionsfaktor ($b_{off}$') aufweist,
- bei dem das erste Anpassnetzwerk ($M_1$) in den zweiten Anschluss ($A_2$) hinein im zweiten Betriebszustand (on) einen transformierten ersten Lastreflexionsfaktor ($a_{on}$') aufweist,
- bei dem die Schaltung ein zweites Anpassnetzwerk ($M_2$) mit einem dritten Anschluss ($A_3$) und einem vierten Anschluss ($A_4$) aufweist,
- bei dem der dritte Anschluss ($A_3$) mit dem zweiten Eingang ($E_2$) des T-Stücks (T) verbunden ist,
- bei dem der vierte Anschluss ($A_4$) mit dem zweiten Quellenausgang ($QA_2$) verbunden ist,
- bei dem das zweite Anpassnetzwerk ($M_2$) in den vierten Anschluss ($A_4$) hinein im ersten Betriebszustand (off) einen transformierten zweiten Lastreflexionsfaktor ($c_{off}$') aufweist,
- bei dem das zweite Anpassnetzwerk ($M_2$) in den vierten Anschluss ($A_4$) hinein im zweiten Betriebszustand (on) einen transformierten dritten Lastreflexionsfaktor ($c_{on}$') aufweist,
- bei dem ein erster Wert ($a_{on}{}'_{opt}$) des transformierten ersten Lastreflexionsfaktors ($a_{on}$') zur Optimierung einer Kenngröße ($G_1$) der Schaltung im zweiten Betriebszustand (on) durch Messung bestimmt wird,
- bei dem ein zweiter Wert ($c_{off}{}'_{opt}$) des transformierten zweiten Lastreflexionsfaktors ($c_{off}$') zur Optimierung der Kenngröße ($G_1$) der Schaltung im ersten Betriebszustand (off) durch Messung bestimmt wird,
- bei dem ein dritter Wert ($c_{on}{}'_{opt}$) des transformierten dritten Lastreflexionsfaktors ($c_{on}$') zur Optimierung der Kenngröße ($G_1$) der Schaltung im zweiten Betriebszustand (on) durch Messung bestimmt wird,
- bei dem der erste Lastreflexionsfaktor ($a_{on}$) auf einen ersten Anfangswert festgelegt wird,
- bei dem der zweite Lastreflexionsfaktor ($C_{on}$) auf einen zweiten Anfangswert festgelegt wird,

wobei die Kenngröße ($G_2$) der Schaltung ein S- Parameter oder eine Kleinsignal- Rauschzahl oder ein effektiver Eingangsreflexionsfaktor oder ein effektiver Ausgangsreflexionsfaktor oder ein effektiver Ausgangswiderstand oder ein Rollet'scher Stabilitätsfaktor oder eine Leistungsverstärkung oder ein Intermodulationsprodukt der Ordnung n oder eine harmonische Verzerrung n- ter Ordnung oder ein Klirrfaktor oder eine Effizienz der Leistungsverstärkung oder eine Rauschzahl oder ein Kompressionspunkt oder eine Kompressionsleistung oder eine Kompression der Leistungsverstärkung oder ein Durchschnitt einer Kleinsignal- Kenngröße oder ein Integral einer Kleinsignal- Kenngröße oder eine Fehlanpassung zwischen dem transformierten ersten Quellreflexionsfaktor ($b_{on}$') und dem ersten Lastreflexionsfaktor ($a_{on}$) ist, wobei zur Optimierung der Kenngröße ($G_2$) ein lokales or globales Minimum oder Maximum der Kenngröße ($G_2$) gesucht wird,
mit den Schritten:

a) Berechnen eines ersten Poincaré- Abstands ($P_1$) zwischen dem ersten Wert ($a_{on}{}'_{opt}$) und dem komplex Konjugierten ($b_{off}{}^*$) des ersten Quellreflexionsfaktors ($b_{off}$) durch

$$P_1 = \operatorname{arctanh}\left(\frac{\left|a_{on}{}'_{opt} - b_{off}{}^*\right|}{\left|1 - b_{off}{}^* \, a_{on}{}'_{opt}{}^*\right|}\right),$$

wobei

$b_{off}$ der erste Quellreflexionsfaktor ($b_{off}$), $b_{off}{}^*$ das komplexe Konjugierte ($b_{off}{}^*$) des ersten Quellreflexions-

faktors ($b_{off}$),
$a_{on}'_{opt}$ der erste Wert ($a_{on}'_{opt}$) des transformierten ersten Lastreflexionsfaktors ($a_{on}'$) und $P_1$ der erste Poincaré- Abstand ($P_1$) ist,

b) Bestimmen eines ersten Poincaré-Kreises ($K_1$) als Menge aller Punkte im ersten Poincaré-Abstand ($P_1$) von dem komplex Konjugierten ($a_{on}^*$) des ersten Lastreflexionsfaktors ($a_{on}$) durch

$$P(y, a_{on}^*) = \operatorname{arctanh}\left(\frac{|y - a_{on}^*|}{|1 - y^* \, a_{on}^*|}\right) \equiv P_1 \, ,$$

wobei

$y$ ein Punkt auf dem ersten Poincaré-Kreis ($K_1$),
$y^*$ das komplex Konjugierte ($y^*$) des Punktes ($y$) auf dem ersten Poincaré-Kreis ($K_1$),
$a_{on}^*$ das komplex Konjugierte ($a_{on}^*$) des ersten Lastreflexionsfaktors ($a_{on}$) und
$P$, der erste Poincaré-Abstand ($P_1$) ist,

c) Bestimmen eines dritten Poincaré- Abstands ($P_3$) zwischen dem zweiten Wert ($c_{off}'_{opt}$) und dem dritten Wert ($c_{on}'_{opt}$) durch

$$P_3 = \operatorname{arctanh}\left(\frac{|c_{on}'_{opt} - c_{off}'_{opt}|}{|1 - c_{on}'_{opt} \, * \, c_{off}'_{opt}|}\right) \, ,$$

wobei

$c_{off}'_{opt}$ der zweite Wert ($c_{off}'_{opt}$) des transformierten zweiten Lastreflexionsfaktors ($c_{off}'$),
$c_{on}'_{opt}$ der dritte Wert ($c_{on}'_{opt}$) des transformierten dritten Lastreflexionsfaktors ($c_{on}'$),
$c_{on}'_{opt}^*$ das konjugiert Komplexe ($c_{on}'_{opt}^*$) des dritten Wertes ($c_{on}'_{opt}$) des transformierten dritten Lastreflexionsfaktors ($c_{on}'$) und
$P_3$ der dritte Poincaré-Abstand ($P_3$) ist,

d) Bestimmen eines dritten Poincaré-Kreises ($K_3$) als Menge aller Punkte im dritten Poincaré-Abstand ($P_3$) von dem dritten Lastreflexionsfaktor ($C_{on}$) durch

$$P(z, c_{on}) = \operatorname{arctanh}\left(\frac{|z - c_{on}|}{|1 - z^* c_{on}|}\right) \equiv P_3 \, ,$$

wobei

$z$ ein Punkt auf dem dritten Poincaré-Kreis ($K_3$),
$z^*$ das komplex Konjugierte ($z^*$) des Punktes ($z$) auf dem dritten Poincaré-Kreis ($K_3$),
$c_{on}$ der dritte Lastreflexionsfaktor ($c_{on}$),
$c_{on}^*$ das komplex Konjugierte ($c_{on}^*$) des dritten Lastreflexionsfaktors ($C_{on}$) und
$P_3$ der dritte Poincaré-Abstand ($P_3$) ist,

e) Bestimmen eines veränderten ersten Poincaré-Kreises ($K_1'$), wobei der veränderte erste Poincaré-Kreis ($K_1'$) bestimmt wird als Menge aller veränderten Reflexionsfaktoren ($y'$), wobei jeder der veränderten Reflexionsfaktoren ($y'$) einer Gesamtimpedanz zugehörig ist, wobei jede Gesamtimpedanz bestimmt wird aus einer ersten Parallelschaltung einer Lastimpedanz der Last (L) und einer einem Reflexionsfaktor ($y$) auf dem ersten Poincaré-Kreis ($K_1$) zugehörigen Impedanz, wobei die Lastimpedanz dem Last-Eingangsreflexionsfaktor ($\Gamma$) der Last (L) zugehörig ist,
f) Bestimmen zumindest eines vierten Wertes ($c_{off,1}$, $c_{off,2}$) des zweiten Lastreflexionsfaktors ($c_{off}$), wobei für den zumindest einen vierten Wert eine Quadratsumme von Abständen zwischen dem vierten Wert ($c_{off,1}$, $c_{off,2}$) und dem dritten Poincaré-Kreis ($K_3$) sowie zwischen dem vierten Wert ($c_{off,1}$, $c_{off,2}$) und dem veränderten ersten Poincaré-Kreis ($K_1'$) minimiert ist,

g) Bestimmen eines fünften Wertes ($b_{off}'1$, $b_{off}'2$) des transformierten ersten Quellreflexionsfaktors ($b_{off}'$) zu jedem vierten Wert ($c_{off,1}$, $c_{off,2}$) des zweiten Lastreflexionsfaktors ($c_{off}$), wobei eine vierte Impedanz ermittelt wird, wobei die vierte Impedanz dem vierten Wert ($c_{off,1}$, $c_{off,2}$) des zweiten Lastreflexionsfaktors ($c_{off}$) zugehörig ist, wobei eine fünfte Impedanz ermittelt wird, so dass eine zweite Parallelschaltung der fünften Impedanz mit der Lastimpedanz gleich der vierten Impedanz ist und wobei der fünfte Wert ($b_{off}'1$, $b_{off}'2$) des transformierten ersten Quellreflexionsfaktors ($b_{off}'$) der fünften Impedanz zugehörig ist,

h) Bestimmen des ersten Anpassnetzwerkes ($M_1$) anhand des ersten Lastreflexionsfaktors ($a_{on}$), des ersten Wertes ($a_{on}'opt$) des transformierten ersten Lastreflexionsfaktors ($a_{on}'$), des ersten Quellreflexionsfaktors ($b_{off}$) und des fünften Wertes ($b_{off}'1$, $b_{off}'2$) des transformierten ersten Quellreflexionsfaktors ($b_{off}'$), und,

i) Bestimmen des zweiten Anpassnetzwerkes ($M_2$) anhand des zweiten Wertes ($c_{off}'opt$) des transformierten zweiten Lastreflexionsfaktors ($c_{off}'$), des dritten Wertes ($c_{on}'opt$) des transformierten dritten Lastreflexionsfaktors ($c_{on}'$), des dritten Lastreflexionsfaktors ($C_{on}$) sowie des vierten Wertes ($c_{off,1}$, $c_{off,2}$) des zweiten Lastreflexionsfaktors ($c_{off}$).

7. Verfahren zur Auslegung einer elektronischen Schaltung,

- bei dem die Schaltung ein erstes Quellenelement ($Q_1$) mit einem ersten Quellenausgang ($QA_1$) und mit einem ersten Quellreflexionsfaktor (b) aufweist,
- bei dem die Schaltung ein zweites Quellenelement ($Q_2$) mit einem zweiten Quellenausgang ($QA_2$) und mit einem zweiten Quellreflexionsfaktor (d) aufweist,
- bei dem die Schaltung eine Last (L) aufweist,
- bei dem die Schaltung ein T-Stück (T) mit einem ersten Eingang ($E_1$), einem zweiten Eingang ($E_2$) und einem Ausgang ($E_3$) aufweist,
- bei dem das T-Stück (T) in den ersten Eingang ($E_1$) hinein einen ersten Lastreflexionsfaktor (a) aufweist,
- bei dem das T-Stück (T) in den zweiten Eingang ($E_2$) hinein einen zweiten Lastreflexionsfaktor (c) aufweist,
- bei dem der Ausgang ($E_3$) des T-Stücks (T) mit der Last (L) verbunden ist,
- bei dem die Schaltung ein erstes Anpassnetzwerk ($M_1$) mit einem ersten Anschluss ($A_1$) und einen zweiten Anschluss ($A_2$) aufweist,
- bei dem der zweite Anschluss ($A_2$) mit dem ersten Quellenausgang ($QA_1$) und der erste Anschluss ($A_1$) mit dem ersten Eingang ($E_1$) des T-Stücks (T) verbunden ist,
- bei dem durch das erste Anpassnetzwerk ($M_1$) in den zweiten Anschluss ($A_2$) hinein ein transformierter erster Lastreflexionsfaktor (a') und in den ersten Anschluss ($A_1$) hinein ein transformierter erster Quellreflexionsfaktor (b') bewirkt wird,
- bei dem die Schaltung ein zweites Anpassnetzwerk ($M_2$) mit einem dritten Anschluss ($A_3$) und einem vierten Anschluss ($A_4$) aufweist,
- bei dem der vierte Anschluss ($A_4$) mit dem zweiten Quellenausgang ($QA_2$) und der dritte Anschluss ($A_3$) mit dem zweiten Eingang ($E_2$) des T-Stücks (T) verbunden ist,
- bei dem durch das zweite Anpassnetzwerk ($M_2$) in den vierten Anschluss ($A_4$) hinein ein transformierter zweiter Lastreflexionsfaktor (c') und in den dritten Anschluss ($A_3$) hinein ein transformierter zweiter Quellreflexionsfaktor (d') bewirkt wird,
- bei dem ein erster Wert ($a'_{opt}$) des transformierten ersten Lastreflexionsfaktors (a') ermittelt wird, wobei das erste Quellenelement ($Q_1$) für den am ersten Quellenausgang ($QA_1$) wirkenden ersten Wert ($a'_{opt}$) des transformierten ersten Lastreflexionsfaktors (a') ein erstes Optimum ($Max_1$) einer ersten Kenngröße ($G_1$) aufweist, wobei der erste Wert ($a'_{opt}$) des transformierten ersten Lastreflexionsfaktors (a') vom komplex Konjugierten des ersten Quellreflexionsfaktors (b) abweicht,
- bei dem ein zweiter Wert ($c'_{opt}$) des transformierten zweiten Lastreflexionsfaktors (c') ermittelt wird, wobei das zweite Quellenelement ($Q_2$) für den am zweiten Quellenausgang ($QA_2$) wirkenden zweiten Wert ($c'_{opt}$) des transformierten zweiten Lastreflexionsfaktors (c') ein zweites Optimum ($Max_2$) einer zweiten Kenngröße ($G_2$) aufweist, wobei der zweite Wert ($c'_{opt}$) des transformierten zweiten Lastreflexionsfaktors (c') vom komplex Konjugierten des zweiten Quellreflexionsfaktors (d) abweicht,

wobei die Kenngröße ($G_1$, $G_2$) der Schaltung ein S-Parameter oder eine Kleinsignal-Rauschzahl oder ein effektiver Eingangsreflexionsfaktor oder ein effektiver Ausgangsreflexionsfaktor oder ein effektiver Ausgangswiderstand oder ein Rollet'scher Stabilitätsfaktor oder eine Leistungsverstärkung oder ein Intermodulationsprodukt der Ordnung n oder eine harmonische Verzerrung n-ter Ordnung oder ein Klirrfaktor oder eine Effizienz der Leistungsverstärkung oder eine Rauschzahl oder ein Kompressionspunkt oder eine Kompressionsleistung oder eine Kompression der Leistungsverstärkung oder ein Durchschnitt einer Kleinsignal-Kenngröße oder ein Integral einer Kleinsignal-Kenngröße oder eine Fehlanpassung zwischen dem transformierten ersten Quellreflexionsfaktor ($b_{on}$') und dem ersten Lastreflexionsfaktor ($a_{on}$) ist,

wobei das Optimum ($Max_1$, $Max_2$) ein lokales oder globales Minimum oder Maximum der Kenngröße ($G_1$, $G_2$) ist, mit den Schritten:

a) Bestimmen eines Abstandswertes ($P_{aus}$) und eines dritten Wertes ($a'_{est}$) des transformierten ersten Lastreflexionsfaktors (a') und eines vierten Wertes ($c'_{est}$) des transformierten zweiten Lastreflexionsfaktors (c'), indem

- ein erster Poincaré-Abstand ($P_1$) zwischen dem ersten Wert ($a'_{opt}$) und dem transformierten ersten Lastreflexionsfaktor (a') definiert wird durch

$$P_1 = \text{arctanh}\left(\frac{\left|a'_{opt} - a'\right|}{\left|1 - a'^* a'_{opt}\right|}\right),$$

wobei

$P_1$ der erste Poincaré-Abstand ($P_1$),
a' der transformierte erste Lastreflexionsfaktor (a'),
a'* das komplex Konjugierte (a'*) des transformierten ersten Lastreflexionsfaktors (a') und
$a'_{opt}$ der erste Wert ($a'_{opt}$) ist,

- ein zweiter Poincaré-Abstand ($P_2$) zwischen dem zweiten Wert ($c'_{opt}$) und dem transformierten zweiten Lastreflexionsfaktor (c') definiert wird durch

$$P_2 = \text{arctanh}\left(\frac{\left|c'_{opt} - c'\right|}{\left|1 - c'^* c'_{opt}\right|}\right),$$

wobei

$P_2$ der zweite Poincaré-Abstand ($P_2$),
c' der transformierte zweite Lastreflexionsfaktor (c'),
c'* das komplex Konjugierte (c'*) des transformierten zweiten Lastreflexionsfaktor (c') und
$c'_{opt}$ der zweite Wert ($c'_{opt}$) ist,

- ein dritter Poincaré-Abstand ($P_3$) zwischen dem transformierten ersten Lastreflexionsfaktor (a') und dem komplex Konjugierten (b*) des ersten Quellreflexionsfaktors (b) definiert wird durch

$$P_3 = \text{arctanh}\left(\frac{\left|a' - b^*\right|}{\left|1 - ba'\right|}\right),$$

wobei

$P_3$ der dritte Poincaré-Abstand ($P_3$),
b der erste Quellreflexionsfaktor (b),
b* das komplex Konjugierte (b*) des ersten Quellreflexionsfaktors (b) und
a' der transformierte erste Lastreflexionsfaktor (a') ist,

- ein vierter Poincaré-Abstand ($P_4$) zwischen dem transformierten zweiten Lastreflexionsfaktor (c') und dem komplex Konjugierten (d*) des zweiten Quellreflexionsfaktors (d) definiert wird durch

$$P_4 = \operatorname{arctanh}\left(\frac{|c' - d*|}{|1 - dc'|}\right),$$

wobei

$P_4$ der vierte Poincaré-Abstand ($P_4$),
d der zweite Quellreflexionsfaktor (d),
d* das komplex Konjugierte (d*) des zweiten Quellreflexionsfaktors (d) und
c' der transformierte zweite Lastreflexionsfaktor (c') ist,

- der Abstandswert ($P_{aus}$) und der dritte Wert ($a'_{est}$) und der vierte Wert ($c'_{est}$) definiert werden indem

- ein Minimum des geometrischen Mittels aus dem ersten Poincaré-Abstand ($P_1$) und dem zweiten Poincaré-Abstand ($P_2$) bestimmt wird unter der Randbedingung, dass der dritte Poincaré-Abstand ($P_3$) gleich dem vierten Poincaré-Abstand ($P_4$) und von Null verschieden ist, indem der transformierte erste Lastreflexionsfaktor (a') und der transformierte zweite Lastreflexionsfaktor (c') variiert werden und das komplex Konjugierte (b*) des ersten Quellreflexionsfaktors (b), das komplex Konjugierte (d*) des zweiten Quellreflexionsfaktors (d), der erste Wert ($a'_{opt}$) und der zweite Wert ($c'_{opt}$) einen festen Wert aufweisen, und

- der dem Minimum zugehörige Wert des dritten Poincaré-Abstands ($P_3$) als Abstandswert ($P_{aus}$), der dem Minimum zugehörige Wert des transformierten ersten Lastreflexionsfaktors (a') als dritter Wert ($a'_{est}$) und der dem Minimum zugehörige Wert des transformierten zweiten Lastreflexionsfaktors (c') als vierter Wert ($c'_{est}$) festgelegt werden,

b) Bestimmen eines fünften Wertes ($b'_{est}$) des transformierten ersten Quellreflexionsfaktors (b') und eines sechsten Wertes ($d'_{est}$) des transformierten zweiten Quellreflexionsfaktors (d'), indem

- ein erster Poincaré-Kreis ($K_1$) mit reellem Mittelpunkt, der einen reellen Reflexionsfaktorwert von einem Drittel (1/3) und einen reellen Reflexionsfaktorwert von minus eins (-1) schneidet bestimmt wird,
- ein zweiter Poincaré-Kreis ($K_2$) als Menge aller Punkte (y) mit einem Abstand von dem reellen Reflexionsfaktorwert von einem Drittel (1/3) gleich dem Abstandswert ($P_{aus}$) bestimmt wird durch

$$P\left(y, \frac{1}{3}\right) = \operatorname{arctanh}\left(\frac{\left|y - \frac{1}{3}\right|}{\left|1 - y\frac{1}{3}\right|}\right) \cong P_{aus},$$

wobei

y ein Punkt (y) auf dem zweiten Poincaré-Kreis ($K_2$) und
$P_{aus}$ der Abstandswert ($P_{aus}$) des dritten Abstands ($P_3$) ist,

- der fünfte Wert ($b'_{est}$) als Wert eines ersten Schnittpunkts und der sechste Wert ($d'_{est}$) als Wert eines von dem ersten Schnittpunkt verschiedenen zweiten Schnittpunkts zwischen dem ersten Poincaré-Kreis ($K_1$) und dem zweiten Poincaré-Kreis (K2) bestimmt wird,

c) Bestimmen des ersten Anpassnetzwerks ($M_1$) anhand des ersten Quellreflexionsfaktors (b) und des fünften Wertes ($b'_{est}$) des transformierten ersten Quellreflexionsfaktors (b') und des ersten Lastreflexionsfaktors (a) und des dritten Wertes ($a'_{est}$) des transformierten ersten Lastreflexionsfaktors (a'),
d) Bestimmen des zweiten Anpassnetzwerks ($M_2$) anhand des zweiten Quellreflexionsfaktors (d) und des sechsten Wertes ($d'_{est}$) des transformierten zweiten Quellreflexionsfaktors (d') und des zweiten Lastreflexionsfaktors (c) und des vierten Wertes ($c'_{est}$) des transformierten zweiten Lastreflexionsfaktors (c').

**8.** Elektronische Schaltung,

- mit zumindest einem Quellenelement ($Q_1$, $Q_2$),
- mit zumindest einer Last (L) und
- mit zumindest einem Anpassnetzwerk ($M_1$, $M_2$), das durch ein Verfahren nach einem der Ansprüche 1 bis 7 ausgelegt ist.

**9.** Elektronische Schaltung nach Anspruch 8,

- mit einem ersten Quellenelement ($Q_1$), einem zweiten Quellenelement ($Q_2$), einem ersten Anpassnetzwerk ($M_1$) und einem zweiten Anpassnetzwerk ($M_2$),
- bei der das erste Anpassnetzwerk ($M_1$) und das zweite Anpassnetzwerk ($M_2$) durch ein Verfahren nach Anspruch 6 ausgelegt sind,
- bei der das zweite Quellenelement ($Q_2$) zur Ausgabe eines Signals (S) mit einer Mittenfrequenz (f) ausgebildet ist,
- bei der die Last (L) eine Lastimpedanz ($Z_L$) aufweist,
- bei der das zweite Anpassnetzwerk ($M_2$) leitungsartige Serienelemente ($L_{S1}...L_{S20}$) aufweist, die das Signal (S) führen,
- wobei die leitungsartigen Serienelemente ($L_{S1}...L_{S20}$) ausschließlich Leitungsimpedanzen ($Z_{S1}...Z_{S20}$) kleiner als die Lastimpedanz ($Z_L$) aufweisen
oder
- wobei eine Summe der elektrischen Längen derjenigen leitungsartigen Serienelemente ($L_{S1}...L_{S20}$), die jeweils eine Leitungsimpedanz ($Z_{S1}...Z_{S20}$) größer als die Lastimpedanz ($Z_L$) aufweisen, kleiner ist als ein Viertel einer dem Signal (S) zugehörigen Wellenlänge ($\lambda$) .

## Claims

**1.** Method of designing an electronic circuit,

- wherein the circuit comprises a first matching network ($M_1$) with a first connection ($A_1$) and a second connection ($A_2$),
- wherein the circuit has a load (L) connected with the first connection ($A_1$),
- wherein a first load reflection factor ($a_{on}$) dependent on the load (L) is produced at the first connection ($A_1$),
- wherein the circuit comprises a source element ($Q_1$), which is connected with the second connection ($A_2$), with a first source reflection factor ($b_{on}$) and
- wherein a transformed first load reflection factor ($a_{on}'$) is produced in the second connection ($A_2$), and a transformed first source reflection factor ($b_{on}'$) is produced in the first connection ($A_1$), by the first matching network ($M_1$),

comprising the steps:

a) determining a first value ($b_{on}'_{opt}$) of the transformed first source reflection factor ($b_{on}'$) and a second value ($a_{on}'_{opt}$) of the transformed first load reflection factor ($a_{on}'$) in that for each first Poincaré spacing ($P_R$) of a number of first Poincaré spacings ($P_R$)

- a first Poincaré circle ($K_1$) as a quantity of all points at the first Poincaré spacing ($P_R$) is determined from the complex conjugate ($a_{on}*$) of the first load reflection factor ($a_{on}$) by

$$P(y, a_{on}*) = \arctan h\left(\frac{|y - a_{on}*|}{|1 - y * a_{on}*|}\right) \equiv P_R \, ,$$

wherein

y is a point (y) on the first Poincaré circle ($K_1$),
y* is the complex conjugate (y*) of the point (y) on the first Poincaré circle ($K_1$),

$a_{on}*$ is the complex conjugate ($a_{on}*$) of the first load reflection factor ($a_{on}$) and
$P_R$ is the first Poincaré spacing ($P_R$),

- a second Poincaré circle ($K_2$) as a quantity of all points at the first Poincaré spacing ($P_R$) is determined from the complex conjugate ($b_{on}*$) of the first source reflection factor ($b_{on}$) by

$$P(x, b_{on}*) = \arctan h\left(\frac{|x - b_{on}*|}{|1 - x * b_{on}*|}\right) \equiv P_R \,,$$

wherein

$x$ is a point ($x$) on the second Poincaré circle ($K_2$),
$x*$ is the complex conjugate ($x*$) of the point ($x$) on the second Poincaré circle ($K_2$),
$b_{on}*$ is the complex conjugate ($b_{on}*$) of the first source reflection factor ($b_{on}$) and
$P_R$ is the first Poincaré spacing ($P_R$),

- a number of first point pairs ($[y(P_R), x(P_R)]$) is determined, wherein a first pair point ($y(P_R)$) of each point pair ($[y(P_R), x(P_R)]$) is on the first Poincaré circle ($K_1$) and wherein a second pair point ($x(P_R)$) of each point pair ($[y(P_R), x(P_R)]$) is on the second Poincaré circle ($K_2$), and
- a value of a first characteristic magnitude ($G_1$) is determined for each first point pair ($[y(P_R), x(P_R)]$) with the first pair point ($y(P_R)$) equal to a value of the transformed first source reflection factor ($b_{on}'$) and with the second pair point ($x(P_R)$) equal to a value of the transformed first load reflection factor ($a_{on}'$),

wherein the characteristic magnitude ($G_1$) of the circuit is an S parameter or a small signal noise factor or an effective input reflection factor or an effective output reflection factor or an effective output resistance or a Rollet stability factor or a power amplification or an intermodulation product of the order n or a harmonic distortion of nth order or a total harmonic distortion factor or an efficiency of the power amplification or a noise factor or a compression point or a compression power or a compression of the power amplification or a mean of a small signal characteristic magnitude or an integral of a small signal characteristic magnitude or a mismatch between the transformed first source reflection factor ($b_{on}'$) and the first load reflection factor ($a_{on}$),
b) determining

- an optimum ($Max_1$) of the first characteristic magnitude ($G_1$) of all those values of the first characteristic magnitude ($G_1$) which are associated with the first point pairs ($[y(P_R), x(P_R)]$),
- a first value pair ($[y_{opt}, x_{opt}]$) from the first point pairs ($[y(P_R), x(P_R)]$), wherein the optimum ($Max_1$) is associated with the first value pair ($[y_{opt}, x_{opt}]$),
- the first value ($b_{on}'_{opt}$) of the transformed first source reflection factor ($b_{on}'$) equal to a first value point ($y_{opt}$) of the first value pair ($[y_{opt}, x_{opt}]$),
- the second value ($a_{on}'_{opt}$) of the transformed first load reflection factor ($a_{on}'$) equal to a second value point ($x_{opt}$) of the first value pair ($[y_{opt}, x_{opt}]$),

wherein the optimum ($Max_1$) is a local or global minimum or maximum of the characteristic magnitude ($G_1$),
c) determining the first matching network ($M_1$) on the basis of the first value ($b_{on}'_{opt}$) of the transformed first source reflection factor ($b_{on}'$) and the second value ($a_{on}'_{opt}$) of the transformed first load reflection factor ($a_{on}'$) as well as the first source reflection factor ($b_{on}$) and the first load reflection factor ($a_{on}$).

2. Method according to claim 1, comprising the further steps:

d) determining a first function ($f_{aon,aon',\varphi}$) which describes the transformation action of the first matching network ($M_1$) in forward direction (V), wherein the first function ($f_{aon,aon',\varphi}$) is defined by

$$f_{a_{on},a_{on}',\varphi}(z_1) = e^{i\varphi} \frac{z_1 - z_0}{1 - z_0 * z_1}$$

wherein

$$z_0 = \frac{1 - |a_{on}|^2}{|a_{on}|^2 |a_{on}'|^2 - 1} a_{on}' e^{-i\varphi} - \frac{1 - |a_{on}'|^2}{|a_{on}|^2 |a_{on}'|^2 - 1} a_{on}$$

wherein

$a_{on}$ is the first load reflection factor ($a_{on}$),
$a_{on}'$ is the transformed first load reflection factor ($a_{on}'$),
$\varphi \in [0...2\pi[$ a parameter,

$i = \sqrt[2]{-1}$ and

$z_1$ is a first argument of the first function ($f_{aon,aon',\varphi}$),

e) determining a second function ($f^R_{aon,aon',\varphi}$) which describes the transformation action of the first matching network ($M_1$) in backward direction (R), wherein the second function ($f^R_{aon,aon',\varphi}$) is defined by

$$f^R_{a_{on},a_{on}',\varphi}(z_2) = e^{i\varphi} \frac{z_2 - z_0^R}{1 - z_0^R * z_2}$$

wherein

$$z_0^R = \frac{1 - |a_{on}'^*|^2}{|a_{on}'^*|^2 |a_{on}^*|^2 - 1} a_{on}^* e^{-i\varphi} - \frac{1 - |a_{on}^*|^2}{|a_{on}'^*|^2 |a_{on}^*|^2 - 1} a_{on}'^* ,$$

wherein

$a_{on}$ is the first load reflection factor ($a_{on}$),
$a_{on}^*$ is the complex conjugate ($a_{on}^*$) of the first load reflection factor ($a_{on}$),
$a_{on}'$ is the transformed first load reflection factor ($a_{on}'$),
$a_{on}'^*$ is the complex conjugate ($a_{on}'^*$) of the transformed first load reflection factor ($a_{on}'$),
$\varphi \in [0...2\pi[$ the parameter and
$z_2$ is a second argument of the second function ($f^R_{aon,aon',\varphi}$),

f) determing a value of the parameter for the optimim ($Max_1$) of the first characteristic magnitude ($G_1$), in that

- the number of the first Poincaré spacings ($P_R$) is equal to one, and the first Poincaré spacing ($P_R$) between the transformed first load reflection factor ($a_{on}'$) and the complex conjugate ($b_{on}^*$) of the first source reflection factor ($b_{on}$) is determined by

$$P_{a_{on}',b_{on}^*} = \arctan h\left(\frac{|a_{on}' - b_{on}^*|}{|1 - b_{on}^* * a_{on}'^*|}\right) \equiv P_R ,$$

wherein

$b_{on}$ is the first source reflection factor ($b_{on}$),
$b_{on}^*$ is the complex conjugate ($B_{on}^*$) of the first source reflection factor ($b_{on}$),
$a_{on}'$ is the transformed first load reflection factor ($a_{on}'$) and

$P_R$ is the first Poincaré spacing ($P_R$),

- the value of the parameter is determined, wherein for the value of the parameter the second function ($fR_{aon,aon',\varphi}$) with the source reflection factor ($b_{on}$) as second argument adopts the first value ($b_{on}'_{opt}$) of the transformed first source reflection factor ($b_{on}'$) as function value,

g) determining the first matching network ($M_1$) on the basis of the first function ($f_{aon,aon',\varphi opt}$) for the value of the parameter.

3.   Method according to any one of the preceding claims,

- in which the first characteristic magnitude ($M_1$) is a mismatch between the transformed first source reflection factor ($b_{on}'$) and the first load reflection factor ($a_{on}$).

4.   Method according to any one of the preceding claims,

- in which as boundary condition a predetermined mismatch between the transformed first source reflection factor ($b_{on}'$) and the first load reflection factor ($a_{on}$) is a part of the first characteristic magnitude ($G_1$).

5.   Method of designing an electronic circuit,

- wherein the circuit comprises a second matching network ($M_2$) with a third connection ($A_3$) and a fourth connection ($A_4$),
- wherein the circuit comprises a variable load (L), which is connected with the third connection ($A_3$), with a first operating state (off) and a second operating state (on) and wherein a second load reflection factor ($c_{on}$) is produced in the second operating state (on), and a third load reflection factor ($c_{off}$) is produced in the first operating state (off), at the third connection ($A_3$) and
- wherein a transformed second load reflection factor ($c_{on}'$) is produced in the fourth connection ($A_4$) in the second operating state and a transformed third load reflection factor ($c_{off}'$) is produced in the fourth connection ($A_4$) in the first operating state by the second matching network ($M_2$),

comprising the steps:

a) determining a third value ($c_{off,opt}$) of the third load reflection factor ($C_{off}$) and a fourth value ($c_{on,opt}$) of the second load reflection factor ($c_{on}$), in that

- a third Poincaré spacing ($P_3$) between the transformed second load reflection factor ($c_{on'}$) and the transformed third load reflection factor ($c_{off'}$) is determined by

$$P_3 = \arctan h\left(\frac{\left|c_{off}' - c_{on}'\right|}{\left|1 - c_{off}'^* c_{on}'\right|}\right),$$

wherein

$c_{on}'$ is the transformed second load reflection factor ($c_{on}'$),
$c_{off}'$ is the transformed third load reflection factor ($c_{off}'$),
$c_{off}'^*$ is the complex conjugate ($c_{off}'$) of the transformed third load reflection factor ($c_{off}'$) and
$P_3$ is the third Poincaré spacing ($P_3$),

- a third Poincaré circle ($K_3$) as a quantity of all points at the third Poincaré spacing ($P_3$) is determined from the second load reflection factor ($c_{on}$) by

$$P(z, c_{on}) = \arctan h\left(\frac{|z - c_{on}|}{|1 - z * c_{on}|}\right) \equiv P_3 ,$$

wherein

z is a point on the third Poincaré circle ($K_3$),
z* is the complex conjugate (z*) of the point (z) on the third Poincaré circle ($K_3$),
$c_{on}$ is the second load reflection factor ($c_{on}$),
$c_{on}$* is the complex conjugate (con*) of the second load reflection factor ($C_{on}$) and
$P_3$ is the third Poincaré spacing ($P_3$),

- a number of second point pairs ($[c_{on}, z(P_3)]$) is determined, wherein a second pair point ($z(P_3)$) of each second point pair ($[c_{on}, z(P_3)]$) is a point on the third Poincaré circuit ($K_3$),
- a value of a second characteristic magnitude ($G_2$) is determined for each second point pair ($[c_{on}, z(P_3)]$), wherein a value of the third load reflection factor ($C_{off}$) is equal to the second pair point ($z(P_3)$) and wherein a value of the second load reflection factor ($C_{on}$) is equal to the first pair point ($c_{on}$),
- an optimum ($Max_2$) of the second characteristic magnitude ($G_2$) is determined from all those values of the second characteristic magnitude ($G_2$) associated with the second point pairs ($[c_{on}, z(P_3)]$),
- a second point pair ($[c_{on,opt}, c_{off,opt}]$) associated with the optimum ($Max_2$) is determined,
- the third value ($c_{off,opt}$) of the third load reflection factor ($C_{off}$) is determined equal to a second pair point ($c_{off,opt}$), which is associated with the optimum ($Max_2$), of the second point pair ($[c_{on,opt}, c_{off,opt}]$) associated with the optimum ($max_2$) and
- the fourth value ($c_{on,opt}$) of the second load reflection factor ($c_{on}$) is determined equal to a first pair point ($c_{on}$), which is associated with the optimum ($Max_2$), of the second point pair ($[c_{on,opt}, c_{off,opt}]$) associated with the optimum ($Max_2$),

wherein the characteristic magnitude ($G_2$) of the circuit is an S parameter or a small signal noise factor or an effective input reflection factor or an effective output reflection factor or an effective output resistance or a Rollet stability factor or a power amplification or an intermodulation product of the order n or a harmonic distortion of nth order or a total harmonic distortion factor or an efficiency of the power amplification or a noise factor or a compression point or a compression power or a compression of the power amplification or a mean of a small signal characteristic magnitude or an integral of a small signal characteristic magnitude or a mismatch between the transformed first source reflection factor ($b_{on}$') and the first load reflection factor ($a_{on}$),
wherein the optimum ($max_2$) is a local or global minimum or maximum of the characteristic magnitude ($G_2$),
b) determining the second matching network ($M_2$) on the basis of the third value ($c_{off,opt}$) of the third load reflection factor ($c_{off}$), the fourth value ($c_{on,opt}$) of the second load reflection factor ($c_{on}$), the transformed second load reflection factor ($c_{on}$') and the transformed third load reflection factor ($c_{off}$').

6. Method of designing an electronic circuit, in which

- the circuit has a first operating state (off) and a second operating state (on),
- the circuit has a first source element ($Q_1$) with a first source output ($QA_1$) and a second source element ($Q_2$) with a second source output ($QA_2$),
- the first source element ($Q_1$) has in the first source output ($QA_1$) a first source reflection factor ($b_{off}$) in the first operating state (off),
- the circuit has a load (L) with a load input (LE),
- the load (L) has in the load input (LE) a load input reflection factor ($\Gamma$),
- the circuit has a T-piece (T) with a first input ($E_1$), a second input ($E_2$) and an output ($E_3$),
- the load input (LE) is connected with the output ($E_3$) of the T-piece (T),
- the T-piece (T) has in the first input ($E_1$) a first load reflection factor ($a_{on}$) in the second operating state (on)
- the T-piece (T) has in the second input ($E_2$) a second load reflection factor ($C_{off}$) in the first operating state (off),
- the T-piece (T) has in the second input ($E_2$) a third load reflection factor ($c_{on}$) in the second operating state (on),
- the first circuit has a first matching network ($M_1$) with a first connection ($A_1$) and a second connection ($A_2$),
- the first connection ($A_1$) is connected with the first input ($E_1$) of the T-piece (T),
- the second connection ($A_2$) is connected with the first source output ($QA_1$),
- the first matching network ($M_1$) has in the first connection ($A_1$) a transformed first source reflection factor ($b_{off}$')

in the first operating state (off),
- the first matching network ($M_1$) has in the second connection ($A_2$) a transformed first load reflection factor ($a_{on}'$) in the second operating state (on),
- the circuit has a second matching network ($M_2$) with a third connection ($A_3$) and a fourth connection ($A_4$),
- the third connection ($A_3$) is connected with the second input ($E_2$) of the T-piece (T),
- the fourth connection ($A_4$) is connected with the second source output ($QA_2$),
- the second matching network ($M_2$) has in the fourth connection ($A_4$) a transformed second load reflection factor ($c_{off}'$) in the first operating state (off),
- the second matching network ($M_2$) has in the fourth connection ($A_4$) a transformed third load reflection factor ($c_{on}'$) in the second operating state (on),
- a first value ($a_{on\,opt}'$) of the transformed first load reflection factor ($a_{on}'$) for optimisation of a characteristic magnitude ($G_1$) of the circuit in the second operating state (on) is determined by measurement,
- a second value ($c_{off\,opt}'$) of the transformed second load reflection factor ($c_{off}'$) for optimisation of the characteristic magnitude ($G_1$) of the circuit in the first operating state (off) is determined by measurement,
- a third value ($c_{on\,opt}'$) of the transformed third load reflection factor ($c_{on}'$) for optimisation of the characteristic magnitude ($G_1$) of the circuit in the second operating state (on) is determined by measurement,
- the first load reflection factor ($a_{on}$) is fixed at a first start value,
- the second load reflection factor ($c_{on}$) is fixed at a second start value.

wherein the characteristic magnitude ($G_2$) of the circuit is an S parameter or a small signal noise factor or an effective input reflection factor or an effective output reflection factor or an effective output resistance or a Rollet stability factor or a power amplification or an intermodulation product of the order n or a harmonic distortion of nth order or a total harmonic distortion factor or an efficiency of the power amplification or a noise factor or a compression point or a compression power or a compression of the power amplification or a mean of a small signal characteristic magnitude or an integral of a small signal characteristic magnitude or a mismatch between the transformed first source reflection factor ($b_{on}'$) and the first load reflection factor ($a_{on}$),
wherein for optimisation of the characteristic magnitude ($G_2$) a local or global minimum or maximum of the characteristic magnitude ($G_2$) is sought,
comprising the steps:

a) calculating a first Poincaré spacing ($P_1$) between the first value ($a_{on\,opt}'$) and the complex conjugate ($b_{off}^*$) of the first source reflection factor ($b_{off}$) by

$$P_1 = \arctan h\left(\frac{\left|a_{on\,opt}' - b_{off}^*\right|}{\left|1 - b_{off}^* \, a_{on\,opt}'^*\right|}\right),$$

wherein

$b_{off}^*$ is the complex conjugate ($b_{off}^*$) of the first source reflection factor ($b_{off}$),
$a_{on\,opt}'$ is the first value ($a_{on\,opt}'$) of the transformed first load reflection factor ($a_{on}'$) and
$P_1$ is the first Poincaré spacing ($P_1$),

b) determining a first Poincaré circle ($K_1$) as a quantity of all points at the first Poincaré spacing ($P_1$) from the complex conjugate ($a_{on}^*$) of the first load reflection factor ($a_{on}$) by

$$P(y, a_{on}^*) = \arctan h\left(\frac{\left|y - a_{on}^*\right|}{\left|1 - y^* \, a_{on}\right|^*}\right) \equiv P_1,$$

wherein

$y$ is a point on the first Poincaré circle ($K_1$),
$y^*$ is the complex conjugate ($y^*$) of the point ($y$) on the first Poincaré circle ($K_1$),
$a_{on}^*$ is the complex conjugate ($a_{on}^*$) of the first load reflection factor ($a_{on}$) and

$P_1$ is the first Poincaré spacing ($P_1$),

c) determining a third Poincaré spacing ($P_3$) between the second value ($c_{off}{}'_{opt}$) and the third value ($c_{on}{}'_{opt}$) by

$$P_3 = \operatorname{arctan} h\left(\frac{\left|c_{on}{}'_{opt} - c_{off}{}'_{opt}\right|}{\left|1 - c_{on}{}'_{opt} * c_{off}{}'_{opt}\right|}\right),$$

wherein

$c_{off}{}'_{opt}$ is the second value ($c_{off}{}'_{opt}$) of the transformed second load reflection factor ($c_{off}'$),
$c_{on}{}'_{opt}$ is the third value ($c_{on}{}'_{opt}$) of the transformed third load reflection factor ($c_{on}'$),
$c_{on}{}'_{opt}*$ is the conjugate complex ($c_{on}{}'_{opt}*$) of the third value ($c_{on}{}'_{opt}$) of the transformed third load reflection factor ($c_{on}'$) and
$P_3$ is the third Poincaré spacing ($P_3$),

d) determining a third Poincaré circle ($K_3$) is a quantity of all points at the third Poincaré spacing ($P_3$) from the third load reflection factor ($C_{on}$) by

$$P(z, c_{on}) = \operatorname{arctan} h\left(\frac{\left|z - c_{on}\right|}{\left|1 - z * c_{on}\right|}\right) \equiv P_3,$$

wherein

z is a point on the third Poincaré circle ($K_3$),
z* is the complex conjugate (z*) of the point (z) on the third Poincaré circle ($K_3$),
$c_{on}$ is the third load reflection factor ($c_{on}$),
$c_{on}*$ is the complex conjugate ($c_{on}*$) of the third load reflection factor ($C_{on}$) and
$P_3$ is the third Poincaré spacing ($P_3$),

e) determining a changed first Poincaré circle ($K_1'$), wherein the changed first Poincaré circle ($K_1'$) is determined as a quantity of all changed reflections factors (y'), wherein a total impedance is associated with each of the changed reflection factors (y'), wherein each total impedance is determined from a first parallel connection of a load impedance of the load (L) and an impedance associated with a reflection factor (y) on the first Poincaré circle ($K_1$), wherein the load impedance is associated with the load input reflection factor ($\Gamma$) of the load (L),

f) determining at least one fourth value ($c_{off,1}$, $c_{off,2}$) of the second load reflection factor ($c_{off}$), wherein for the at least one fourth value a sum-of-squares of spacings between the fourth value ($c_{off,1}$, $c_{off,2}$) and the third Poincaré circle ($K_3$) as well as between the fourth value ($c_{off,1}$, $c_{off,2}$) and the changed first Poincaré circle ($K_1'$) is minimised,

g) determining a fifth value ($b_{off}'_1$, $b_{off}'_2$) of the transformed first source reflection factor ($b_{off}'$) with respect to each fourth value ($c_{off,1}$, $c_{off,2}$) of the second load reflection factor ($c_{off}$), wherein a fourth impedance is determined, wherein the fourth impedance is associated with the fourth value ($c_{off,1}$, $c_{off,2}$) of the second load reflection factor ($c_{off}$), wherein a fifth impedance is determined so that a second parallel connection of the fifth impedance with the load impedance is equal to the fourth impedance and wherein the fifth value ($b_{off}'_1$, $b_{off}'_2$) of the transformed first source reflection factor ($b_{off}'$) is associated with the fifth impedance,

h) determining the first matching network ($M_1$) on the basis of the first load reflection factor ($a_{on}$), the first value ($a_{on}{}'_{opt}$) of the transformed first load reflection factor ($a_{on}'$), the first source reflection factor ($b_{off}$) and the fifth value ($b_{off}'_1$, $b_{off}'_2$) of the transformed first source reflection factor ($b_{off}'$) and

i) determining the second matching network ($M_2$) on the basis of the second value ($c_{off}{}'_{opt}$) of the transformed second load reflection factor ($c_{off}'$), the third value ($c_{on}{}'_{opt}$) of the transformed third load reflection factor ($c_{on}'$), the third load reflection factor ($c_{on}$) and the fourth value ($c_{off,1}$, $c_{off,2}$) of the second load reflection factor ($c_{off}$).

7. Method of designing an electronic circuit, in which

- the circuit has a first source element ($Q_1$) with a first source output ($QA_1$) and with a first source reflection factor (b),
- the circuit has a second source element ($Q_2$) with a second source output ($QA_2$) and with a second source reflection factor (d),
- the circuit has a load (L),
- the circuit has a T-piece (T) with a first input ($E_1$), a second input ($E_2$) and an output ($E_3$),
- the T-piece (T) has in the first input ($E_1$) a first load reflection factor (a),
- the T-piece (T) has in the second input ($E_2$) a second load reflection factor (c),
- the output ($E_3$) of the T-piece (T) is connected with the load (L),
- the circuit has a first matching network ($M_1$) with a first connection ($A_1$) and a second connection ($A_2$),
- the second connection ($A_2$) is connected with the first source output ($QA_1$) and the first connection ($A_1$) is connected with the first input ($E_1$) of the T-piece (T),
- a transformed first load reflection factor (a') is produced in the second connection ($A_2$) and a transformed first source reflection factor (b') is produced in the first connection ($A_1$) by the first matching network ($M_1$)
- the circuit has a second matching network ($M_2$) with a third connection ($A_3$) and a fourth connection ($A_4$),
- the fourth connection ($A_4$) is connected with the second source output ($QA_2$) and the third connection ($A_3$) is connected with the second input ($E_2$) of the T-piece (T),
- a transformed second load reflection factor (c') is produced in the fourth connection ($A_4$) and a transformed second source reflection factor (d') is produced in the third connection ($A_3$) by the second matching network ($M_2$),
- a first value ($a'_{opt}$) of the transformed first load reflection factor (a') is determined, wherein the first source element ($Q_1$) has for the first value ($a'_{opt}$), which is effective at the first source output ($QA_1$), of the transformed first load reflection factor (a') a first optimum ($Max_1$) of a first characteristic magnitude ($G_1$), wherein the first value ($a'_{opt}$) of the transformed first load reflection factor (a') differs from the complex conjugate of the first source reflection factor (b),
- a second value ($c'_{opt}$) of the transformed second load reflection factor (c') is determined, wherein the second source element ($Q_2$) has for the second value ($c'_{opt}$), which is effective at the second source output ($QA_2$), of the transformed second load reflection factor (c') a second optimum ($Max_2$) of a second characteristic magnitude ($G_2$), wherein the second value ($c'_{opt}$) of the transformed second load reflection factor (c') differs from the complex conjugate of the second source reflection factor (d),

wherein the characteristic magnitude ($G_1$, $G_2$) of the circuit is an S parameter or a small signal noise factor or an effective input reflection factor or an effective output reflection factor or an effective output resistance or a Rollet stability factor or a power amplification or an intermodulation product of the order n or a harmonic distortion of nth order or a total harmonic distortion factor or an efficiency of the power amplification or a noise factor or a compression point or a compression power or a compression of the power amplification or a mean of a small signal characteristic magnitude or an integral of a small signal characteristic magnitude or a mismatch between the transformed first source reflection factor ($b_{on}'$) and the first load reflection factor ($a_{on}$),
wherein the optimum ($Max_1$, $Max_2$) is a local or global minimum or maximum of the characteristic magnitude ($G_1$, $G_2$), comprising the steps:

a) determining a spacing value ($P_{aus}$) and a third value ($a'_{est}$) of the transformed first load reflection factor (a') and a fourth value ($c'_{est}$) of the transformed second load reflection factor (c'), in that

- a first Poincaré spacing ($P_1$) between the first value ($a'_{opt}$) and the transformed first load reflection factor (a') is defined by

$$P_1 = \arctan h\left(\frac{|a'_{opt} - a'|}{|1 - a'^* a'_{opt}|}\right),$$

wherein

$P_1$ is the first Poincaré spacing ($P_1$),
a' is the transformed first load reflection factor (a'),
a'* is the complex conjugate (a'*) of the transformed first load reflection factor (a') and
$a'_{opt}$ is the first value ($a'_{opt}$),

- a second Poincaré spacing ($P_2$) between the second value ($c'_{opt}$) and the transformed second load reflection factor (c') is defined by

$$P_2 = \arctan h \left( \frac{\left| c'_{opt} - c' \right|}{\left| 1 - c'^* c'_{opt} \right|} \right),$$

wherein

$P_2$ is the second Poincaré spacing ($P_2$),
c' is the transformed second load reflection factor (c'),
c'* is the complex conjugate (c'*) of the transformed second load reflection factor (c') and
$c'_{opt}$ is the second value ($c'_{opt}$),

- a third Poincaré spacing ($P_3$) between the transformed first load reflection factor (a') and the complex conjugate (b*) of the first source reflection factor (b) is defined by

$$P_3 = \arctan h \left( \frac{\left| a' - b^* \right|}{\left| 1 - ba' \right|} \right),$$

wherein

$P_3$ is the third Poincaré spacing ($P_3$),
b is the first source reflection factor (b),
b* is the complex conjugate (b*) of the first source reflection factor (b) and
a* is the transformed first load reflection factor (a'),

- a fourth Poincaré spacing ($P_4$) between the transformed second load reflection factor (c') and the complex conjugate (d*) of the second source reflection factor (d) is defined by

$$P_4 = \arctan h \left( \frac{\left| c' - d^* \right|}{\left| 1 - dc' \right|} \right),$$

, wherein

$P_4$ is the fourth Poincaré spacing ($P_4$),
d is the second source reflection factor (d),
d* is the complex conjugate (d*) of the second source reflection factor (d) and
c' is the transformed second load reflection factor (c'),

- the spacing value ($P_{aus}$) and the third value ($a'_{est}$) and the fourth value ($c'_{est}$) are defined in that
- a minimum of the geometric mean of the first Poincaré spacing ($P_1$) and the second Poincaré spacing ($P_2$) is determined under the boundary condition that the third Poincaré spacing ($P_3$) is equal to the fourth Poincaré spacing ($P_4$) and is different from zero, in that the transformed first load reflection factor (a') and the transformed second load reflection factor (c') are varied and the complex conjugate (b*) of the first source reflection factor (b), the complex conjugate (d*) of the second source reflection factor (d), the first value ($a'_{opt}$) and the second value ($c'_{opt}$) have a fixed value, and
- the value, which is associated with the minimum, of the third Poincaré spacing ($P_3$) is fixed as spacing value ($P_{aus}$), the value, which is associated with the minimum, of the transformed first load reflection factor (a') is fixed as third value ($a'_{est}$) and the value, which is associated with the minimum, of the transformed second load reflection factor (c') is fixed as fourth value ($c'_{est}$),

b) determining a fifth value (b'$_{est}$) of the transformed first source reflection factor (b') and a sixth value (d'$_{est}$) of the transformed second source reflection factor (d'), in that

- a first Poincaré circle (K$_1$) with a real centre point is determined, which intersects a real reflection factor value of a third (1/3) and a real reflection factor value of minus one (-1),
- a second Poincaré circle (K$_2$) as a quantity of all points (y) with a spacing from the real reflection factor of a third (1/3) equal to the spacing value (P$_{aus}$) is determined by

$$P\left(y, \frac{1}{3}\right) = \operatorname{arctan} h \left( \frac{\left| y - \frac{1}{3} \right|}{\left| 1 - y\frac{1}{3} \right|} \right) \equiv P_{aus},$$

wherein

y is a point (y) on the second Poincaré circle (K$_2$) and
P$_{aus}$ is the spacing value (P$_{aus}$) of the third spacing (P$_3$),

- the fifth value (b'$_{est}$) is determined as a value of a first intersection point, and the sixth value (d'$_{est}$) is determined as a value of a second intersection point different from the first intersection point, between the first Poincaré circle (K$_1$) and the second Poincaré circle (K$_2$),

c) determining the first matching network (M$_1$) on the basis of the first source reflection factor (b) and the fifth value (b'$_{est}$) of the transformed first source reflection factor (b') and the first load reflection factor (a) and the third value (a'$_{est}$) of the transformed first load reflection factor (a'),
d) determining the second matching network (M$_2$) on the basis of the second source reflection factor (d) and the sixth value (d'$_{est}$) of the transformed second source reflection factor (d') and the second load reflection factor (c) and the fourth value (c'$_{est}$) of the transformed second load reflection factor (c').

8. Electronic circuit,

- with at least one source element (Q$_1$, Q$_2$),
- with at least one load (L) and
- with at least one matching network (M$_1$, M$_2$), which is designed by a method according to any one of claims 1 to 7.

9. Electronic circuit according to claim 8,

- with a first source element (Q$_1$), a second source element (Q$_2$), a first matching network (M$_1$) and a second matching network (M$_2$),

in which

- the first matching network (M$_1$) and the second matching network (M$_2$) are designed by a method according to claim 6,
- the second source element (Q2) is constructed for output of a signal (S) with a centre frequency (f),
- the load (L) has a load impedance (Z$_L$) and
- the second matching network (M$_2$) has line- like series elements (L$_{S1}$...L$_{S20}$) which conduct the signal (S),
- wherein the line- like series elements (L$_{S1}$...L$_{S20}$) have exclusively line impedances (Z$_{S1}$...Z$_{S20}$) smaller than the load impedance (Z$_L$)
or
- wherein a sum of the electrical lengths of those line- like series elements (L$_{S1}$...L$_{S20}$) respectively having a line impedance (Z$_{S1}$...Z$_{S20}$) greater than the load impedance (Z$_L$) is smaller than a quarter of a wavelength ($\lambda$) associated with the signal (S).

**Revendications**

1. Procédé de conception d'un circuit électronique,

- dans lequel le circuit présente un premier réseau d'adaptation ($M_1$) avec un premier raccord ($A_1$) et un deuxième raccord ($A_2$);
- dans lequel le circuit présente une charge (L) reliée au premier raccord ($A_1$);
- dans lequel on provoque au premier raccord ($A_1$) un premier facteur de réflexion de charge ($a_{on}$) dépendant de la charge (L);
- dans lequel le circuit présente un élément de source ($Q_1$) relié au deuxième raccord ($A_2$), avec un premier facteur de réflexion de source ($b_{on}$);
- dans lequel on provoque par le premier réseau d'adaptation ($M_1$) dans le deuxième raccord ($A_2$) un premier facteur de réflexion de charge transformé ($a_{on}'$) et dans le premier raccord ($A_1$) un premier facteur de réflexion de source transformé ($b_{on}'$),

avec les étapes suivantes:

a) détermination d'une première valeur ($b_{on}'_{opt}$) du premier facteur de réflexion de source transformé ($b_{on}'$) et d'une deuxième valeur ($a_{on}'_{opt}$) du premier facteur de réflexion de charge transformé ($a_{on}'$), par le fait que, pour chaque première distance de Poincaré ($P_R$) d'un nombre de premières distances de Poincaré ($P_R$),

- on détermine un premier disque de Poincaré ($K_1$) comme l'ensemble de tous les points dans la première distance de Poincaré ($P_R$) du conjugué complexe ($a_{on}*$) du premier facteur de réflexion de charge ($a_{on}$) par l'équation

$$P(y, a_{on}*) = \operatorname{arctanh}\left(\frac{|y - a_{on}*|}{|1 - y * a_{on}*|}\right) \equiv P_R \,.$$

dans laquelle

y est un point (y) sur le premier disque de Poincaré ($K_1$),
y* est le conjugué complexe (y*) du point (y) sur le premier disque de Poincaré ($K_1$),
$a_{on}*$ est le conjugué complexe ($a_on*$) du premier facteur de réflexion de charge ($a_{on}$), et
$P_R$ est la première distance de Poincaré ($P_R$), - on détermine un deuxième disque de Poincaré ($K_2$) comme l'ensemble des points dans la première distance de Poincaré ($P_R$) du conjugué complexe ($b_{on}*$) du premier facteur de réflexion de source ($b_{on}$) par l'équation

$$P(x, b_{on}*) = \operatorname{arctanh}\left(\frac{|x - b_{on}*|}{|1 - x * b_{on}*|}\right) \cong P_R \,.$$

dans laquelle

x est un point (x) sur le deuxième disque de Poincaré ($K_2$),
x* est le conjugué complexe (x*) du point (x) sur le deuxième disque de Poincaré ($K_2$),
$b_{on}*$ est le conjugué complexe ($b_{on}*$) du premier facteur de réflexion de source ($b_{on}$), et
$P_R$ est la première distance de Poincaré ($P_R$),

- on détermine un nombre de premières paires de points ([$y(P_R)$, $x(P_R)$]), dans lequel un premier point de paire ($y(P_R)$) de chaque paire de points ([$y(P_R)$, $x(P_R)$]) est sur le premier disque de Poincaré ($K_1$), et dans lequel un deuxième point de paire ($x(P_R)$) de chaque paire de points ([$y(P_R)$, $x(P_R)$]) est sur le deuxième disque de Poincaré ($K_2$), et
- on détermine une valeur d'une première caractéristique ($G_1$) pour chaque première paire de points ([$y(P_R)$, $x(P_R)$]) avec le premier point de paire ($y(P_R)$) égale à une valeur du premier facteur de réflexion de source transformé ($b_{on}'$) et avec le deuxième point de paire ($x(P_R)$) égale à une valeur du premier facteur

de charge transformé ($a_{on}$'),

dans lequel la caractéristique ($G_1$) du circuit est un paramètre S ou un facteur petit signal-bruit ou un facteur de réflexion d'entrée effectif ou un facteur de réflexion de sortie effectif ou une résistance de sortie effective ou un facteur de stabilité de Rollet ou une amplification de puissance ou un produit d'intermodulation d'ordre n ou une distorsion harmonique d'ordre n ou un facteur de distorsion harmonique ou un rendement de l'amplification de puissance ou un taux de bruit ou un point de compression ou une puissance de compression ou une compression de l'amplification de puissance ou une moyenne d'une caractéristique de petit signal ou une intégrale d'une caractéristique de petit signal ou une désadaptation entre le premier facteur de réflexion de source transformé ($b_{on}$') et le premier facteur de réflexion de charge ($a_{on}$),
b) détermination

- d'un optimum ($Max_1$) de la première caractéristique ($G_1$) à partir de toutes les valeurs de la première caractéristique ($G_1$), qui sont associées aux premières paires de points ([$y(P_R)$, $x(P_R)$]),
- d'une première paire de valeurs ([$y_{opt}$, $x_{opt}$]) à partir des premières paires de points ([$y(P_R)$, $x(P_R)$]), où l'optimum ($Max_1$) est associé à la première paire de valeurs ([$y_{opt}$, $x_{opt}$]),
- de la première valeur ($b_{on}{'}_{opt}$) du premier facteur de réflexion de source transformé ($b_{on}$') égale à un premier point de valeur ($y_{opt}$) de la première paire de valeurs ([$y_{opt}$, $x_{opt}$]),
- de la deuxième valeur ($a_{on}{'}_{opt}$) du premier facteur de réflexion de charge transformé ($a_{on}$') égale à un deuxième point de valeur ($x_{opt}$) de la première paire de valeurs ([$y_{opt}$, $X_{opt}$]),

dans lequel l'optimum ($Max_1$) est un minimum ou un maximum local ou global de la caractéristique ($G_1$),
c) détermination du premier réseau d'adaptation ($M_1$) à l'aide de la première valeur ($b_{on}{'}_{opt}$) du premier facteur de réflexion de source transformé ($b_{on}$'), de la deuxième valeur ($a_{on}{'}_{opt}$) du premier facteur de réflexion de charge transformé ($a_{on}$'), du premier facteur de réflexion de source ($b_{on}$) et du premier facteur de réflexion de charge ($a_{on}$).

2. Procédé selon la revendication 1, avec les étapes supplémentaires suivantes:

d) détermination d'une première fonction ($f_{aon,aon',\varphi}$), qui décrit l'action de transformation du premier réseau d'adaptation ($M_1$) dans le sens direct (V), dans lequel la première fonction ($f_{aon,aon',\varphi}$) est définie par

$$f_{a_{on},a_{on}',\varphi}(z_1) = e^{i\varphi}\frac{z_1 - z_0}{1 - z_0^* z_1}$$

avec

$$z_0 = \frac{1 - |a_{on}|^2}{|a_{on}|^2|a_{on}'|^2 - 1} a_{on}' e^{-i\varphi} - \frac{1 - |a_{on}'|^2}{|a_{on}|^2|a_{on}'|^2 - 1} a_{on} \quad,$$

dans laquelle

$a_{on}$ est le premier facteur de réflexion de charge ($a_{on}$),
$a_{on}$' est le premier facteur de réflexion de charge transformé ($a_{on}$'),
$\varphi \in [0 \dots 2\pi[$ un paramètre,

$i = \sqrt[2]{-1}$ et

$z_1$ est un premier argument de la première fonction ($f_{aon,aon',\varphi}$),

e) détermination d'une deuxième fonction ($f^R_{aon,aon',\varphi}$), qui décrit l'action de transformation du premier réseau

d'adaptation ($M_1$) en direction inverse (R), dans lequel la deuxième fonction ($f^R_{aon,aon',\varphi}$) est définie par l'équation

$$f^R_{a_{on},a_{on}',\varphi}(z_2) = e^{i\varphi}\frac{z_2 - z_0^R}{1 - z_0^{R^*}z_2}$$

avec

$$z_0^R = \frac{1 - |a_{on}'^*|^2}{|a_{on}'^*|^2|a_{on}^*|^2 - 1}a_{on}^*e^{-i\varphi} - \frac{1 - |a_{on}^*|^2}{|a_{on}'^*|^2|a_{on}^*|^2 - 1}a_{on}'^*,$$

dans lesquelles

$a_{on}$ est le premier facteur de réflexion de charge ($a_{on}$),
$a_{on}^*$ est le conjugué complexe ($a_{on}^*$) du premier facteur de réflexion de charge ($a_{on}$),
$a_{on}'$ est le premier facteur de réflexion de charge transformé ($a_{on}'$),
$a_{on}'^*$ est le conjugué complexe ($a_{on}'^*$) du premier facteur de réflexion de charge transformé ($a_{on}'$),
$\varphi \in [0 \ldots 2\pi[$ un paramètre, et
$z_2$ est un deuxième argument de la deuxième fonction ($f^R_{aon,aon',\varphi}$),

f) détermination d'une valeur du paramètre pour l'optimum ($Max_1$) de la première caractéristique ($G_1$), par le fait que

- le nombre des premières distances de Poincaré ($P_R$) est égal à un et que l'on détermine la première distance de Poincaré ($P_R$) entre le premier facteur de réflexion de charge transformé ($a_{on}'$) et le conjugué complexe ($b_{on}^*$) du premier facteur de réflexion de source ($b_{on}$) par l'équation

$$P_{a_{on}',b_{on}^*} = \operatorname{arctanh}\left(\frac{|a_{on}' - b_{on}^*|}{|1 - b_{on}^* a_{on}'^*|}\right) \equiv P_R,$$

dans laquelle

$b_{on}$ est le premier facteur de réflexion de source ($b_{on}$),
$b_{on}^*$ est le conjugué complexe ($b_{on}^*$) du premier facteur de réflexion de source ($b_{on}$),
$a_{on}'$ est le premier facteur de réflexion de charge transformé ($a_{on}'$), et
$P_R$ est la première distance de Poincaré ($P_R$),

- on détermine la valeur du paramètre et, pour la valeur du paramètre, la deuxième fonction ($f^R_{aon,aon}'$, $\varphi$) avec le premier facteur de réflexion de source ($b_{on}$) comme deuxième argument prend la première valeur ($b_{on}'{}_{opt}$) du premier facteur de réflexion de source transformé ($b_{on}'$) comme valeur de fonction,

g) détermination du premier réseau d'adaptation ($M_1$) à l'aide de la première fonction ($f_{aon,aon',\varphi opt}$) pour la valeur du paramètre.

3. Procédé selon l'une quelconque des revendications précédentes,

- dans lequel la première caractéristique ($G_1$) est une désadaptation entre le premier facteur de réflexion de source transformé ($b_{on}'$) et le premier facteur de réflexion de charge ($a_{on}$).

**4.** Procédé selon l'une quelconque des revendications précédentes,

- dans lequel, comme condition additionnelle, une désadaptation prédéterminée entre le premier facteur de réflexion de source transformé ($b_{on}'$) et le premier facteur de réflexion de charge ($a_{on}$) est une partie de la première caractéristique ($G_1$).

**5.** Procédé de conception d'un circuit électronique,

- dans lequel le circuit présente un deuxième réseau d'adaptation ($M_2$) avec un troisième raccord ($A_3$) et un quatrième raccord ($A_4$),
- dans lequel le circuit présente une charge variable (L) reliée au troisième raccord ($A_3$) avec un premier état de fonctionnement (off) et un deuxième état de fonctionnement (on), et dans lequel on provoque au troisième raccord ($A_3$) un deuxième facteur de réflexion de charge ($c_{on}$) dans le deuxième état de fonctionnement (on) et un troisième facteur de réflexion de charge ($c_{off}$) dans le premier état de fonctionnement (off),
- dans lequel on provoque, par le deuxième réseau d'adaptation ($M_2$), dans le quatrième raccord ($A_4$), un deuxième facteur de réflexion transformé ($c_{on}'$) dans le deuxième état de fonctionnement et un troisième facteur de réflexion transformé ($c_{off}'$) dans le premier état de fonctionnement,

avec les étapes suivantes:

a) détermination d'une troisième valeur ($c_{off,opt}$) du troisième facteur de réflexion de charge ($c_{off}$) et d'une quatrième valeur ($c_{on,opt}$) du deuxième facteur de réflexion de charge ($c_{on}$), par le fait que

- on détermine une troisième distance de Poincaré ($P_3$) entre le deuxième facteur de réflexion de charge transformé ($c_{on}'$) et le troisième facteur de réflexion de charge transformé ($c_{off}'$) par l'équation

$$P_3 = \operatorname{arctanh}\left(\frac{|c_{off}' - c_{on}'|}{|1 - c_{off}'^* c_{on}'|}\right),$$

dans laquelle

$c_{on}'$ est le deuxième facteur de réflexion de charge transformé ($c_{on}'$),
$c_{off}'$ est le troisième facteur de réflexion de charge transformé ($c_{off}'$),
$c_{off}'^*$ est le conjugué complexe ($c_{off}'^*$) du troisième facteur de réflexion de charge transformé ($c_{off}'$), et
$P_3$ est la troisième distance de Poincaré ($P_3$),

- on détermine un troisième disque de Poincaré ($K_3$) comme l'ensemble de tous les points dans la troisième distance de Poincaré ($P_3$) du deuxième facteur de réflexion de charge ($c_{on}$) par l'équation

$$P(z, c_{on}) = \operatorname{arctanh}\left(\frac{|z - c_{on}|}{|1 - z^* c_{on}|}\right) = P_3,$$

dans laquelle

z est un point sur le troisième disque de Poincaré ($K_3$),
$z^*$ est le conjugué complexe ($z^*$) du point (z) sur le troisième disque de Poincaré ($K_3$),
$c_{on}$ est le deuxième facteur de réflexion de charge ($c_{on}$),
$c_{on}^*$ est le conjugué complexe ($c_{on}^*$) du deuxième facteur de réflexion de charge ($c_{on}$), et
$P_3$ est la troisième distance de Poincaré ($P_3$),

- on détermine un nombre de deuxièmes paires de points ($[c_{on}, z(P_3)]$), dans lequel un deuxième point de paire ($z(P_3)$) de chaque deuxième paire de points ($[c_{on}, z(P_3)]$) est un point sur le troisième disque de Poincaré ($K_3$),
- on détermine une valeur d'une deuxième caractéristique ($G_2$) pour chaque deuxième paire de points ($[c_{on},$

$z(P_3)$]), dans lequel une valeur du troisième facteur de réflexion de charge ($c_{off}$) est égale au deuxième point de paire ($z(P_3)$), et dans lequel une valeur du deuxième facteur de réflexion de charge ($c_{on}$) est égale au premier point de paire ($c_{on}$),

- on détermine un optimum ($Max_2$) de la deuxième caractéristique ($G_2$) à partir de toutes les valeurs de la deuxième caractéristique ($G_2$), qui sont associées aux deuxièmes paires de points ([$c_{on}$, $z(P_3)$]),
- on détermine une deuxième paire de points ([$C_{on,opt}$, $C_{off,opt}$]) appartenant à l'optimum ($Max_2$),
- on détermine la troisième valeur ($c_{off,opt}$) du troisième facteur de réflexion de charge ($c_{off}$) égale à un deuxième point de paire ($c_{off,opt}$) appartenant à l'optimum ($Max_2$) de la paire de points ([$c_{on,opt}$, $c_{off,opt}$]) appartenant à l'optimum ($Max_2$), et
- on détermine la quatrième valeur ($c_{on,opt}$) du deuxième facteur de réflexion de charge ($c_{on}$) égale à un premier point de paire ($c_{on}$) appartenant à l'optimum ($Max_2$) de la deuxième paire de points ([$c_{on,opt}$, $c_{off,opt}$]) appartenant à l'optimum ($Max_2$),

dans lequel la caractéristique ($G_2$) du circuit est un paramètre S ou un facteur petit signal-bruit ou un facteur de réflexion d'entrée effectif ou un facteur de réflexion de sortie effectif ou une résistance de sortie effective ou un facteur de stabilité de Rollet ou une amplification de puissance ou un produit d'intermodulation d'ordre n ou une distorsion harmonique d'ordre n ou un facteur de distorsion harmonique ou un rendement de l'amplification de puissance ou un taux de bruit ou un point de compression ou une puissance de compression ou une compression de l'amplification de puissance ou une moyenne d'une caractéristique de petit signal ou une intégrale d'une caractéristique de petit signal ou une désadaptation entre le premier facteur de réflexion de source transformé ($b_{on}$') et le premier facteur de réflexion de charge ($a_{on}$),

dans lequel l'optimum ($Max_2$) est un minimum ou un maximum local ou global de la caractéristique ($G_2$),

b) détermination du deuxième réseau d'adaptation ($M_2$) à l'aide de la troisième valeur ($c_{off,opt}$) du troisième facteur de réflexion de charge ($c_{off}$), de la quatrième valeur ($c_{on,opt}$) du deuxième facteur de réflexion de charge ($c_{on}$), du deuxième facteur de réflexion de charge transformé ($c_{on}$') et du troisième facteur de réflexion de charge transformé ($c_{off}$').

6. Procédé de conception d'un circuit électronique,

- dans lequel le circuit présente un premier état de fonctionnement (off) et un deuxième état de fonctionnement (on),
- dans lequel le circuit présente un premier élément de source ($Q_1$) avec une première sortie de source ($QA_1$) et un deuxième élément de source ($Q_2$) avec une deuxième sortie de source ($QA_2$),
- dans lequel le premier élément de source ($Q_1$) présente, dans la première sortie de source ($QA_1$), dans le premier état de fonctionnement (off), un premier facteur de réflexion de source ($b_{off}$),
- dans lequel le circuit présente une charge (L) avec une entrée de charge (LE),
- dans lequel la charge (L) présente dans l'entrée de charge (LE) un facteur de réflexion d'entrée de charge ($\Gamma$),
- dans lequel le circuit présente une pièce en T (T) avec une première entrée ($E_1$), une deuxième entrée ($E_2$) et une sortie ($E_3$),
- dans lequel l'entrée de charge (LE) est reliée à la sortie ($E_3$) de la pièce en T (T),
- dans lequel la pièce en T (T) présente dans la première entrée ($E_1$), dans le deuxième état de fonctionnement (on), un premier facteur de réflexion de charge ($a_{on}$),
- dans lequel la pièce en T (T) présente dans la deuxième entrée ($E_2$), dans le premier état de fonctionnement (off), un deuxième facteur de réflexion de charge ($c_{off}$),
- dans lequel la pièce en T (T) présente dans la deuxième entrée ($E_2$), dans le deuxième état de fonctionnement (on), un troisième facteur de réflexion de charge ($c_{on}$)
- dans lequel le circuit présente un premier réseau d'adaptation ($M_1$) avec un premier raccord ($A_1$) et un deuxième raccord ($A_2$),
- dans lequel le premier raccord ($A_1$) est relié à la première entrée ($E_1$) de la pièce en T (T),
- dans lequel le deuxième raccord ($A_2$) est relié à la première sortie de source ($QA_1$),
- dans lequel le premier réseau d'adaptation ($M_1$) présente dans le premier raccord ($A_1$), dans le premier état de fonctionnement (off), un premier facteur de réflexion de source transformé ($b_{off}$'),
- dans lequel le premier réseau d'adaptation ($M_1$) présente dans le deuxième raccord ($A_2$), dans le deuxième état de fonctionnement (on), un premier facteur de réflexion de charge transformé ($a_{on}$'),
- dans lequel le circuit présente un deuxième réseau d'adaptation ($M_2$) avec un troisième raccord ($A_3$) et un quatrième raccord ($A_4$),
- dans lequel le troisième raccord ($A_3$) est relié à la deuxième entrée ($E_2$) de la pièce en T (T),
- dans lequel le quatrième raccord ($A_4$) est relié à la deuxième sortie de source ($QA_2$),

- dans lequel le deuxième réseau d'adaptation ($M_2$) présente dans le quatrième raccord ($A_4$), dans le premier état de fonctionnement (off), un deuxième facteur de réflexion de charge transformé ($c_{off}'$),
- dans lequel le deuxième réseau d'adaptation ($M_2$) présente dans le quatrième raccord ($A_4$), dans le deuxième état de fonctionnement (on), un troisième facteur de réflexion de charge transformé ($c_{on}'$),
- dans lequel on détermine une première valeur ($a_{on}{}'_{opt}$) du premier facteur de réflexion de charge transformé ($a_{on}'$) pour l'optimisation d'une caractéristique ($G_1$) du circuit dans le deuxième état de fonctionnement (on) par une mesure,
- dans lequel on détermine une deuxième valeur ($c_{off}{}'_{opt}$) du deuxième facteur de réflexion de charge transformé ($c_{off}'$) pour l'optimisation de la caractéristique ($G_1$) du circuit dans le premier état de fonctionnement (off) par une mesure,
- dans lequel on détermine une troisième valeur ($c_{on}{}'_{opt}$) du troisième facteur de réflexion de charge transformé ($c_{on}'$) pour l'optimisation de la caractéristique ($G_1$) du circuit dans le deuxième état de fonctionnement (on) par une mesure,
- dans lequel on fixe le premier facteur de réflexion de charge ($a_{on}$) à une première valeur initiale,
- dans lequel on fixe le deuxième facteur de réflexion de charge ($c_{on}$) à une deuxième valeur initiale,

dans lequel la caractéristique ($G_2$) du circuit est un paramètre S ou un facteur petit signal- bruit ou un facteur de réflexion d'entrée effectif ou un facteur de réflexion de sortie effectif ou une résistance de sortie effective ou un facteur de stabilité de Rollet ou une amplification de puissance ou un produit d'intermodulation d'ordre n ou une distorsion harmonique d'ordre n ou un facteur de distorsion harmonique ou un rendement de l'amplification de puissance ou un taux de bruit ou un point de compression ou une puissance de compression ou une compression de l'amplification de puissance ou une moyenne d'une caractéristique de petit signal ou une intégrale d'une caractéristique de petit signal ou une désadaptation entre le premier facteur de réflexion de source transformé ($b_{on}'$) et le premier facteur de réflexion de charge ($a_{on}$),
dans lequel, pour l'optimisation de la caractéristique ($G_2$), on recherche un minimum ou un maximum local ou global de la caractéristique ($G_2$),
avec les étapes suivantes:

a) calcul d'une première distance de Poincaré ($P_1$) entre la première valeur ($a_{on}{}'_{opt}$) et le conjugué complexe ($b_{off}{}^*$) du premier facteur de réflexion de source ($b_{off}$) par l'équation

$$P_1 = \operatorname{arctanh}\left(\frac{\left|a_{on}{}'_{opt} - b_{off}{}^*\right|}{\left|1 - b_{off}{}^* \, a_{on}{}'_{opt}{}^*\right|}\right),$$

dans laquelle

$b_{off}$ est le premier facteur de réflexion de source ($b_{off}$),
$b_{off}{}^*$ est le conjugué complexe ($b_{off}{}^*$) du premier facteur de réflexion de source ($b_{off}$),
$a_{on}{}'_{opt}$ est la première valeur ($a_{on}{}'_{opt}$) du premier facteur de réflexion de charge transformé ($a_{on}'$), et
$P_1$ est la première distance de Poincaré ($P_1$),

b) détermination d'un premier disque de Poincaré ($K_1$) comme l'ensemble de tous les points dans la première distance de Poincaré ($P_1$) du conjugué complexe ($a_{on}{}^*$) du premier facteur de réflexion de charge ($a_{on}$), par l'équation

$$P(y, a_{on}{}^*) = \operatorname{arctanh}\left(\frac{\left|y - a_{on}{}^*\right|}{\left|1 - y^* \, a_{on}{}^*\right|}\right) = P_1.$$

dans laquelle

$y$ est un point sur le premier disque de Poincaré ($K_1$),
$y^*$ est le conjugué complexe ($y^*$) du point ($y$) sur le premier disque de Poincaré ($K_1$),
$a_{on}{}^*$ est le conjugué complexe ($a_{on}{}^*$) du premier facteur de réflexion de charge ($a_{on}$), et
$P_1$ est la première distance de Poincaré ($P_1$),

c) détermination d'une troisième distance de Poincaré ($P_3$) entre la deuxième valeur ($c_{off}{'}_{opt}$) et la troisième valeur ($c_{on}{'}_{opt}$) par l'équation

$$P_3 = \operatorname{arctanh}\left(\frac{|c_{on}{'}_{opt} - c_{off}{'}_{opt}|}{|1 - c_{on}{'}_{opt} * c_{off}{'}_{opt}|}\right),$$

dans laquelle

$c_{off}{'}_{opt}$ est la deuxième valeur ($c_{off}{'}_{opt}$) du deuxième facteur de réflexion de charge transformé ($c_{off}{'}$),
$c_{on}{'}_{opt}$ est la troisième valeur ($c_{on}{'}_{opt}$) du troisième facteur de réflexion de charge transformé ($c_{on}{'}$),
$c_{on}{'}_{opt}*$ est le conjugué complexe ($c_{on}{'}_{opt}*$) de la troisième valeur ($c_{on}{'}_{opt}$) du troisième facteur de réflexion de charge transformé ($c_{on}{'}$), et
$P_3$ est la troisième distance de Poincaré ($P_3$),

d) détermination d'un troisième disque de Poincaré ($K_3$) comme l'ensemble de tous les points dans la troisième distance de Poincaré ($P_3$) du troisième facteur de réflexion de charge ($c_{on}$) par l'équation

$$P(z, c_{on}) = \operatorname{arctanh}\left(\frac{|z - c_{on}|}{|1 - z * c_{on}|}\right) \equiv P_3,$$

dans laquelle

$z$ est un point sur le troisième disque de Poincaré ($K_3$),
$z*$ est le conjugué complexe ($z*$) du point ($z$) sur le troisième disque de Poincaré ($K_3$),
$c_{on}$ est le troisième facteur de réflexion de charge ($c_{on}$),
$c_{on}*$ est le conjugué complexe ($c_{on}*$) du troisième facteur de réflexion de charge ($c_{on}$), et
$P_3$ est la troisième distance de Poincaré ($P_3$),

e) détermination d'un premier disque de Poincaré modifié ($K_1{'}$), dans lequel on détermine le premier disque de Poincaré modifié ($K_1{'}$) comme l'ensemble de tous les facteurs de réflexion modifiés ($y'$), dans lequel chacun des facteurs de réflexion modifiés ($y'$) appartient à une impédance globale, dans lequel on détermine chaque impédance globale à partir d'un premier circuit parallèle d'une impédance de charge de la charge (L) et d'une impédance appartenant à un facteur de réflexion (y) sur le premier disque de Poincaré ($K_1$), dans lequel l'impédance de charge appartient au facteur de réflexion d'entrée de charge ($\Gamma$) de la charge (L),
f) détermination d'au moins une quatrième valeur ($c_{off,1}$, $c_{off,2}$) du deuxième facteur de réflexion de charge ($c_{off}$), dans lequel on minimise, pour ladite au moins une quatrième valeur, une somme des carrés de distances entre la quatrième valeur ($c_{off,1}$, $c_{off,2}$) et le troisième disque de Poincaré ($K_3$) ainsi qu'entre la quatrième valeur ($c_{off,1}$, $c_{off,2}$) et le premier disque de Poincaré modifié ($K_1{'}$),
g) détermination d'une cinquième valeur ($b_{off}{'}_1$, $b_{off}{'}_2$) du premier facteur de réflexion de source transformé ($b_{off}{'}$) à chaque quatrième valeur ($c_{off,1}$, $c_{off,2}$) du deuxième facteur de réflexion de charge ($c_{off}$), dans lequel on détermine une quatrième impédance, dans lequel la quatrième impédance appartient à la quatrième valeur ($c_{off,1}$, $c_{off,2}$) du deuxième facteur de réflexion de charge ($c_{off}$), dans lequel on détermine une cinquième impédance, de telle manière qu'un deuxième montage parallèle de la cinquième impédance avec l'impédance de charge soit égal à la quatrième impédance et dans lequel la cinquième valeur ($b_{off}{'}_1$, $b_{off}{'}_2$) du premier facteur de réflexion de source transformé ($b_{off}{'}$) appartienne à la cinquième impédance,
h) détermination du premier réseau d'adaptation ($M_1$) à l'aide du premier facteur de réflexion de charge ($a_{on}$), de la première valeur ($a_{on}{'}_{opt}$) du premier facteur de réflexion de charge transformé ($a_{on}{'}$), du premier facteur de réflexion de source ($b_{off}$) et de la cinquième valeur ($b_{off}{'}_1$, $b_{off}{'}_2$) du premier facteur de réflexion de source transformé ($b_{off}{'}$), et
i) détermination du deuxième réseau d'adaptation ($M_2$) à l'aide de la deuxième valeur ($c_{off}{'}_{opt}$) du deuxième facteur de réflexion de charge transformé ($c_{off}{'}$), de la troisième valeur ($c_{on}{'}_{opt}$) du troisième facteur de réflexion transformé ($c_{on}{'}$), du troisième facteur de réflexion de charge ($c_{on}$) ainsi que de la quatrième valeur ($c_{off,1}$, $c_{off,2}$) du deuxième facteur de réflexion de charge ($c_{off}$).

**7.** Procédé de conception d'un circuit électronique,

- dans lequel le circuit présente un premier élément de source ($Q_1$) avec une première sortie de source ($QA_1$) et avec un premier facteur de réflexion de source (b),
- dans lequel le circuit présente un deuxième élément de source ($Q_2$) avec une deuxième sortie de source ($QA_2$) et avec un deuxième facteur de réflexion de source (d),
- dans lequel le circuit présente une charge (L),
- dans lequel le circuit présente une pièce en T (T) avec une première entrée ($E_1$), une deuxième entrée ($E_2$) et une sortie ($E_3$),
- dans lequel la pièce en T (T) présente dans la première entrée ($E_1$) un premier facteur de réflexion de charge (a),
- dans lequel la pièce en T (T) présente dans la deuxième entrée ($E_2$) un deuxième facteur de réflexion de charge (c),
- dans lequel la sortie ($E_3$) de la pièce en T (T) est reliée à la charge (L),
- dans lequel le circuit présente un premier réseau d'adaptation ($M_1$) avec un premier raccord ($A_1$) et un deuxième raccord ($A_2$),
- dans lequel le deuxième raccord ($A_2$) est relié à la première sortie de source ($QA_1$) et le premier raccord ($A_1$) est relié à la première entrée ($E_1$) de la pièce en T (T),
- dans lequel on provoque par le premier réseau d'adaptation ($M_1$) dans le deuxième raccord ($A_2$) un premier facteur de réflexion de charge transformé (a') et dans le premier raccord ($A_1$) un premier facteur de réflexion de source transformé (b'),
- dans lequel le circuit présente un deuxième réseau d'adaptation ($M_2$) avec un troisième raccord ($A_3$) et un quatrième raccord ($A_4$),
- dans lequel le quatrième raccord ($A_4$) est relié à la deuxième sortie de source ($QA_2$) et le troisième raccord ($A_3$) est relié à la deuxième entrée ($E_2$) de la pièce en T (T),
- dans lequel on provoque par le deuxième réseau d'adaptation ($M_2$) dans le quatrième raccord ($A_4$) un deuxième facteur de réflexion de charge transformé (c') et dans le troisième raccord ($A_3$) un deuxième facteur de réflexion de source transformé (d'),
- dans lequel on détermine une première valeur ($a'_{opt}$) du premier facteur de réflexion de charge transformé (a'), dans lequel le premier élément de source ($Q_1$) présente, pour la première valeur ($a'_{opt}$) du premier facteur de réflexion de charge transformé (a') agissant à la première sortie de source ($QA_1$), un premier optimum ($Max_1$) d'une première caractéristique ($G_1$), dans lequel la première valeur ($a'_{opt}$) du premier facteur de réflexion de charge transformé (a') s'écarte du conjugué complexe du premier facteur de réflexion de source (b),
- dans lequel on détermine une deuxième valeur ($c'_{opt}$) du deuxième facteur de réflexion de charge transformé (c'), dans lequel le deuxième élément de source ($Q_2$) présente, pour la deuxième valeur ($c'_{opt}$) du deuxième facteur de réflexion de charge transformé (c') agissant à la deuxième sortie de source ($QA_2$), un deuxième optimum ($Max_2$) d'une deuxième caractéristique ($G_2$), dans lequel la deuxième valeur ($c'_{opt}$) du deuxième facteur de réflexion de charge transformé (c') s'écarte du conjugué complexe du deuxième facteur de réflexion de source (d),

dans lequel la caractéristique ($G_1$, $G_2$) du circuit est un paramètre S ou un facteur petit signal-bruit ou un facteur de réflexion d'entrée effectif ou un facteur de réflexion de sortie effectif ou une résistance de sortie effective ou un facteur de stabilité de Rollet ou une amplification de puissance ou un produit d'intermodulation d'ordre n ou une distorsion harmonique d'ordre n ou un facteur de distorsion harmonique ou un rendement de l'amplification de puissance ou un taux de bruit ou un point de compression ou une puissance de compression ou une compression de l'amplification de puissance ou une moyenne d'une caractéristique de petit signal ou une intégrale d'une caractéristique de petit signal ou une désadaptation entre le premier facteur de réflexion de source transformé ($b_{on}'$) et le premier facteur de réflexion de charge ($a_{on}$),

dans lequel l'optimum ($Max_1$, $Max_2$) est un minimum ou un maximum local ou global de la caractéristique ($G_1$, $G_2$), avec les étapes suivantes:

a) détermination d'une valeur de distance ($P_{aus}$) et d'une troisième valeur ($a'_{est}$) du premier facteur de réflexion de charge transformé (a') et d'une quatrième valeur ($c'_{est}$) du deuxième facteur de réflexion de charge transformé (c'), par le fait que

- on définit une première distance de Poincaré ($P_1$) entre la première valeur ($a'_{opt}$) et le premier facteur de réflexion de charge transformé (a') par l'équation

$$P_1 = \text{arctanh}\left(\frac{|a'_{opt} - a'|}{|1 - a'^* a'_{opt}|}\right),$$

dans laquelle

$P_1$ est la première distance de Poincaré ($P_1$),
a' est le premier facteur de réflexion de charge transformé (a'),
a'* est le conjugué complexe (a'*) du premier facteur de réflexion de charge transformé (a'), et
$a'_{opt}$ est la première valeur ($a'_{opt}$),

- on définit une deuxième distance de Poincaré ($P_2$) entre la deuxième valeur ($c'_{opt}$) et le deuxième facteur de réflexion de charge transformé (c') par l'équation

$$P_2 = \text{arctanh}\left(\frac{|c'_{opt} - c'|}{|1 - c'^* c'_{opt}|}\right),$$

dans laquelle

$P_2$ est la deuxième distance de Poincaré ($P_2$),
c' est le deuxième facteur de réflexion de charge transformé (c'),
c'* est le conjugué complexe (c'*) du deuxième facteur de réflexion de charge transformé (c'), et
$c'_{opt}$ est la deuxième valeur ($c'_{opt}$),

- on définit une troisième distance de Poincaré ($P_3$) entre le premier facteur de réflexion de charge transformé (a') et le conjugué complexe (b*) du premier facteur de réflexion de source (b) par l'équation

$$P_3 = \text{arctanh}\left(\frac{|a' - b^*|}{|1 - ba'|}\right),$$

dans laquelle

$P_3$ est la troisième distance de Poincaré ($P_3$),
b est le premier facteur de réflexion de source (b),
b* est le conjugué complexe du premier facteur de réflexion de source (b), et
a' est le premier facteur de réflexion de charge transformé (a'),

- on définit une quatrième distance de Poincaré ($P_4$) entre le deuxième facteur de réflexion de charge transformé (c') et le conjugué complexe (d*) du deuxième facteur de réflexion de source (d) par l'équation

$$P_4 = \text{arctanh}\left(\frac{|c' - d^*|}{|1 - dc'|}\right),$$

dans laquelle

$P_4$ est la quatrième distance de Poincaré ($P_4$),
d est le deuxième facteur de réflexion de source (d),
d* est le conjugué complexe (d*) du deuxième facteur de réflexion de source (d), et
c' est le deuxième facteur de réflexion de charge transformé (c'),

- on définit la valeur de distance ($P_{aus}$) et la troisième valeur ($a'_{est}$) et la quatrième valeur ($c'_{est}$) par le fait que

EP 2 499 739 B1

- on détermine un minimum de la moyenne géométrique entre la première distance de Poincaré ($P_1$) et la deuxième distance de Poincaré ($P_2$), avec la condition additionnelle que la troisième distance de Poincaré ($P_3$) est égale à la quatrième distance de Poincaré ($P_4$) et est différente de zéro, par le fait que l'on fait varier le premier facteur de réflexion de charge transformé (a') et le deuxième facteur de réflexion de charge transformé (c') et que le conjugué complexe (b*) du premier facteur de réflexion de source (b), le conjugué complexe (d*) du deuxième facteur de réflexion de source (d), la première valeur ($a'_{opt}$) et la deuxième valeur ($c'_{opt}$) présentent une valeur fixe, et
- on fixe la valeur de la troisième distance de Poincaré ($P_3$) appartenant au minimum comme valeur de distance ($P_{aus}$), la valeur du facteur de réflexion de charge transformé (a') appartenant au minimum comme troisième valeur ($a'_{est}$), et la valeur du deuxième facteur de réflexion de charge (c') appartenant au minimum comme quatrième valeur (c'est),

b) détermination d'une cinquième valeur ($b'_{est}$) du premier facteur de réflexion de source transformé (b') et d'une sixième valeur ($d'_{est}$) du deuxième facteur de réflexion de source transformé (d'), par le fait que

- on détermine un premier disque de Poincaré ($K_1$) avec un centre réel, qui coupe une valeur de facteur de réflexion réelle d'un tiers (1/3) et une valeur de facteur de réflexion réelle de moins un (-1),
- on détermine un deuxième disque de Poincaré ($K_2$) comme l'ensemble de tous les points (y) avec une distance de la valeur de facteur de réflexion réelle d'un tiers (1/3) égale à la valeur de distance ($P_{aus}$), par l'équation

$$P(y, \frac{1}{3}) = \operatorname{arctanh}\left( \frac{\left| y - \frac{1}{3} \right|}{\left| 1 - y\frac{1}{3} \right|} \right) = P_{aus} \; ,$$

dans laquelle

y est un point (y) sur le deuxième disque de Poincaré ($K_2$), et
$P_{aus}$ est la valeur de distance ($P_{aus}$) de la troisième distance ($P_3$),

- on détermine la cinquième valeur ($b'_{est}$) comme la valeur d'un premier point d'intersection et la sixième valeur ($d'_{est}$) comme la valeur d'un deuxième point d'intersection différent du premier point d'intersection entre le premier disque de Poincaré ($K_1$) et le deuxième disque de Poincaré ($K_2$),

c) détermination du premier réseau d'adaptation ($M_1$) à l'aide du premier facteur de réflexion de source (b) et de la cinquième valeur ($b'_{est}$) du premier facteur de réflexion de source transformé (b') et du premier facteur de réflexion de charge (a) et de la troisième valeur ($a'_{est}$) du premier facteur de réflexion de charge transformé (a'),
d) détermination du deuxième réseau d'adaptation ($M_2$) à l'aide du deuxième facteur de réflexion de source (d) et de la sixième valeur ($d'_{est}$) du deuxième facteur de réflexion de source transformé (d') et du deuxième facteur de réflexion de charge (c) et de la quatrième valeur ($c'_{est}$) du deuxième facteur de réflexion de charge transformé (c').

8. Circuit électronique,

- avec au moins un élément de source ($Q_1$, $Q_2$),
- avec au moins une charge (L), et
- avec au moins un réseau d'adaptation ($M_1$, $M_2$), qui est conçu par un procédé selon l'une quelconque des revendications 1 à 7.

9. Circuit électronique selon la revendication 8,

- avec un premier élément de source ($Q_1$), un deuxième élément de source ($Q_2$), un premier réseau d'adaptation ($M_1$) et un deuxième réseau d'adaptation ($M_2$),
- dans lequel le premier réseau d'adaptation ($M_1$) et le deuxième réseau d'adaptation ($M_2$) sont conçus par un procédé selon la revendication 6,

70

- dans lequel le deuxième élément de source ($Q_2$) est réalisé de façon à émettre un signal (S) avec une fréquence moyenne (f),
- dans lequel la charge (L) présente une impédance de charge ($Z_L$),
- dans lequel le deuxième réseau d'adaptation ($M_2$) présente des éléments en série de type lignes ($L_{S1}$, ..., $L_{S20}$), qui conduisent le signal (S),
- dans lequel les éléments en série de type lignes ($L_{S1}$, ..., $L_{S20}$) présentent exclusivement des impédances de ligne ($Z_{S1}$, ..., $Z_{S20}$) inférieures à l'impédance de charge ($Z_L$),

ou

- dans lequel la somme des longueurs électriques des éléments en série de type lignes ($L_{S1}$, ..., $L_{S20}$), qui présentent respectivement une impédance de ligne ($Z_{S1}$, ..., $Z_{S20}$) supérieure à l'impédance de charge ($Z_L$), est inférieure à un quart d'une longueur d'onde ($\lambda$) appartenant au signal (S) .

Fig. 1

Fig. 2

Fig. 3

Fig. 4

Fig. 5

Fig. 6

Fig. 7

EP 2 499 739 B1

Fig. 8

EP 2 499 739 B1

Fig. 9

Fig. 10

Fig. 11

Fig. 12

Fig. 13

Fig. 14

EP 2 499 739 B1

Fig. 15

Fig. 16

Fig. 17

Fig. 18

Fig. 19

Fig. 20

Fig. 21

EP 2 499 739 B1

Fig. 22

Fig. 23

Fig. 24

Fig. 25

EP 2 499 739 B1

Fig. 26

Fig. 27

Fig. 28

Fig. 29

Fig. 30

EP 2 499 739 B1

EP 2 499 739 B1

L=1.1 λ

L=0.6 λ

L=0.1 λ

Fig. 31

EP 2 499 739 B1

**L=1.1**  **L=0.6**  **L=0.1**

4 + j 0  "Id"

10.1 - j 11.0

50 + j 0  "hd"

1.44 - j 3.5

$Q_{max,\ Z1-Z3} = 1.45$  $Q_{max,\ Z1-Z3} = 1.12$  $Q_{max,\ Z1-Z3} = 1.74$

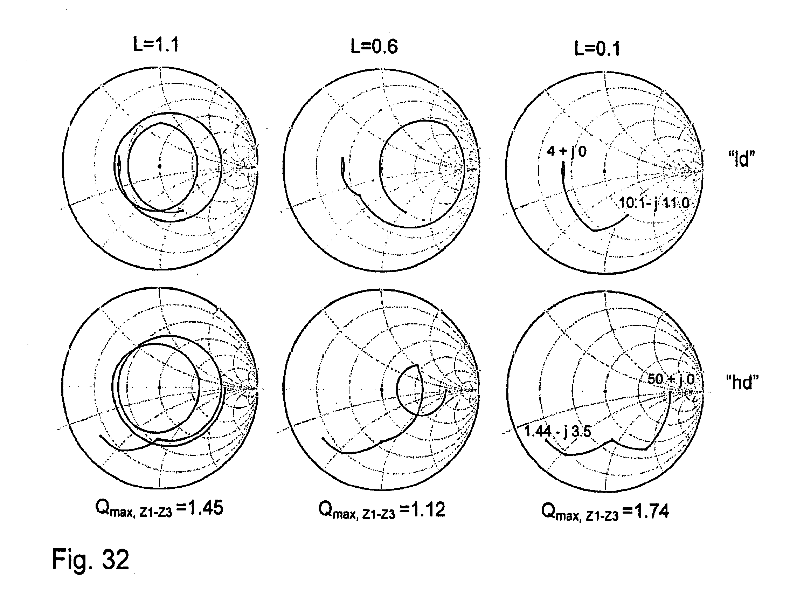

Fig. 32

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Über eine Eigenschaft der konformen Abbildung kreisförmiger Bereiche. **GEORG PICK.** Mathematische Annalen. 1916, vol. 77, 1-6
- **T. PETERS.** *Hyperbolische Geometrie,* 03. September 2003, 6, 7, www.mathe-seiten
- **M. JAMICKI ; P. PFLUG.** Invariant Distances and Metrics in complex Analysis - revisited. *Invariant Distances and Metrics in complex Analysis - revisited,* Februar 2004, 7
- **PROF. DR. DIRK FERUS.** *Komplexe Analysis,* 2008, 18-26
- **MADHU S. GUPTA.** Escher's art, Smith chart and hyperbolic geometry. *IEEE MICROWAVE MAGAZINE,* Oktober 2006, vol. 7 (5), 66-76
- **E. FOLKE BOLINDER.** Geometric-analytic Theory of Transition in electrical Engineering. *PROCEEDINGS OF THE IRE,* 01. Juni 1959, vol. 46 (6), 1124-1129
- **MITTRA R et al.** An Impedance Transformation Method for Finding the Load Impedance of a Two-Port Network. *IRE TRANSACTIONS ON MICROWAVE THEORY AND TECHNIQUES,* 01. Januar 1962, vol. 6 (1), 13-19
- **BUMMAN K. et al.** The Doherty Power Amplifier. *IEEE microwave magazine,* Oktober 2006, 42-50
- **R. SWEENEY.** Practical Magic. *IEEE microwave magazine,* April 2008, 73-82
- **F. H. RAAB et al.** Power Amplifiers and Transmitters for RF and Microwave. *IEEE Transactions on Microwave Theory and Techniques,* Marz 2002, vol. 50 (3), 814-826
- **W.H. DOHERTY.** A New High Efficiency Power Amplifier for Modulated Waves. *Proceedings of the Institute of Radio Engineers,* September 1936, vol. 24 (9), 1163-1182